(19) Europäisches Patentamt
European Patent Office
Office européen des brevets

(11) EP 4 582 262 A1

(12) # EUROPEAN PATENT APPLICATION
published in accordance with Art. 153(4) EPC

(43) Date of publication:
**09.07.2025 Bulletin 2025/28**

(21) Application number: **23860213.0**

(22) Date of filing: **25.08.2023**

(51) International Patent Classification (IPC):
***B41N 1/14** (2006.01)* ***B41C 1/10** (2006.01)*
***B41M 1/06** (2006.01)* ***G03F 7/00** (2006.01)*
***G03F 7/004** (2006.01)* ***G03F 7/029** (2006.01)*

(52) Cooperative Patent Classification (CPC):
**B41C 1/10; B41M 1/06; B41N 1/14; G03F 7/00; G03F 7/004; G03F 7/029**

(86) International application number:
**PCT/JP2023/030714**

(87) International publication number:
**WO 2024/048451 (07.03.2024 Gazette 2024/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.08.2022 JP 2022138128**

(71) Applicant: **FUJIFILM Corporation**
**Tokyo 106-8620 (JP)**

(72) Inventors:
- **MATSUURA Atsushi**
  **Haibara-gun, Shizuoka 421-0396 (JP)**
- **WATANABE Shumpei**
  **Haibara-gun, Shizuoka 421-0396 (JP)**

(74) Representative: **HGF**
**HGF Limited**
**1 City Walk**
**Leeds LS11 9DX (GB)**

(54) **PLANOGRAPHIC PRINTING PLATE PRECURSOR, PLANOGRAPHIC PRINTING PLATE MANUFACTURING METHOD, AND PRINTING METHOD**

(57) An object of the present invention is to provide an on-press development-type planographic printing plate precursor which suppresses color-forming defect after a lapse of time and has excellent visibility. Another object of the present invention is to provide a manufacturing method of a planographic printing plate and a printing method. The planographic printing plate precursor of the present invention is an on-press development-type planographic printing plate precursor including a support and an image-recording layer, in which the support has an aluminum alloy plate and an anodic oxide film disposed on the aluminum alloy plate, a density of intermetallic compounds having a major axis of 2.0 μm or more on a surface of the support on a side opposite to the image-recording layer is 1,000 pieces/mm$^2$ or less, the image-recording layer contains an infrared absorber and an acid color-forming agent, and a color-forming factor of the acid color-forming agent, which is determined by a predetermined measuring method, is 20,000 or more.

FIG. 1

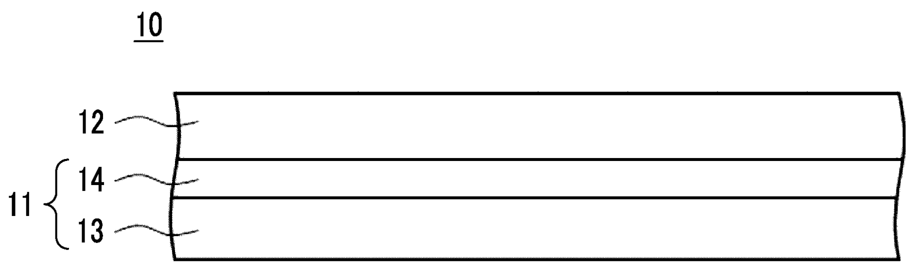


EP 4 582 262 A1

## Description

### BACKGROUND OF THE INVENTION

1. Field of the Invention

The present invention relates to a planographic printing plate precursor, a manufacturing method of a planographic printing plate, and a printing method.

2. Description of the Related Art

Planographic printing is a method of printing an image by setting a lipophilic image area of a planographic printing plate as an ink receiving area and a hydrophilic non-image area of the planographic printing plate as a dampening water receiving area (ink non-receiving area) using the property in which water and oily ink repel each other, causing a difference in adhesiveness of ink to the surface of the planographic printing plate, allowing the ink to be impressed only on an image area, and transferring the ink to a printing medium such as paper.

In order to produce the planographic printing plate having the lipophilic image area and the hydrophilic non-image area, a planographic printing plate precursor (PS plate) in which a lipophilic photosensitive resin layer (image-recording layer) is provided on a hydrophilic support has been widely used. Normally, the planographic printing plate precursor is manufactured by a method of remaining a portion, which is an image area of the image-recording layer, after subjecting the planographic printing plate precursor to be exposed through an original image such as a lith film, dissolving and removing other unnecessary image-recording layers with an alkaline developer or an organic solvent, and forming a non-image area by exposing a hydrophilic surface of the support.

Due to growing interest in global environment, issues related to waste liquid associated with a wet treatment such as a development treatment have been attracting attention.

In order to solve the above-described problem, there is a tendency to simplify or eliminate the development or plate-making, and a method called "on-press development" is performed as one of the countermeasures. That is, the on-press development is a method of exposing the planographic printing plate precursor, mounting the planographic printing plate precursor in a printing press without performing the development treatment, and then removing unnecessary portions of the image-recording layer at an initial stage of a printing process.

Examples of the planographic printing plate precursor used for such an on-press development include a planographic printing plate precursor disclosed in WO2020/262692A.

WO2020/262692A discloses a technique relating to an on-press development-type planographic printing plate precursor having a support and an image-recording layer on the support, in which the image-recording layer contains an initiator, an infrared absorber capable of donating electrons to the initiator, and a color forming substance precursor, in which a brightness change of the image-recording layer before and after exposure with a predetermined infrared laser is equal to or more than a predetermined value.

### SUMMARY OF THE INVENTION

The present inventors have examined various physical properties of the planographic printing plate precursor with reference to WO2020/262692A, and have found that, in some cases, a dot-like color-forming defect (color formation of fine dots) occurs in the appearance of the planographic printing plate precursor after a predetermined period of time from the manufacturing, and further improvement is required in suppressing the dot-like color-forming defect after the lapse of time.

An object of the present invention is to provide an on-press development-type planographic printing plate precursor which suppresses color-forming defect after a lapse of time and has excellent visibility.

Another object of the present invention is to provide a manufacturing method of a planographic printing plate and a printing method.

The present inventors have found that the above-described objects can be achieved by the following configurations.

[1] An on-press development-type planographic printing plate precursor comprising:

a support; and
an image-recording layer,
in which the support has an aluminum alloy plate and an anodic oxide film disposed on the aluminum alloy plate,
a density of intermetallic compounds having a major axis of 2.0 μm or more on a surface of the support on a side

opposite to the image-recording layer is 1,000 pieces/$mm^2$ or less,
the image-recording layer contains an infrared absorber and an acid color-forming agent, and
a color-forming factor of the acid color-forming agent, which is determined by a measurement X described later, is 20,000 or more.

[2] The planographic printing plate precursor according to [1],
in which the density of the intermetallic compounds having a major axis of 2.0 μm or more on the surface of the support on the side opposite to the image-recording layer is 500 pieces/$mm^2$ or less.
[3] The planographic printing plate precursor according to [1] or [2],
in which the density of the intermetallic compounds having a major axis of 2.0 μm or more on the surface of the support on the side opposite to the image-recording layer is 10 pieces/$mm^2$ or less.
[4] The planographic printing plate precursor according to any one of [1] to [3],
in which a density of recessed portions having a depth of 0.7 μm or more from an average plane, which is obtained by measuring a surface of the support on a side of the anodic oxide film in a range of 400 μm × 400 μm using a non-contact three-dimensional roughness meter, is 3,000 pieces/$mm^2$ or more.
[5] The planographic printing plate precursor according to any one of [1] to [4],
in which a surface area ratio ΔS calculated by an expression (S1) described later from an actual area Sx which is obtained by an approximate three-point method from three-dimensional data obtained by, using an atomic force microscope, measuring 256 × 256 points in a range of 25 μm × 25 μm on a surface of the support on a side of the anodic oxide film and from a geometrically measured area S0 of the surface of the support on the side of the anodic oxide film is 25% or more.
[6] The planographic printing plate precursor according to any one of [1] to [5],

in which the anodic oxide film has a micropore extending in a depth direction from a surface of the anodic oxide film,
the micropore is composed of a large-diameter hole portion extending in the depth direction from the surface of the anodic oxide film and a small-diameter hole portion communicating with a bottom portion of the large-diameter hole portion and extending in the depth direction,
an average diameter of the large-diameter hole portion at the surface of the anodic oxide film is 15 to 50 nm,
a depth of the large-diameter hole portion is 30 to 1,000 nm,
an average diameter of the small-diameter hole portion at a communicate position with the large-diameter hole portion is 15 nm or less, and
a depth of the small-diameter hole portion is 300 to 3,000 nm.

[7] The planographic printing plate precursor according to any one of [1] to [5],

in which the anodic oxide film has a micropore extending in a depth direction from a surface of the anodic oxide film,
the micropore is composed of an upper hole portion extending in the depth direction from the surface of the anodic oxide film, a middle hole portion communicating with a bottom portion of the upper hole portion and extending in the depth direction, and a lower hole portion communicating with a bottom portion of the middle hole portion and extending in the depth direction to a bottom portion of the micropore,
an average diameter of the upper hole portion at the surface of the anodic oxide film is 15 to 50 nm,
a depth of the upper hole portion is 30 to 1,000 nm,
a maximum diameter of the middle hole portion is 20 to 100 nm, and is larger than the average diameter of the upper hole portion at the surface of the anodic oxide film,
an average diameter of the lower hole portion at a communicate position with the large-diameter hole portion is 20 nm or less, and
a depth of the lower hole portion is 500 to 3,000 nm.

[8] The planographic printing plate precursor according to any one of [1] to [7],

in which the anodic oxide film has a micropore extending in a depth direction from a surface of the anodic oxide film,
a density of the micropores on the surface of the anodic oxide film is 400 to 1,500 pieces/$\mu m^2$, and
an opening ratio of the micropores on the surface of the anodic oxide film is 30% to 85%.

[9] The planographic printing plate precursor according to any one of [1] to [8],

in which the color-forming factor of the acid color-forming agent, which is determined by the measurement X, is 20,000 to 100,000.

[10] The planographic printing plate precursor according to any one of [1] to [9],

in which an absorption maximal wavelength λmax of a color forming substance generated from the acid color-forming agent in a wavelength range of 380 to 750 nm is present in a range of 500 to 650 nm.

[11] The planographic printing plate precursor according to any one of [1] to [10],

in which the acid color-forming agent has at least one group represented by Formulae (1a) to (1d) described later.

[12] The planographic printing plate precursor according to [11],

in which the acid color-forming agent has any of structures represented by Formulae (2a) to (2f) described later.

[13] The planographic printing plate precursor according to [11],

in which the acid color-forming agent includes a compound represented by Formula (3a) described later or a compound represented by Formula (3b) described later.

[14] The planographic printing plate precursor according to any one of [1] to [13],

in which the image-recording layer further contains a polymerization initiator, and

the polymerization initiator includes an electron-accepting polymerization initiator and an electron-donating polymerization initiator.

[15] The planographic printing plate precursor according to [14],

in which the electron-accepting polymerization initiator is an onium salt compound, and

the electron-donating polymerization initiator is a borate salt compound.

[16] The planographic printing plate precursor accepting to [14] or [15],

in which a total content of the electron-accepting polymerization initiator and the electron-donating polymerization initiator is 1.0 molar equivalent or more with respect to a content of the acid color-forming agent.

[17] The planographic printing plate precursor according to any one of [14] to [16],

in which a value obtained by subtracting a lowest unoccupied molecular orbital of the infrared absorber from a lowest unoccupied molecular orbital of the electron-accepting polymerization initiator is 0.55 eV or less.

[18] The planographic printing plate precursor according to any one of [1] to [17],

in which the image-recording layer further contains polymer particles.

[19] The planographic printing plate precursor according to [18],

in which the polymer particles are microgels.

[20] The planographic printing plate precursor according to [18],

in which the polymer particles include a polymer having a hydrophobic main chain, and

the polymer includes a constitutional unit having a pendant cyano group directly bonded to the hydrophobic main chain and a constitutional unit having a pendant group including a hydrophilic polyalkylene oxide segment.

[21] The planographic printing plate precursor according to any one of [1] to [20],

in which the infrared absorber includes a decomposition-type infrared absorber which is decomposed by exposure to infrared rays.

[22] The planographic printing plate precursor according to [21],

in which the decomposition-type infrared absorber is a compound represented by Formula (A) described later.

[23] The planographic printing plate precursor according to any one of [1] to [22], further comprising:

a protective layer on the image-recording layer.

[24] The planographic printing plate precursor according to [23],

in which the protective layer contains a color forming substance precursor.

[25] The planographic printing plate precursor according to [24],

in which the color forming substance precursor includes an infrared absorber.

[26] The planographic printing plate precursor according to [24] or [25],

in which the color forming substance precursor includes a decomposition-type infrared absorber which is decomposed by exposure to infrared rays.

[27] A manufacturing method of a planographic printing plate, comprising:

an exposure step of exposing the image-recording layer of the planographic printing plate precursor according to any one of [1] to [26] in an imagewise manner to form an exposed portion and a non-exposed portion; and

an on-press development step of supplying at least one of a printing ink or a dampening water on a printing press

to remove the non-exposed portion of the imagewise-exposed image-recording layer and to manufacture a planographic printing plate.

[28] A printing method comprising:

an exposure step of exposing the image-recording layer of the planographic printing plate precursor according to any one of [1] to [26] in an imagewise manner to form an exposed portion and a non-exposed portion;
an on-press development step of supplying at least one of a printing ink or a dampening water on a printing press to remove the non-exposed portion of the imagewise-exposed image-recording layer and to manufacture a planographic printing plate; and
a printing step of performing printing using the manufactured planographic printing plate.

According to the present invention, it is possible to provide an on-press development-type planographic printing plate precursor which suppresses color-forming defect after a lapse of time and has excellent visibility.
In addition, according to the present invention, it is possible to provide a manufacturing method of a planographic printing plate and a printing method.

## BRIEF DESCRIPTION OF THE DRAWINGS

Fig. 1 is a schematic cross-sectional view showing an example of a configuration of a planographic printing plate precursor according to an embodiment of the present invention.
Fig. 2 shows an example of an image obtained by, using a scanning electron microscope, imaging a surface of a support in the planographic printing plate precursor on a side opposite to an image-recording layer.
Fig. 3 shows an example of an image obtained by, using a scanning electron microscope, imaging the surface of the support in the planographic printing plate precursor on the side opposite to the image-recording layer.
Fig. 4 is a schematic cross-sectional view showing an example of an embodiment of an anodic oxide film.
Fig. 5 is a schematic cross-sectional view showing another example of the embodiment of the anodic oxide film.
Fig. 6 is a graph showing an example of a waveform diagram of an alternating current waveform used for a hydrochloric acid electrolytic treatment in a manufacturing method of a support.
Fig. 7 is a side view showing an example of a radial type cell used for a hydrochloric acid electrolytic treatment using an alternating current in the manufacturing method of a support.
Fig. 8 is a schematic view of an anodization treatment device used for an anodization treatment in the production of a support.

## DESCRIPTION OF THE PREFERRED EMBODIMENTS

Hereinafter, the present invention will be described in detail.
The description of the configuration requirements described below is made on the basis of representative embodiments of the present invention, but it should not be construed that the present invention is limited to those embodiments.
In the present specification, numerical ranges represented by "to" include numerical values before and after "to" as lower limit values and upper limit values.
In the present specification, the concept of "(meth)acryl" includes both acryl and methacryl, and the concept of "(meth)acryloyl" includes both acryloyl and methacryloyl.
The term "step" in the present specification indicates not only an independent step but also a step which cannot be clearly distinguished from other steps as long as the intended purpose of the step is achieved.
Unless otherwise specified, each of values of physical properties is measured at 25°C.
Unless otherwise specified, each component in a composition or each constitutional unit in a polymer in the present specification may be contained alone or in combination of two or more kinds thereof.
In the present specification, in a case where there is a plurality of substances corresponding to each component in a composition, or in a case where there is a plurality of constitutional units corresponding to each constitutional unit in a polymer, unless otherwise specified, the amount of each component in the composition or the amount of each constitutional unit in the polymer means the total amount of the plurality of corresponding substances present in the composition or the total amount of the plurality of corresponding constitutional units present in the polymer.
In the present specification, a combination of two or more preferred aspects is a more preferred aspect.
A weight-average molecular weight (Mw) and a number-average molecular weight (Mn) in the present specification are molecular weights in terms of polystyrene used as a standard substance, which are detected by a molecular weight of a target compound in a solvent using tetrahydrofuran (THF), a differential refractometer, and a gel permeation chromatography (GPC) analyzer using TSKgel GMHxL, TSKgel G4000HxL, and TSKgel G2000HxL (all product names manufactured by Tosoh Corporation) as columns, unless otherwise specified.

In the present specification, a term "planographic printing plate precursor" includes not only a planographic printing plate precursor but also a key plate precursor. In addition, the term "planographic printing plate" includes not only a planographic printing plate produced by performing operations such as exposure and development, on a planographic printing plate precursor as necessary but also a key plate. In a case of the key plate precursor, operations of exposure and development are not necessarily required. In addition, a key plate is a planographic printing plate precursor for attachment to a plate cylinder which is not used, for example, in a case where printing is performed on a part of a paper surface with one or two colors in color newspaper printing.

In the present specification, a term "on-press development-type" means that the planographic printing plate precursor can be used for on-press development.

In the present specification, "excellent printing durability" means that the number of sheets which can be printed using the planographic printing plate is large.

[Planographic printing plate precursor]

The planographic printing plate precursor according to the embodiment of the present invention is an on-press development-type planographic printing plate precursor including a support and an image-recording layer, in which the support has an aluminum alloy plate and an anodic oxide film disposed on the aluminum alloy plate, a density of intermetallic compounds having a major axis of 2.0 μm or more on a surface of the support on a side opposite to the image-recording layer is 1,000 pieces/$mm^2$ or less, the image-recording layer contains an infrared absorber and an acid color-forming agent, and a color-forming factor of the acid color-forming agent, which is determined by a measurement X described later, is 20,000 or more.

As described above, the present inventors have found that, in some cases, a dot-like color-forming defect (color formation stain of fine dots) occurs in the appearance of the planographic printing plate precursor after a predetermined period of time from manufacturing.

The present inventors have examined the cause of the dot-like color-forming defect occurring in the planographic printing plate precursor after the passage of time (hereinafter, also referred to as "color-forming defect over time"), and have found that, in a case where an acid color-forming agent having relatively high color formability is used as a color forming substance precursor, a tendency of the color-forming defect over time to occur is found in order to improve ease of seeing an exposed portion in a plate inspection work of checking the exposed portion after imagewise exposure of the planographic printing plate precursor (hereinafter, also simply referred to as "visibility"). In addition, the present inventors have found that, even in a case where such an acid color-forming agent is used, by using an aluminum alloy plate in which the number of intermetallic compounds having a major axis of 2.0 μm or more (hereinafter, also referred to as "specific intermetallic compounds") is equal to or less than a predetermined value as a support of the planographic printing plate precursor, it is possible to effectively suppress the color-forming defect over time while maintaining excellent visibility, and have completed the present invention.

As the cause of the occurrence of the color-forming defect over time, a chemical change of the acid color-forming agent to the color forming substance due to a corrosion reaction with the intermetallic compound present in the aluminum alloy plate is considered; and it is presumed that a planographic printing plate precursor in which the color-forming defect over time is suppressed while having excellent visibility due to the acid color-forming agent can be provided by reducing the number of specific intermetallic compounds in the aluminum alloy plate.

Fig. 1 is a schematic cross-sectional view showing an example of a configuration of the planographic printing plate precursor according to the embodiment of the present invention.

A planographic printing plate precursor 10 shown in Fig. 1 has a support 11 and an image-recording layer 12. The support 11 includes an aluminum alloy plate 13 and an anodic oxide film 14 disposed on the aluminum alloy plate 13.

The configuration of the planographic printing plate precursor is not limited to the aspect shown in Fig. 1. For example, as will be described later, an undercoat layer may be provided between the support and the image-recording layer, or a protective layer may be provided on a surface of the image-recording layer on a side opposite to the support.

Hereinafter, each configuration of the planographic printing plate precursor according to the embodiment of the present invention will be described.

[Support]

The planographic printing plate precursor according to the embodiment of the present invention has a support including an aluminum alloy plate and an anodic oxide film disposed on the aluminum alloy plate.

The anodic oxide film in the support is located on the image-recording layer side. That is, the planographic printing plate precursor includes the aluminum alloy plate, the anodic oxide film, and the image-recording layer in this order.

Hereinafter, the term "support" means a support including an aluminum alloy plate and an anodic oxide film disposed on the aluminum alloy plate, unless otherwise specified.

<Density of intermetallic compounds>

In the planographic printing plate precursor according to the embodiment of the present invention, the density of the specific intermetallic compounds on a surface of the support on a side opposite to the image-recording layer is 1,000 pieces/$mm^2$ or less.

Here, the intermetallic compound refers to a compound which does not form a solid solution in an aluminum alloy and is crystallized in the aluminum alloy in a form of a eutectic (from "Basics and Industrial Technology of Aluminum Materials", published by the Light Metal Association, pp. 32 and the like). In addition, it is known that a compound consisting of two or more metal elements does not always have a component atomic ratio equal to a stoichiometric ratio.

Examples of the intermetallic compound include an intermetallic compound consisting of two elements, such as $Al_3Fe$, $Al_6Fe$, $Al_mFe$, $Al_6Mn$, $Al_3Ti$, and $Al_2Cu$; an intermetallic compound consisting of three elements, such as $\alpha$-AlFeSi and $\beta$-AlFeSi; and an intermetallic compound consisting of four elements, such as $\alpha$-AlFeMnSi and $\beta$-AlFeMnSi.

In the present specification, the "major axis" of the intermetallic compound means the longest diameter in the intermetallic compound displayed in an image obtained by observing, from a normal direction, the surface of the support on the side opposite to the image-recording layer.

In addition, the major axis and the density of the intermetallic compounds described above are measured by the following method.

First, an oil on the surface of the support including the anodic oxide film and the aluminum alloy plate on the side opposite to the image-recording layer (hereinafter, also referred to as "target surface") is wiped off with acetone, and the support is used as a measurement sample. In a case where an inorganic matter is attached to the target surface, the inorganic matter on the target surface is removed by an appropriate removal method. In a case where the removal is difficult, the target surface may be subjected to mechanical polishing and mirror finishing.

Next, a reflected electron image of the target surface is imaged under the following conditions using a scanning electron microscope (SEM) (for example, "SU8010" manufactured by Hitachi High-Tech Corporation).

· Acceleration voltage: 12.0 kV
· Magnification: 2,000 times
· Probe setting: High
· Gain initial stage setting: medium
· Next-stage gain setting: high

Next, images of the reflected electron images are imaged from a normal direction of the target surface for five sites (an area of 1 $mm^2$ after 370 times magnification) randomly selected from the target surface. In the obtained images, the intermetallic compound present on the target surface appears as a particle-shaped region brighter than the surroundings. A size of the region having a particle shape, representing the intermetallic compound, is measured, and the number of regions having a major axis of 2.0 $\mu$m or more is calculated. An arithmetic average value of the number of regions having a major axis of 2.0 $\mu$m or more is calculated from the five SEM images, and converted into a value per unit area, whereby the density of the specific intermetallic compounds (unit: pieces/$mm^2$) is obtained.

In a case of calculating the density of the intermetallic compounds from the SEM image of the target surface, for example, image analysis software may be used as follows. Images of the five imaged sites are stored in a JPEG format, and are converted into a bitmap (BMP) format using MS-Paint (manufactured by Microsoft Corporation). The BMP format file is read by image analysis software Image Factory Ver. 3.2 Japanese version (manufactured by ASAHI HITECH Co., Ltd.) to perform image analysis, and then static binarization processing of the image is performed. From the obtained image, the number of particle-shaped regions of a white bright color corresponding to the intermetallic compound is counted, and the major axis of each particle-shaped region is designated as a feature amount to obtain a particle size distribution. From the result of the particle size distribution calculated from the image data of five sites, the density of the intermetallic compounds in which the major axis on the target surface is within a predetermined range (2.0 $\mu$m or more or the like) can be calculated.

Figs. 2 and 3 show an example of an image obtained by imaging the target surface of the support using the SEM. In each image, it can be seen that a white particle-shaped region corresponding to the intermetallic compound is shown in a portion surrounded by a dotted line circle or a solid line circle. The "major axis" of the metal compound is measured as the maximum value of a distance between two straight lines in a case where two parallel straight lines are assumed to be in

contact with a contour line of the particle-shaped region, with the particle-shaped region interposed therebetween.

The image shown in Fig. 2 is an example of an SEM image of the target surface of the support included in the planographic printing plate precursor according to the embodiment of the present invention. In the image shown in Fig. 2, all particle images of the intermetallic compound surrounded by the dotted line circle have a major axis of less than 2.0 μm, and a particle image having a major axis of 2.0 μm or more is not observed. On the other hand, in the image shown in Fig. 3, four particle images of the intermetallic compound surrounded by the solid line circle, in which a major axis (indicated by "L" in Fig. 3) is 2.0 μm or more, are observed.

In addition, the major axis and the density of the intermetallic compounds on the target surface of the support can also be measured by analyzing the target surface of the support using an electron probe micro analyzer (EPMA) to acquire a formulation distribution on the target surface.

From the viewpoint that the effect of the present invention is more excellent, the density of the specific intermetallic compounds on the surface of the support on the side opposite to the image-recording layer is preferably 500 pieces/mm$^2$ or less, more preferably 100 pieces/mm$^2$ or less, and still more preferably 10 pieces/mm$^2$ or less. The lower limit value thereof may be 0 pieces/mm$^2$.

In addition, from the viewpoint that the effect of the present invention is more excellent, a density of an intermetallic compounds having a major axis of 0.1 μm or more and less than 2.0 μm on the surface of the support on the side opposite to the image-recording layer is preferably 10,000 pieces/mm$^2$ or more, more preferably 25,000 pieces/mm$^2$ or more, and still more preferably 35,000 pieces/mm$^2$ or more.

The upper limit value thereof is not particularly limited, but from the viewpoint that the color-forming defect over time is more excellent, it is preferably 90,000 pieces/mm$^2$ or less and more preferably 70,000 pieces or less.

The support in which the density of the specific intermetallic compounds on the target surface is within the above-described range can be manufactured, for example, by setting conditions such as a cooling rate in a case of casting an aluminum alloy in a manufacturing method of a support, which will be described later.

In addition, a support having the density of the intermetallic compounds having a major axis of 0.1 μm or more and less than 2.0 μm on the target surface can also be manufactured in the same manner by setting conditions such as a cooling rate in a case of casting an aluminum alloy in a manufacturing method of a support, which will be described later.

<Aluminum alloy plate>

The aluminum alloy plate consists of a metal containing dimensionally stable aluminum as a main component and containing a small amount of foreign elements.

Examples of the foreign element contained in an aluminum alloy constituting the aluminum alloy plate include silicon, iron, manganese, copper, magnesium, chromium, zinc, bismuth, nickel, and titanium. Among these, at least one foreign element selected from the group consisting of silicon, iron, manganese, titanium, and copper is often contained in the aluminum alloy plate as a foreign element constituting the intermetallic compound together with aluminum. The total content of the foreign elements in the aluminum alloy is preferably 10% by mass or less.

A formulation of the aluminum alloy plate is not particularly limited, and known materials (for example, materials satisfying standards such as JIS A 1050, JIS A 1100, JIS A 3103, and JIS A 3005) can be appropriately used.

Examples of the formulation of the aluminum alloy plate include the following formulation.

- Si: 0.03% to 0.20% by mass
- Fe: 0.11% to 0.45% by mass
- Al: remainder (for example, 99% by mass or more)

The aluminum alloy plate may contain the above-described foreign element as an alloy component.

A content of Si contained in the aluminum alloy plate is preferably 0.03% to 0.20% by mass, more preferably 0.04% to 0.18% by mass, and still more preferably 0.05% to 0.15% by mass.

The reason for this is that, in a case where the content of Si is within the range, even when the aluminum alloy plate is subjected to an anodization treatment after an electrolytic roughening treatment, defects are unlikely to occur in the anodic oxide film, and corrosion stain suppressing property as the planographic printing plate is improved.

Si is an element contained in an Al base metal as a raw material in an amount of approximately 0.03% to 0.1% by mass as unavoidable impurities, and is often intentionally added in a trace amount in order to prevent variation due to differences in raw materials.

A solid solution amount of Si in the aluminum alloy plate is preferably 120 to 600 ppm by mass, more preferably 150 to 600 ppm by mass, and still more preferably 150 to 500 ppm by mass.

In a case where the solid solution amount of Si is within the range, the anodic oxide film is homogeneous, and micropores having an average opening diameter of 0.01 to 0.05 μm and 0.05 to 1.5 μm are uniformly formed on the entire surface.

An amount of Fe contained in the aluminum alloy plate, which forms a solid solution in aluminum, is small, and most of Fe remains as the intermetallic compound.

A content of Fe contained in the aluminum alloy plate is preferably 0.11% to 0.45% by mass, more preferably 0.15% to 0.45% by mass, and still more preferably 0.20% to 0.43% by mass.

In a case where the content of Fe is within the range, Fe is dispersed as a fine intermetallic compound, and these work as a starting point of the electrolytic roughening treatment, and as a result, the anodic oxide film is homogeneous.

In addition, from the viewpoint of easily manufacturing the aluminum alloy plate having a predetermined amount of the intermetallic compound having a major axis of 0.1 μm or more and less than 2.0 μm, the solid solution amount of Fe in the aluminum alloy plate is preferably 100 ppm or less, more preferably 50 ppm or less, and still more preferably 40 ppm or less.

In addition, from the viewpoint of more excellent heat resistance of the aluminum alloy plate, the solid solution amount of Fe in the aluminum alloy plate is preferably 10 ppm or more, and more preferably 20 ppm or more.

The aluminum alloy plate may contain Cu. In a case where the aluminum alloy plate contains Cu, from the viewpoint of maintaining uniformity of the electrolytic roughening, a content of Cu is preferably 0.030% by mass or less.

The aluminum alloy plate may contain a crystal grain refining element such as Ti and B in order to prevent cracking during casting. In a case where the aluminum alloy plate contains Ti, for example, Ti can be added in a range of 0.05% by mass or less. In a case where the aluminum alloy plate contains B, for example, B can be added in a range of 0.02% by mass or less.

The aluminum alloy plate may contain unavoidable impurities.

Examples of the unavoidable impurities include Mg, Mn, Zn, Cr, Zr, V, Zn, and Be; and these may be contained in an amount of 0.05% by mass or less, respectively.

In addition, most of the unavoidable impurities are contained in the Al base metal. The effect of the present invention is not impaired as long as the unavoidable impurities are contained in, for example, a base metal having an Al purity of 99.5%.

As the unavoidable impurities, for example, impurities in an amount described in "Aluminum Alloys: Structure and properties" (1976) by L. F. Mondolfo may be contained.

The remainder of the aluminum alloy plate other than the foreign elements and unavoidable impurities described above is Al.

A width of the aluminum alloy plate is preferably approximately 400 to 2,000 mm, and a thickness thereof is preferably 0.1 to 0.6 mm and more preferably 0.1 to 0.5 mm. Both the width and the thickness can be appropriately changed depending on the size of the printing press, the size of the printing plate, and the user's request.

<Anodic oxide film>

The anodic oxide film included in the support is a film generally produced on the surface of the aluminum alloy plate by an anodization treatment.

An amount of the anodic oxide film is not particularly limited, but is preferably 2.0 g/$m^2$ or more, more preferably 3.2 g/$m^2$ or more, and still more preferably 3.4 g/$m^2$ or more. The upper limit thereof is not particularly limited, but is often 5.0 g/$m^2$ or less, preferably 4.0 g/$m^2$ or less.

(Micropore)

The anodic oxide film preferably has a fine pore (hereinafter, also referred to as "micropore") formed on a surface of the anodic oxide film on the image-recording layer side (hereinafter, also referred to as "film surface"). The micropore extends along a depth direction (direction toward the aluminum alloy plate; a thickness direction) from the film surface. In addition, a large number of micropores are formed on the film surface, and each of the micropores is often uniformly distributed on the film surface.

The "micropore" is a term generally used to refer to a pore structure formed in an anodic oxide film by an anodization treatment, and does not define a size of the pore.

A density of the micropores on the film surface is not particularly limited, but is preferably 200 to 2,000 pieces/μ$m^2$ and more preferably 400 to 1,500 pieces/μ$m^2$.

The density of the micropores is a value obtained by observing the film surface with a field emission scanning electron microscope (FE-SEM) at a magnification of 150,000 times, randomly selecting a measurement region of 400 × 600 $nm^2$ in four images obtained by observing four different sites, measuring the number of micropores present in the measurement region, calculating the number of micropores per area of the measurement region for each image, and arithmetically averaging the calculated values.

From the viewpoint of more excellent printing durability, an average diameter (average opening diameter) of the micropores on the film surface is preferably 15 to 100 nm, more preferably 20 to 50 nm, and still more preferably 23 to 35

nm.

The average diameter of the micropores is a value obtained by observing the film surface with a field emission scanning electron microscope (FE-SEM) at a magnification of 150,000 times, randomly selecting a measurement region of 400 × 600 $nm^2$ in four images obtained by observing four different sites, measuring sizes (diameters) of micropores present in the measurement region, and arithmetically averaging all the measured values.

In a case where a shape of an opening portion by the micropore on the film surface is not circular, an equivalent circle diameter is used. The "equivalent circle diameter" means a diameter of a circle in a case where a circle having the same projected area as the projected area of the opening portion is assumed.

An opening ratio of the micropores on the film surface is preferably 10% to 90% and more preferably 30% to 85%.

The opening ratio refers to a value obtained by converting, into a percentage, a value obtained by multiplying an average area of the opening portions formed by the micropores, which is calculated by using an average radius obtained by dividing an average diameter of the micropores on the film surface by 2, by a density (number density) of the micropores on the film surface.

A depth of the micropore is not particularly limited, but is preferably 10 nm to 1,000 nm, more preferably 50 nm to 500 nm, and still more preferably 70 nm to 200 nm. The depth of the micropore means a distance in the depth direction from the film surface of the micropore to the deepest portion of a bottom portion of the micropore.

The depth of the micropore is a value obtained by observing a cross section of the anodic oxide film along the depth direction with the FE-SEM at a magnification of 150,000, randomly selecting 25 or more micropores from four observation images obtained by observing four different cross sections, measuring depths of the selected micropores, and arithmetically averaging the measured values.

A shape of the micropore is not particularly limited, and the micropore may have a substantially straight tubular shape (substantially cylindrical shape) in which the diameter of the micropore is substantially unchanged in the depth direction, or the diameter of the micropore may change continuously or discontinuously in the depth direction. Examples of the shape in which the diameter of the micropore changes in the depth direction include a conical shape in which the diameter decreases in the depth direction, a frustum shape in which the diameter increases in the depth direction, and a shape in which a plurality of hole portions having different diameters along the depth direction communicate with each other as will be described later.

In addition, a shape of the bottom portion of the micropore is not particularly limited, and may be a curved (convex) or planar.

Fig. 4 is a schematic cross-sectional view showing an example of an embodiment of the anodic oxide film. An anodic oxide film 14A shown in Fig. 4 has a micropore 20 composed of a large-diameter hole portion 22 and a small-diameter hole portion 24.

The large-diameter hole portion 22 is a hole portion which extends from a film surface 21 (a surface of the anodic oxide film 14A on the image-recording layer side which is not shown) to a position at a depth D1 (see Fig. 4), and communicates with the small-diameter hole portion 24 at a bottom portion 22A. The small-diameter hole portion 24 is a hole portion which communicates with the bottom portion 22A of the large-diameter hole portion 22 and further extends from a communicate position 23 to a position at a depth D2 (see Fig. 4).

An average diameter of the large-diameter hole portion 22 on the film surface 21 is the same as the average diameter of the micropore on the film surface described above, and a preferred range of the average diameter and the measuring method are also the same.

The depth D1 of the large-diameter hole portion 22 (distance from the film surface 21 to the bottom portion 22A) is preferably 10 to 1,000 nm, more preferably 20 to 1,000 nm, still more preferably 30 to 500 nm, and particularly preferably 50 to 200 nm.

The depth D1 of the large-diameter hole portion 22 and the depth D2 of the small-diameter hole portion 24 can be measured according to the method of measuring the depth of the micropore described above.

A shape of the large-diameter hole portion 22 is not limited to the substantially straight tubular shape (substantially cylindrical shape) shown in Fig. 4, and may be, for example, a conical shape in which the diameter decreases in the depth direction or a frustum shape in which the diameter increases in the depth direction. The shape of the large-diameter hole portion 22 is preferably a substantially straight tubular shape.

A shape of the bottom portion 22A of the large-diameter hole portion 22 is not particularly limited, and may be a curved (convex) or planar.

The small-diameter hole portion 24 is a hole portion which communicates with the bottom portion 22A of the large-diameter hole portion 22 and further extends from the communicate position 23 in the depth direction. In the micropore 20 shown in Fig. 4, one large-diameter hole portion 22 communicates with one small-diameter hole portion 24, but two or more small-diameter hole portions may communicate with one large-diameter hole portion.

An average diameter of the small-diameter hole portion 24 at the communicate position 23 is not particularly limited as long as it is smaller than the average diameter of the large-diameter hole portion 22, and is preferably 15 nm or less, more preferably 13 nm or less, still more preferably 11 nm or less, and particularly preferably 10 nm or less. The lower

limit thereof is not particularly limited, but is preferably 5 nm or more.

The average diameter of the small-diameter hole portion at the communicate position is a value obtained by observing the film surface with a field emission scanning electron microscope (FE-SEM) at a magnification of 150,000 times, randomly selecting a measurement region of 400 × 600 $nm^2$ in four images obtained by observing four different sites, measuring sizes (diameters) of small-diameter hole portions present in the measurement region, and arithmetically averaging all the measured values.

In a case where the large-diameter hole portion is deep when the above-described average diameter of the small-diameter hole portion is measured, an upper part (region where the large-diameter hole portion is present) of the anodic oxide film may be cut (for example, cut by argon gas) as necessary, the exposed surface of the anodic oxide film may be observed using the FE-SEM, and the average diameter of the small-diameter hole portion at the communicate position with the large-diameter hole portion may be obtained according to the above-described method.

In addition, in a case where a shape of the small-diameter hole portion at the communicate position with the large-diameter hole portion is not circular, an equivalent circle diameter is used.

The depth D2 of the small-diameter hole portion 24 (distance from the communicate position 23 with the large-diameter hole portion 22 to a bottom portion 24A of the small-diameter hole portion 24) is preferably 100 to 5,000 nm, more preferably 200 to 4,000 nm, still more preferably 300 to 3,000 nm, and particularly preferably 500 to 1,800 nm.

A shape of the small-diameter hole portion 24 is not limited to the substantially straight tubular shape (substantially cylindrical shape) shown in Fig. 4, and may be, for example, a conical shape in which the diameter decreases in the depth direction or a frustum shape in which the diameter increases in the depth direction. The shape of the small-diameter hole portion 24 is preferably a substantially straight tubular shape.

A shape of the bottom portion 24A of the small-diameter hole portion 24 is not particularly limited, and may be a curved (convex) or planar.

A ratio of the average diameter of the large-diameter hole portion 22 on the film surface 21 to the average diameter of the small-diameter hole portion 24 at the communicate position 23 ((Average diameter of large-diameter hole portion on film surface)/(Average diameter of small-diameter hole portion at communicate position)) is preferably 1.1 to 13 and more preferably 2.5 to 6.5.

In addition, a ratio (D1/D2) of the depth D1 of the large-diameter hole portion 22 to the depth D2 of the small-diameter hole portion 24 is preferably 0.005 to 50 and more preferably 0.025 to 40.

Preferred examples of the micropore composed of the large-diameter hole portion and the small-diameter hole portion include a micropore composed of a large-diameter hole portion in which the depth D1 from the film surface is 30 to 1,000 nm and an average diameter on the film surface is 15 to 50 nm, and a small-diameter hole portion in which the depth D2 from the communicate position with the large-diameter hole portion is 300 to 3,000 nm and an average diameter at the communicate position with the large-diameter hole portion is 15 nm or less. In the above-described micropore, a micropore in which the average diameter, depth, and shape of each hole portion are the above-described preferred aspects is more preferable.

Fig. 5 is a schematic cross-sectional view showing another example of the embodiment of the anodic oxide film. An anodic oxide film 14B shown in Fig. 5 has a micropore 30 composed of an upper hole portion 32, a middle hole portion 34, and a lower hole portion 36. In the micropores 30, the upper hole portion 32, the middle hole portion 34, and the lower hole portion 36 communicate with each other.

The upper hole portion 32 is a hole portion which extends from a film surface 31 (a surface of the anodic oxide film 14B on the image-recording layer side which is not shown) to a position at a depth D3 (see Fig. 5), and communicates with the middle hole portion 34 at a bottom portion 32A.

The middle hole portion 34 is a hole portion which communicates with the bottom portion 32A of the upper hole portion 32, further extends from a communicate position 33 with the upper hole portion 32 to a position at a depth D4 (see Fig. 5), and communicates with the lower hole portion 36 at a bottom portion 34A.

The lower hole portion 36 is a hole portion which communicates with the bottom portion 34A of the middle hole portion 34, and further extends from a communicate position 35 with the middle hole portion 34 to a bottom portion 36A at a depth D5 (see Fig. 5).

An average diameter of the upper hole portion 32 on the film surface 31 is the same as the average diameter of the micropore on the film surface described above, and a preferred range of the average diameter and the measuring method are also the same.

The depth D3 of the upper hole portion 32 (distance from the film surface 31 to the bottom portion 32A) is preferably 10 to 1,000 nm, more preferably 30 to 1,000 nm, still more preferably 50 to 500 nm, and particularly preferably 90 to 300 nm.

The depth D3 of the upper hole portion 32, the depth D4 of the middle hole portion 34 described later, and the depth D5 of the lower hole portion 36 described later can be measured according to the method of measuring the depth of the micropore described above.

A shape of the upper hole portion 32 is not limited to the substantially straight tubular shape (substantially

cylindrical shape) shown in Fig. 5, and may be, for example, a conical shape in which the diameter decreases in the depth direction or a frustum shape in which the diameter increases in the depth direction. The shape of the upper hole portion 32 is preferably a substantially straight tubular shape.

The middle hole portion 34 is a hole portion which communicates with the bottom portion 32A of the upper hole portion 32 and further extends from the communicate position 33 in the depth direction.

The maximum diameter of the middle hole portion 34 is preferably 20 to 100 nm, more preferably 30 to 100 nm, and still more preferably 40 to 80 nm.

In addition, the maximum diameter of the middle hole portion 34 may be, for example, 1.2 to 5.0 times the average diameter of the upper hole portion 32 on the film surface 31.

The average diameter of the middle hole portion 34 at the communicate position 33 and the average diameter of the lower hole portion 36 at the communicate position 35 described later can be measured according to the method of measuring the average diameter of the small-diameter hole portion 24 at the communicate position 23 with the large-diameter hole portion 22 described above.

The depth D4 of the middle hole portion 34 (distance from the communicate position 33 with the large-diameter hole portion 32 to the communicate position 35 with the lower hole portion 36) is preferably 500 to 3,000 nm, more preferably 700 to 2,000 nm, and still more preferably 800 to 1,600 nm.

A shape of the middle hole portion 34 is not limited to the substantially straight tubular shape (substantially cylindrical shape) shown in Fig. 5, and may be, for example, a conical shape in which the diameter decreases in the depth direction or a frustum shape in which the diameter increases in the depth direction. The shape of the middle hole portion 34 is preferably a substantially straight tubular shape.

A shape of the bottom portion 34A of the middle hole portion 34 is not particularly limited, and may be a curved (convex) or planar.

In addition, the micropore 30 shown in Fig. 5 has one substantially straight tubular hole portion as the middle hole portion 34 between the upper hole portion 32 and the lower hole portion 36, but the middle hole portion may have a structure in which a plurality of hole portions having different diameters along the depth direction communicate with each other. In a case where the middle hole portion has a plurality of hole portions, preferred aspects of the size and shape of each hole portion are as described above.

The lower hole portion 36 is a hole portion which communicates with the bottom portion 34A of the middle hole portion 34 and further extends from the communicate position 35 in the depth direction.

It is preferable that an average diameter of the lower hole portion 36 at the communicate position 35 is smaller than the average diameter of the upper hole portion 32 on the film surface 31, and is smaller than the average diameter of the middle hole portion 34 at the communicate position 33. The average diameter of the lower hole portion 36 at the communicate position 35 is preferably 15 nm or less, more preferably 13 nm or less, still more preferably 11 nm or less, and particularly preferably 10 nm or less. The lower limit thereof is not particularly limited, but is preferably 5 nm or more.

The depth D5 of the lower hole portion 36 (distance from the communicate position 35 with the middle hole portion 34 to the bottom portion 36A of the lower hole portion 36) is preferably 500 to 3,000 nm, more preferably 700 to 2,000 nm, still more preferably 700 to 1,700 nm, and particularly preferably 800 to 1,500 nm.

A shape of the lower hole portion 36 is not limited to the substantially straight tubular shape (substantially cylindrical shape) shown in Fig. 5, and may be, for example, a conical shape in which the diameter decreases in the depth direction or a frustum shape in which the diameter increases in the depth direction. The shape of the lower hole portion 36 is preferably a substantially straight tubular shape.

A shape of the bottom portion 36A of the lower hole portion 36 is not particularly limited, and may be a curved (convex) or planar.

Preferred examples of the micropore composed of the upper hole portion, the middle hole portion, and the small-diameter hole portion include a micropores composed of an upper hole portion in which the depth D3 from the film surface is 30 to 1,000 nm and an average diameter on the film surface is 15 to 50 nm, a middle hole portion which has a maximum diameter of 20 to 100 nm and is larger than the average diameter of the upper hole portion on the film surface, and a small-diameter hole portion in which the depth D5 from the communicate position with the middle hole portion is 500 to 3,000 nm and an average diameter at the communicate position with the middle hole portion is 15 nm or less.

In the above-described micropore, a micropore in which the average diameter, depth, and shape of each hole portion are the above-described preferred aspects is more preferable.

The structure of the micropore in the anodic oxide film is not limited to the aspects shown in Figs. 4 and 5.

For example, as described above, the middle hole portion may have a structure in which a plurality of hole portions having different diameters along the depth direction communicate with each other. That is, the micropore may have a structure in which four or more hole portions having different diameters communicate with each other along the depth direction.

In addition, the micropore of the anodic oxide film may be composed of a small-diameter hole portion extending from a film surface in a depth direction, and a large-diameter hole portion communicating with a bottom portion of the small-diameter hole portion, further extending in the depth direction from a communicate position, and having a diameter at the communicate position larger than a diameter of the small-diameter hole portion on the film surface. The size and shape of each hole portion in this case may be the same as those of each hole portion of the micropore shown in Fig. 4, including preferred aspects.

(Recessed portion density)

From the viewpoint of more excellent printing durability, a density of recessed portions having a depth of 0.7 μm or more from an average plane (hereinafter, also referred to as "specific recessed portions"), which is obtained by measuring a surface of the support on a side of the anodic oxide film in a range of 400 μm × 400 μm using a non-contact three-dimensional roughness meter, is preferably 3,000 pieces/$mm^2$ or more, more preferably 3,500 pieces/$mm^2$ or more, and still more preferably 5,000 pieces/$mm^2$ or more. The upper limit of the density of the specific recessed portions is not particularly limited, but is preferably 10,000 pieces/$mm^2$ or less, and more preferably 8,000 pieces/$mm^2$ or less.

The density of the specific recessed portions in the support refers to a value measured as follows.

First, using a non-contact three-dimensional roughness meter (VertScan, manufactured by Ryoka Systems Inc.), three-dimensional data is obtained by scanning a surface of the support on the anodic oxide film side (image-recording layer side) in a range of 400 μm × 400 μm in a non-contact manner with a resolution of 0.01 μm. The device contents and measurement conditions of VertScan are as follows.

(1) Device contents

CCD camera: Sony HR-57
Objective lens: ×10
Lens barrel: ×1
Wavelength filter: 530 white

(2) Measurement condition

Measurement mode: wave
Visual field range: 400 μm × 400 μm
Scan range: start + 6 μm, stop -10 μm

Next, the obtained three-dimensional data is subjected to image analysis using software (SX Viewer, manufactured by Ryoka Systems Inc.), and the number of recessed portions having a depth of 0.7 μm or more from the obtained average plane is counted. The average plane means a plane located at a height obtained by averaging height values of all measurement data of the surface of the support on the image-recording layer side in the measurement region (400 μm × 400 μm).

The density of the specific recessed portions is obtained by measuring five sites for each sample, calculating the number of predetermined recesses at each site, acquiring the average value thereof, and converting the acquired average value into the number of recessed portions per unit area ($mm^2$).

(Surface area ratio ΔS)

In the support, from the viewpoint of more excellent printing durability, a surface area ratio ΔS calculated by the following expression (S1) from an actual area Sx which is obtained by an approximate three-point method from three-dimensional data obtained by, using an atomic force microscope, measuring 256 × 256 points in a range of 25 μm × 25 μm on a surface of the support on a side of the anodic oxide film and from a geometrically measured area S0 of the surface of the support on the side of the anodic oxide film is preferably 25% or more, more preferably 35% or more, and still more preferably 45% or more. The upper limit of the surface area ratio ΔS is not particularly limited, but is preferably 90% or less and more preferably 80% or less.

$$\Delta S = (Sx - S0)/S0 \times 100\ (\%) \cdots (S1)$$

The surface area ratio ΔS in the support refers to a value measured as follows.

Specifically, the support is cut into a size of 1 $cm^2$ and set on a horizontal sample stand which is provided on a piezo scanner, a cantilever is allowed to approach the surface of the sample, the surface is scanned in an XY direction in a case where the cantilever reaches a region where an atomic force works, and the unevenness of the sample is captured by

the displacement of the piezo in a Z direction. As the piezo scanner, a piezo scanner capable of performing scanning a distance of 150 μm in the XY direction and a distance of 10 μm in the Z direction is used. The measurement is performed using a cantilever having a resonance frequency of 130 kHz to 200 kHz and a spring constant of 7 to 20 N/m (OMCL-AC200-TS, manufactured by Olympus Corporation) in a dynamic force mode (DFM). In addition, by carrying out the least squares approximation of the acquired three-dimensional data, the slight inclination of the sample is corrected to acquire a reference surface.

During the measurement, 256 × 256 points in an area of 25 × 25 μm on the surface are measured. The surface area ratio is acquired by setting the resolution in the X direction to 0.05 μm, the resolution in the Y direction to 1.9 μm, the resolution in the Z direction to 1 nm, and the scan speed to 18 μm/sec.

From the viewpoint of improving image visibility in the on-press development-type planographic printing plate precursor, it is useful that a brightness of the surface of the anodic oxide film in the support is high.

Usually, in a printing step of the planographic printing plate, before the printing plate is mounted on a printing press, the printing plate is inspected to check whether an image is recorded as intended. For the on-press development-type planographic printing plate precursor, it is required to check the image at the stage of imagewise exposure. Therefore, a unit generating a so-called printed image in an image exposed portion is used.

Examples of a method of quantitatively evaluating ease of seeing the image area (visibility) of the on-press development-type planographic printing plate precursor imagewise exposed include a method of measuring the lightness of the image exposed portion and the lightness of a non-exposed portion and calculating a difference therebetween. Here, as the lightness, a value of lightness L* in a CIE L*a*b* color system can be used, and the lightness can be measured using a color difference meter (SpectroEye, manufactured by X-Rite, Incorporated). As the difference between the measured lightness of the image exposed portion and the measured lightness of the non-exposed portion is larger, it is easier to see the image area.

In order to improve the visibility, that is, in order to increase the difference between the lightness of the image exposed portion and the lightness of the non-exposed portion, the value of lightness L* of the surface of the anodic oxide film in the L*a*b* color system is preferably high, and more preferably 60 to 100.

The support may include, as necessary, a back coat layer containing an organic polymer compound described in JP1993-045885A (JP-H5-045885A), an alkoxy compound of silicon described in JP1994-035174A (JP-H6-035174A), or the like on the surface on the aluminum alloy plate side.

<Manufacturing method of support>

The support used in the planographic printing plate precursor according to the embodiment of the present invention can be manufactured by a known method.

Examples of a preferred aspect of the manufacturing method of the above-described support include a method including a step of performing a roughening treatment on a cast aluminum alloy plate (roughening treatment step) and a step of anodizing the aluminum alloy plate subjected to the roughening treatment (anodization treatment step).

As the aluminum alloy plate used for manufacturing the support, an aluminum alloy plate manufactured by a continuous casting method is preferable.

In rolling of the continuous casting, since a solidification rate of a surface of a cast material is high, a crystal precipitate is fine and uniform, a homogenization heat treatment of a cast slab required by a semi-continuous casting method (DC casting method) is not required, and the quality is stable because the cast slab is not subjected to a long-time treatment, which is appropriate as a support for the planographic printing plate.

Specifically, the following method is suitably exemplified as the continuous casting method.

First, an aluminum alloy molten metal adjusted to a predetermined alloy component content is subjected to a purification treatment as necessary.

Examples of the purification treatment include a degassing treatment (for example, a flux treatment using argon gas, chlorine gas, or the like) for removing unnecessary gas such as hydrogen in the molten metal; filtering treatments using so-called rigid media filters such as a ceramic tube filter and a ceramic foam filter, filters using alumina flakes, alumina balls, or the like as filter media, and glass cross filters; and treatments in which such degassing treatment and filtering treatment are combined.

It is preferable that these purification treatments are performed in order to prevent defects due to foreign substances such as non-metallic inclusions and oxides in the molten metal, and defects due to gas dissolved in the molten metal. The filtering of the molten metal is described in JP1994-057432A (JP-H6-057432A), JP1991-162530A (JP-H3-162530A), JP1993-140659A (JP-H5-140659A), JP1992-231425A (JP-H4-231425A), JP1992-276031A (JP-H4-276031A), JP1993-311261A (JP-H5-311261A), and JP1994-136466A (JP-H6-136466A). In addition, the degassing of the molten metal is described in JP1993-051659A (JP-H5-051659A), JP1993-049148A (JP-H5-049148A), and JP1995-040017A (JP-H7-040017A).

Next, continuous casting is performed using the molten metal subjected to the purification treatment as

necessary.

The continuous casting is a process of supplying the aluminum alloy molten metal between a pair of members such as cooling rolls through a molten metal supply nozzle, and rolling while solidifying the aluminum alloy molten metal by the pair of cooling rolls or the like. The continuous casting can be performed by a method using a cooling roll, represented by a twin-roll method (Hunter method) and a 3C method, a method using a cooling belt or a cooling block, represented by a twin-belt method (Hassler method) and an Alusuisse caster II type, and the like.

The continuous casting method generally has a feature that the solid solubility of the alloy component in the aluminum matrix can be increased since the cooling rate is higher than that in the DC casting method. In the continuous casting method, the molten metal is cooled at a cooling rate in a range of 100 to 1000 °C/sec to be solidified.

As described above, in a case where the cooling rate in a case of casting the aluminum alloy plate is high, the density of the specific intermetallic compounds in the target surface of the manufactured support tends to be reduced.

Regarding the continuous casting method, the techniques proposed by the present applicant are described in JP1991-079798A (JP-H3-079798A), JP1993-201166A (JP-H5-201166A), JP1993-156414A (JP-H5-156414A), JP1994-262203A (JP-H6-262203A), JP1994-122949A (JP-H6-122949A), JP1994-210406A (JP-H6-210406A), and JP1994-026308A (JP-H6-026308A).

In the continuous casting, for example, in a case where a method using a cooling roll, such as a Hunter method, is used, it is possible to directly continuously cast a casting plate having a plate thickness of 1 to 10 mm, and there is an advantage that a hot rolling step can be omitted.

In addition, in a case where a method using a cooling belt, such as a Hasley method, is used, a casting plate having a plate thickness of 10 to 50 mm can be cast. In general, a continuously cast and rolled plate having a plate thickness of 1 to 10 mm is obtained by disposing hot rolling rolls immediately after casting using a method using a cooling belt and continuously rolling the cast product.

From the viewpoint that the density of the specific intermetallic compounds can be reduced and the density of the intermetallic compounds having a major axis of 0.1 μm or more and less than 2.0 μm can be increased to the above-described preferred ranges, a method using a cooling roll is preferable. In addition, it is preferable that the plate thickness of the casting plate manufactured using the cooling roll is 7 mm or less.

After the continuous casting, the obtained aluminum alloy plate is finished to a predetermined thickness, for example, a plate thickness of 0.1 to 0.5 mm, through a cold rolling step or the like as necessary.

In the continuous casting, an intermediate annealing treatment may be performed before or after cold rolling or during cold rolling, from the viewpoint of increasing the solid solution amount of Si or suppressing the solid solution amount of Fe. In addition, the appropriate intermediate annealing treatment also has an effect of refining crystal grains, and thus the surface quality can be improved.

From the viewpoint of optimizing the size and the number of the intermetallic compounds (that is, from the viewpoint of reducing the density of the specific intermetallic compounds and adjusting the density of the intermetallic compounds having a major axis of 0.1 μm or more and less than 2.0 μm to the above-described preferred ranges), it is desirable to avoid performing the above-described intermediate annealing treatment at an excessively high temperature or for an excessively long time. In particular, it is desirable to avoid performing a heat treatment at a temperature exceeding 550°C and for more than 36 hours. This is because the above-described intermetallic compound may be re-solidified in aluminum, or the intermetallic compound of a quasi-stable phase, such as α-AlFeSi and β-AlFeSi, may be changed to a stable phase of $Al_3Fe$.

From the above-described viewpoint, Examples of suitable conditions for the above-described intermediate annealing treatment include conditions for heating using a batch annealing furnace at 280°C to 550°C for 2 to 20 hours, preferably 350°C to 550°C for 2 to 10 hours and more preferably 350°C to 550°C for 2 to 5 hours; and conditions for heating using a continuous annealing furnace at 400°C to 550°C for 6 minutes or less, preferably 450°C to 550°C for 2 minutes or less.

The aluminum alloy plate finished to have a predetermined thickness, for example, 0.1 to 0.5 mm by the above-described steps may further improve leveling by a correction device such as a roller leveler and a tension leveler. The improvement of the leveling may be performed after cutting the aluminum alloy plate into a sheet shape, but in order to improve productivity, it is preferable to perform the improvement in a state of a continuous coil.

In addition, the aluminum alloy plate may be processed to a predetermined plate width by passing through a slitter line.

Furthermore, in order to prevent scratches caused by friction between aluminum alloy plates, a thin oil film may be provided on the surface of the aluminum alloy plate. As the oil film, a volatile oil film or a non-volatile oil film is appropriately used as necessary.

(Roughening treatment step)

The roughening treatment step is a step of performing a roughening treatment on the surface of the aluminum

alloy plate.

As the roughening treatment, generally, one of a mechanical roughening treatment, a chemical roughening treatment, or an electrochemical roughening treatment, or a combination of two or more of the treatments is used.

From the viewpoint of efficiently manufacturing a predetermined support, it is preferable that the roughening treatment step has a hydrochloric acid electrolytic treatment step of performing alternating current electrolysis on the aluminum alloy plate in a hydrochloric acid treatment liquid which may contain sulfuric acid, at a liquid temperature of the hydrochloric acid treatment liquid of 30°C or lower, a sum of electric quantities involved in an anodic reaction of the aluminum alloy plate of 500 C/dm$^2$ or less, and a peak current value of an alternating current waveform of 80 A/dm$^2$ or less, thereby producing a roughened aluminum alloy plate.

In a case where the hydrochloric acid treatment liquid contains sulfuric acid, a ratio of a content of sulfuric acid to a content of hydrochloric acid is preferably 0.1 or less.

It is preferable that the manufacturing method of the support includes, after the above-described hydrochloric acid electrolytic treatment step, an anodization treatment step of subjecting the roughened aluminum alloy plate to an anodization treatment to form an anodic oxide film of aluminum on the aluminum alloy plate.

It is preferable that the manufacturing method of the support includes, after the above-described anodization treatment step, a pore widening treatment step of subjecting the aluminum alloy plate on which the anodic oxide film is formed to an etching treatment to enlarge a diameter of the micropore in the anodic oxide film.

Hereinafter, each of the above-described steps and any processing will be described in detail.

(Mechanical roughening treatment)

The manufacturing method of the support may include a mechanical roughening treatment before the hydrochloric acid electrolytic treatment step.

Examples of the mechanical roughening treatment method include a wire brush grain method of scratching the surface of the aluminum alloy plate with a metal wire; a ball grain method of graining the surface of the aluminum alloy plate with a polishing ball and an abrasive; and a brush grain method of graining the surface with a nylon brush and an abrasive, which is described in JP1994-135175A (JP-H6-135175A) and JP1975-040047B (JP-S50-040047B).

(Hydrochloric acid electrolytic treatment step)

The hydrochloric acid electrolytic treatment step in the manufacturing method of the support is preferably a hydrochloric acid electrolytic treatment step of performing alternating current electrolysis on the aluminum alloy plate in a hydrochloric acid treatment liquid which may contain sulfuric acid, at a liquid temperature of the hydrochloric acid treatment liquid of 30°C or lower, a sum of electric quantities involved in an anodic reaction of the aluminum alloy plate of 500 C/dm$^2$ or less, and a peak current value of an alternating current waveform of 80 A/dm$^2$ or less, thereby producing a roughened aluminum alloy plate. By performing such a hydrochloric acid electrolytic treatment and then performing the anodization treatment described later, the above-described planographic printing plate precursor can be efficiently manufactured.

The hydrochloric acid treatment liquid contains hydrochloric acid. A concentration of the hydrochloric acid in the hydrochloric acid treatment liquid is preferably 5 to 30 g/L and more preferably 10 to 20 g/L.

The hydrochloric acid treatment liquid may contain sulfuric acid. In a case where the hydrochloric acid treatment liquid contains sulfuric acid, a concentration of the sulfuric acid in the hydrochloric acid treatment liquid is preferably 2.0 g/L or less, more preferably 1.0 g/L or less, and still more preferably 0.5 g/L. In a case where the hydrochloric acid treatment liquid contains sulfuric acid, the lower limit of the concentration of the sulfuric acid in the hydrochloric acid treatment liquid is not particularly limited, and may be more than 0 g/L.

The hydrochloric acid treatment liquid may contain aluminum ions. In a case where the hydrochloric acid treatment liquid contains aluminum ions, a concentration of the aluminum ions is preferably 1.0 to 30.0 g/L and more preferably 5.0 to 20.0 g/L.

In a case where the hydrochloric acid treatment liquid contains sulfuric acid, a ratio of the content of sulfuric acid to the content of hydrochloric acid is preferably 0.1 or less. The lower limit thereof is not particularly limited, and may be more than 0.

A liquid temperature of the hydrochloric acid treatment liquid is preferably 30°C or lower, more preferably 26°C or lower, and still more preferably 23°C or lower. The lower limit thereof is not particularly limited, but is preferably 10°C or higher and more preferably 15°C or higher.

In the hydrochloric acid electrolytic treatment step, the sum of electric quantities (the sum of electric quantities involved in an anodic reaction of the aluminum alloy plate at the time when the hydrochloric acid electrolytic treatment is completed) is preferably 500 C/dm$^2$ or less, and more preferably 350 C/dm$^2$ or less. The lower limit of the sum of electric quantities is not particularly limited, but is preferably 50 C/dm$^2$ or more and more preferably 200 C/dm$^2$ or more.

The peak current value of an alternating current waveform is preferably 80 A/dm$^2$ or less and more preferably 70

$A/dm^2$ or less. The above-described peak current value is preferably 10 $A/dm^2$ or more and more preferably 20 $A/dm^2$ or more.

The alternating current waveform of the hydrochloric acid electrolytic treatment may use a sine wave, a square wave, a trapezoidal wave, a triangular wave, or the like. A frequency thereof is preferably 0.1 to 250 Hz.

Fig. 6 is a graph showing an example of an alternating waveform current waveform diagram used for the hydrochloric acid electrolytic treatment.

In Fig. 6, ta represents an anodic reaction time, tc represents a cathodic reaction time, tp represents a time taken for the current to reach the peak from 0, Ia represents the peak current on an anode cycle side, and Ic represents the peak current on a cathode cycle side. In the trapezoidal wave, the time tp taken for the current to reach the peak from 0 is preferably 1 to 10 msec.

As conditions for one cycle of alternating current used for the hydrochloric acid electrolytic treatment, it is preferable that a ratio tc/ta of the anodic reaction time ta to the cathodic reaction time tc of the aluminum alloy plate is in a range of 1 to 20, a ratio Qc/Qa of an electric quantity Qc at the anode to an electric quantity Qa at the anode of the aluminum alloy plate is in a range of 0.3 to 20, and the anodic reaction time ta is in a range of 5 to 1,000 msec.

It is preferable that the peak current value is in the above-described range (80 $A/dm^2$ or less) in both the anode cycle side Ia and the cathode cycle side Ic of the current in terms of the peak value of the trapezoidal wave.

A device shown in Fig. 7 can be used for the hydrochloric acid electrolytic treatment using the alternating current.

Fig. 7 is a side view showing an example of a radial type cell used for the hydrochloric acid electrolytic treatment using the alternating current.

In Fig. 7, the reference numeral 50 represents a main electrolytic cell, the reference numeral 51 represents an AC power source, the reference numeral 52 represents a radial drum roller, the reference numerals 53a and 53b represent a main pole, the reference numeral 54 represents an electrolytic solution feed inlet, the reference numeral 55 represents an electrolytic solution, the reference numeral 56 represents a slit, the reference numeral 57 represents an electrolytic solution passage, the reference numeral 58 represents an auxiliary anode, the reference numeral 60 represents an auxiliary anode cell, and the reference numeral W represents an aluminum alloy plate. In a case where two or more electrolytic cells are used, the electrolysis conditions may be the same or different from each other.

The aluminum alloy plate W is wound around the radial drum roller 52 which is immersed in and disposed on the main electrolytic cell 50, and in the transport step, electrolysis is performed by the main poles 53a and 53b connected to the AC power source 51. The electrolytic solution 55 is supplied from the electrolytic solution feed inlet 54 to the electrolytic solution passage 57 between the radial drum roller 52 and the main poles 53a and 53b, through the slit 56. The aluminum alloy plate W treated in the main electrolytic cell 50 is then electrolyzed in the auxiliary anode cell 60. In the auxiliary anode cell 60, the auxiliary anode 58 is disposed to face the aluminum alloy plate W, and the electrolytic solution 55 is supplied so as to flow in the space between the auxiliary anode 58 and the aluminum alloy plate W.

(Alkali etching treatment)

It is preferable that the manufacturing method of the support includes an alkali etching treatment after the above-described mechanical roughening treatment in a case of performing the mechanical roughening treatment, or before and after the above-described hydrochloric acid electrolytic treatment step.

In addition, the alkali etching treatment performed before the hydrochloric acid electrolytic treatment is performed for the purpose of removing rolling oil, stains, natural oxide films, and the like on the surface of the aluminum alloy plate (rolled aluminum) in a case where the mechanical roughening treatment has not been performed, and for the purpose of dissolving edge portions of unevenness generated by the mechanical roughening treatment to change the surface with steep unevenness to a surface with smooth undulations in a case where the mechanical roughening treatment has been performed.

In a case where the mechanical roughening treatment is not performed before the alkali etching treatment, an etching amount is preferably 0.1 to 10 $g/m^2$ and more preferably 1 to 5 $g/m^2$. In a case where the etching amount is 1 to 10 $g/m^2$, rolling oil, stains, natural oxide films, and the like on the surface are sufficiently removed.

In a case where the mechanical roughening treatment is performed before the alkali etching treatment, the etching amount is preferably 3 to 20 $g/m^2$ and more preferably 5 to 15 $g/m^2$.

The alkali etching treatment performed immediately after the hydrochloric acid electrolytic treatment is performed for the purpose of dissolving smut generated in an acidic electrolytic solution and dissolving edge portions of unevenness formed by the hydrochloric acid electrolytic treatment. Since unevenness formed by the hydrochloric acid electrolytic treatment varies depending on the type of the electrolytic solution, the optimum etching amount also varies, but the etching amount of the alkali etching treatment performed after the hydrochloric acid electrolytic treatment is preferably 0 to 0.5 $g/m^2$ and more preferably 0 to 0.3 $g/m^2$.

Examples of the alkali used in an alkaline solution include caustic alkali and an alkali metal salt. In particular, an aqueous solution of caustic soda is preferable.

A concentration of the alkaline solution can be determined depending on the etching amount, but is preferably 1% to 50% by mass and more preferably 10% to 35% by mass. In a case where aluminum ions are dissolved in the alkaline solution, a concentration of the aluminum ions is preferably 0.01% to 10% by mass and more preferably 3% to 8% by mass. A temperature of the alkaline solution is preferably 20°C to 90°C. A treatment time is preferably 0 to 120 seconds.
Examples of a method of bringing the aluminum alloy plate into contact with the alkaline solution include a method of passing the aluminum alloy plate through a tank containing the alkaline solution, a method of immersing the aluminum alloy plate in a tank containing the alkaline solution, and a method of spraying the alkaline solution onto a surface of the aluminum alloy plate.

(Desmutting treatment)

In the manufacturing method of the support, it is preferable that, after performing the hydrochloric acid electrolytic treatment or the alkali etching treatment, pickling (desmutting treatment) is performed to remove corrosive organisms remaining on the surface.
As an acid used for the desmutting treatment, for example, nitric acid, sulfuric acid, hydrochloric acid, and the like are generally used, but other acids may be used.
The above-described desmutting treatment is performed, for example, by bringing the above-described aluminum alloy plate into contact with an acidic solution (containing 0.01% to 5% by mass of aluminum ions) in which a concentration of hydrochloric acid, nitric acid, sulfuric acid, or the like is 0.5% to 30% by mass.
Examples of a method of bringing the aluminum alloy plate into contact with the acidic solution include a method of passing the aluminum alloy plate through a tank containing the acidic solution, a method of immersing the aluminum alloy plate in a tank containing the acidic solution, and a method of spraying the acidic solution onto a surface of the aluminum alloy plate.
Since a surface state of the aluminum alloy plate after the desmutting treatment affects the subsequent growth of the natural oxide film, the selection and concentration of the acid, and the temperature conditions are appropriately selected according to the purpose.

(Water washing treatment)

In the manufacturing method of the support, it is preferable to perform water washing after the completion of each of the above-described steps. In particular, water washing at the end of the step affects the subsequent growth of the natural oxide film, and thus water washing is required to be sufficiently performed using pure water, well water, tap water, or the like.

(Anodization treatment step (surface layer anodization treatment step))

The anodization treatment step is a step of, after the above-described hydrochloric acid electrolytic treatment step, subjecting the roughened aluminum alloy plate to an anodization treatment to form an anodic oxide film of aluminum on the aluminum alloy plate.
The anodization treatment step may be performed only once or may be performed a plurality of times.
A procedure of the anodization treatment step is not particularly limited, and examples thereof include known methods.
In the anodization treatment step, an aqueous solution of sulfuric acid, phosphoric acid, oxalic acid, and the like can be used as an electrolytic bath. For example, a concentration of sulfuric acid may be 100 to 300 g/L.
Conditions for the anodization treatment are appropriately set depending on the electrolytic solution, and examples thereof include a solution temperature of 5°C to 70°C (preferably 10°C to 60°C), a current density of 0.5 to 60 A/dm$^2$ (preferably 5 to 60 A/dm$^2$), a voltage of 1 to 100 V (preferably 5 to 50 V), an electrolysis time of 1 to 100 seconds (preferably 5 to 60 seconds), and a coating amount of 0.1 to 5 g/m$^2$ (preferably 0.2 to 3 g/m$^2$).
In the manufacturing method of the support, from the viewpoint of further improving adhesiveness between the support and the image-recording layer, an aqueous solution containing sulfuric acid or phosphoric acid is preferable as an electrolytic bath used in the anodization treatment step.

(Pore widening treatment step)

The pore widening treatment step is a treatment (pore diameter expanding treatment) step of, after the above-described anodization treatment step, performing an etching treatment on the aluminum alloy plate on which the anodized film has been formed to expand the diameter of the micropore in the anodic oxide film.
The pore widening treatment can be performed by bringing the aluminum alloy plate obtained by the above-described anodization treatment step into contact with an acid aqueous solution or an alkaline aqueous solution. The contact method is not particularly limited, and examples thereof include a dipping method and a spraying method.

(Underlayer anodization treatment step (second anodization treatment step))

In the manufacturing method of the support, after the above-described surface layer anodization treatment and pore widening treatment, an underlayer anodization treatment step of further performing an anodization treatment to form an anodic oxide film of aluminum on the aluminum alloy plate may be performed.
A procedure of the underlayer anodization treatment step is not particularly limited, and examples thereof include known methods.
In the underlayer anodization treatment step, an aqueous solution of sulfuric acid, phosphoric acid, oxalic acid, and the like can be used as an electrolytic bath. For example, a concentration of sulfuric acid may be 100 to 300 g/L.
Conditions for the underlayer anodization treatment are appropriately set depending on the electrolytic solution, and examples thereof include a solution temperature of 5°C to 70°C (preferably 10°C to 60°C), a current density of 0.5 to 60 $A/dm^2$ (preferably 5 to 60 $A/dm^2$), a voltage of 1 to 100 V (preferably 5 to 50 V), an electrolysis time of 1 to 100 seconds (preferably 5 to 60 seconds), and a coating amount of 0.1 to 5 $g/m^2$ (preferably 0.2 to 3 $g/m^2$).
As an electrolytic bath used in the underlayer anodization treatment step, an aqueous solution containing sulfuric acid or phosphoric acid is preferable, and an aqueous solution containing sulfuric acid is more preferable.

(Interlayer anodization treatment step)

In the manufacturing method of the support, after the above-described surface layer anodization treatment and pore widening treatment and before the above-described underlayer anodization treatment, a step (interlayer anodization treatment step) of performing an anodization treatment with a phosphoric acid solution to form, between the upper layer anodic oxide film and the lower layer anodic oxide film, an anodic oxide film having a pore diameter larger than that of the upper layer may be performed.
A procedure of the interlayer anodization treatment step is not particularly limited, and examples thereof include known methods.
In the interlayer anodization treatment step, a phosphoric acid aqueous solution can be used as an electrolytic bath. For example, a concentration of phosphoric acid in the phosphoric acid aqueous solution is 10 to 300 g/L.
Conditions for the interlayer anodization treatment are appropriately set depending on the electrolytic solution, and examples thereof include a solution temperature of 5°C to 70°C (preferably 10°C to 60°C), a current density of 0.5 to 60 $A/dm^2$ (preferably 5 to 60 $A/dm^2$), a voltage of 1 to 100 V (preferably 5 to 50 V), an electrolysis time of 1 to 100 seconds (preferably 5 to 60 seconds), and a coating amount of 0.1 to 5 $g/m^2$ (preferably 0.2 to 3 $g/m^2$).
As the electrolytic bath used for the interlayer anodization treatment, an aqueous solution containing phosphoric acid is preferable.
The manufacturing method of the support may include a hydrophilization treatment step of subjecting the aluminum alloy plate which has been subjected to the above-described anodization treatment and pore widening treatment step to a hydrophilization treatment. As the hydrophilization treatment, methods described in paragraphs 0109 to 0114 of JP2005-254638A can be adopted.
As the hydrophilization treatment, a method of immersing the aluminum alloy plate in an aqueous solution of an alkali metal silicate such as sodium silicate and potassium silicate, or a method of applying a hydrophilic vinyl polymer or a hydrophilic compound to form a hydrophilic undercoat layer is preferable.
The hydrophilization treatment using an aqueous solution of an alkali metal silicate such as sodium silicate and potassium silicate can be performed according to a method and procedure described in US2714066A and US3181461A.

[Image-recording layer]

The planographic printing plate precursor according to the embodiment of the present invention includes an image-recording layer containing at least an infrared absorber and an acid color-forming agent.
The image-recording layer is preferably an image-recording layer which can be removed by at least one of printing ink or dampening water.
In addition, the image-recording layer is preferably a negative tone image-recording layer and more preferably a water-soluble or water-dispersible negative tone image-recording layer.
Hereinafter, each component contained in the image-recording layer will be described.

<Infrared absorber>

The image-recording layer contains an infrared absorber.

The infrared absorber is not particularly limited, and examples thereof include pigments and dyes.

As the dye used as the infrared absorber, it is possible to use a commercially available dye and a known dye described in publications of "Dye Handbooks" (edited by the Society of Synthetic Organic Chemistry, Japan, published in 1970) and the like. Specific examples thereof include dyes such as an azo dye, a metal complex salt azo dye, a pyrazolone azo dye, a naphthoquinone dye, an anthraquinone dye, a phthalocyanine dye, a carbonium dye, a quinoneimine dye, a methine dye, a cyanine dye, a squarylium coloring agent, a pyrylium salt, and a metal thiolate complex.

Among these dyes, a cyanine coloring agent, a squarylium coloring agent, a pyrylium salt, a nickel thiolate complex, or an indolenine cyanine coloring agent is preferable, a cyanine coloring agent or an indolenine cyanine coloring agent are more preferable, and a cyanine coloring agent is still more preferable.

In addition, the infrared absorber is preferably a cationic polymethine coloring agent having an oxygen atom or a nitrogen atom at a meso-position. Preferred examples of the cationic polymethine coloring agent include a cyanine coloring agent, a pyrylium coloring agent, a thiopyrylium coloring agent, and an azulenium coloring agent; and from the viewpoint of ease of availability, solubility in a solvent during an introduction reaction, and the like, a cyanine coloring agent is preferable.

Specific examples of the cyanine coloring agent include compounds described in paragraphs 0017 to 0019 of JP2001-133969A, compounds described in paragraphs 0016 to 0021 of JP2002-023360A, compounds described in paragraphs 0012 to 0037 of JP2002-040638A, compounds described in paragraphs 0034 to 0041 of JP2002-278057A, compounds described in paragraphs 0080 to 0086 of JP2008-195018A, compounds described in paragraphs 0035 to 0043 of JP2007-090850A, and compounds described in paragraphs 0105 to 0113 of JP2012-206495A.

In addition, compounds described in paragraphs 0008 and 0009 of JP1993-005005A (JP-H5-005005A) and paragraphs 0022 to 0025 of JP2001-222101A can be also preferably used.

As the pigment, a compound described in paragraphs 0072 to 0076 of JP2008-195018A is preferable.

In addition, the infrared absorber preferably includes an infrared absorber which is decomposed by exposure to infrared rays (decomposition-type infrared absorber), and more preferably includes a decomposition color-forming infrared absorber.

It is presumed that, by using a decomposition-type infrared absorber as the infrared absorber, polymerization is promoted by the decomposition-type infrared absorber or a decomposition product thereof, and a decomposition product of the decomposition-type infrared absorber and the polymerizable compound interact with each other, thereby improving the printing durability.

The decomposition-type infrared absorber preferably has a function of absorbing infrared rays upon exposure to infrared rays, decomposing, and forming color. Hereinafter, a compound which forms color by the decomposition of the decomposition-type infrared absorber by absorbing infrared rays upon exposure to infrared rays will also be referred to as "color forming substance of the decomposition-type infrared absorber".

In addition, it is preferable that the decomposition-type infrared absorber preferably has a function of absorbing infrared rays upon exposure to infrared rays and converting the absorbed infrared rays into heat.

It is sufficient that the decomposition-type infrared absorber absorbs at least a part of light in an infrared wavelength range (wavelength of 750 nm to 1 mm) to be decomposed; and an infrared absorber having a maximal absorption wavelength in a wavelength range of 750 to 1,400 nm is preferable, and an infrared absorber having a maximal absorption wavelength in a wavelength range of 760 to 900 nm is more preferable.

In addition, the decomposition-type infrared absorber is preferably a compound which is decomposed due to exposure to infrared rays to generate a compound having a maximal absorption wavelength in a wavelength range of 500 to 600 nm.

As the decomposition-type infrared absorber, an infrared absorber which is decomposed by heat, electron migration, or both due to exposure to infrared rays is preferable, and an infrared absorber which is decomposed by electron migration due to exposure to infrared rays is more preferable. Here, the "decomposed by electron migration" means that an electron excited to the lowest unoccupied molecular orbital (LUMO) from the highest occupied molecular orbital (HOMO) of the decomposition-type infrared absorber by exposure to infrared rays intramolecularly moves to an electron accepting group (group having potential close to LUMO) in the molecule, thereby causing decomposition.

As the infrared absorber and the infrared absorber which is decomposed by exposure to infrared rays, compounds described in WO2020/262692A can be suitably used.

As the infrared absorber which is decomposed by exposure to infrared rays, compounds described in JP2008-544322A or WO2016/027886A can be suitably used.

As the cyanine coloring agent which is the decomposition-type infrared absorber, infrared absorbing compounds described in WO2019/219560A can be suitably used.

Among these, as the decomposition-type infrared absorber, a compound (cyanine coloring agent) represented

by Formula (A) is preferable.

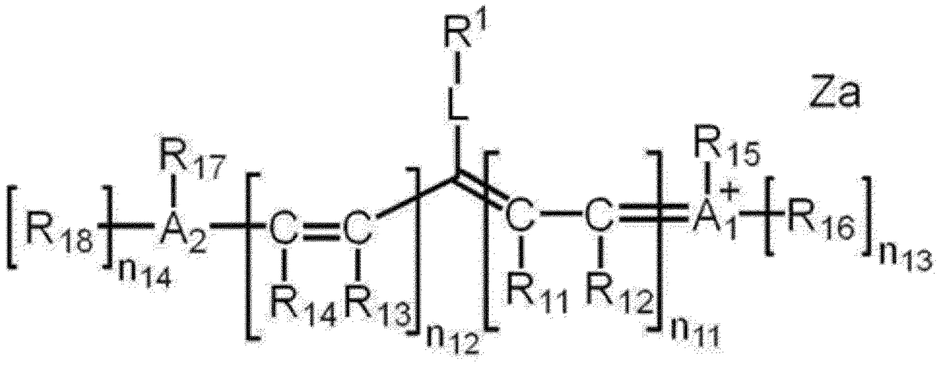

(A)

In the formula, $R^1$ represents a group having an $R^1$-L bond which is cleaved by exposure to infrared rays,

$R_{11}$ to $R_{18}$ each independently represent a hydrogen atom, a halogen atom, -Ra, -ORb, -SRc, or -NRdRe,
Ra to Re each independently represent a hydrocarbon group,
$A_1$, $A_2$, and a plurality of $R_{11}$'s to $R_{18}$'s may be linked to each other to form a monocycle or a polycycle,
$A_1$ and $A_2$ each independently represent an oxygen atom, a sulfur atom, or a nitrogen atom,
$n_{11}$ and $n_{12}$ each independently represent an integer of 0 to 5, where a total of $n_{11}$ and $n_{12}$ is 2 or more,
$n_{13}$ and $n_{14}$ each independently represent 0 or 1,
L represents an oxygen atom, a sulfur atom, or $-NR_{10}-$,
$R_{10}$ represents a hydrogen atom, an alkyl group, or an aryl group, and
Za represents a counter ion which neutralizes an electric charge.

Examples of the compound represented by Formula (A) include compounds IR-6 to IR-9 described later.

From the viewpoint of printing durability and halftone dot reproducibility, the highest occupied molecular orbital (HOMO) value of the infrared absorber is preferably -5.00 eV or less, and more preferably -5.30 eV or less. From the viewpoint of printing durability and halftone dot reproducibility, the lower limit value thereof is preferably -5.90 eV or more, more preferably -5.75 eV or more, and still more preferably -5.60 eV or more.

In the present specification, the energy of molecular orbital (MO) such as the highest occupied molecular orbital (HOMO) and the lowest unoccupied molecular orbital (LUMO) is calculated by the following method.

First, free counter ions in a compound as a calculation object are excluded from the calculation object. For example, in the case of a cationic infrared absorber, a cationic polymerization initiator, and the like, counter anions are excluded from the calculation target; and in the case of an anionic infrared absorber, an anionic polymerization initiator, and the like, counter cations are excluded from the calculation target. The "free" mentioned herein means that the compound as an object and the counter ions thereof are not covalently linked to each other.

The structural optimization is carried out by DFT (B3LYP/6-31G(d)) using quantum chemical calculation software Gaussian 16.

The MO energy is calculated by DFT (B3LYP/6-31+G(d,p)/PCM (solvent = methanol)) with the optimum structure obtained by the structural optimization, using quantum chemical calculation software Gaussian 16. For a compound containing iodine, the MO energy is calculated under the condition of DFT (B3LYP/DGDZVP/PCM (solvent = methanol)).

The optimum structure mentioned herein means a structure in which the total energy obtained by the DFT calculation is the most stable. The most stable structure is found by repeating the structural optimization as necessary.

By the following formulae, the MO energy Ebare (unit: hartree) obtained by the above-described MO energy calculation is converted into Escaled (unit: eV) used as the HOMO value and the LUMO value.

$$\text{[Calculation formula for HOMO] Escaled} = 0.823168 \times 27.2114 \times \text{Ebare} - 1.07634$$

$$\text{[Calculation formula for LUMO] Escaled} = 0.820139 \times 27.2114 \times \text{Ebare} - 1.086039$$

27.2114 is a coefficient for simply converting hartree into eV, and 0.823168 and -1.07634 used for calculating HOMO and 0.820139 and -1.086039 used for calculating LUMO are adjustment coefficients. These values are determined such that the calculated values of HOMO and LUMO of the compound as a calculation object match the measured values.

The infrared absorber may be used alone or in combination of two or more kinds thereof. In addition, as the infrared absorber, the pigment and the dye may be used in combination.

A content of the infrared absorber in the image-recording layer is preferably 0.1% by mass to 10.0% by mass and more preferably 0.5% by mass to 5.0% by mass with respect to the total mass of the image-recording layer.

<Acid color-forming agent>

The image-recording layer contains an acid color-forming agent.

In the present specification, the "acid color-forming agent" means a compound which forms color by an electron-accepting compound such as an acid and has a property of changing the color of the image-recording layer.

In addition, in the present specification, "color formability" means a degree of color development of the acid color-forming agent caused by an electron-accepting compound such as an acid, unless otherwise specified.

In the acid color-forming agent contained in the image-recording layer of the planographic printing plate precursor according to the embodiment of the present invention, the color-forming factor of the acid color-forming agent, which is determined by the following measurement X, is 20,000 or more.

Measurement X: in a case where a solution obtained by mixing 1 mL of a first acetonitrile solution in which a concentration of the acid color-forming agent is 0.02 mmol/L, 1 mL of a second acetonitrile solution in which a concentration of 10-camphorsulfonic acid is 0.02 mmol/L, 5 mL of water, and 93 mL of acetonitrile is used for measuring a ultraviolet-visible absorption spectrum with a measurement cell having an optical path width of 10 mm to obtain an absorbance at an absorption maximal wavelength, which is denoted by Amax, a value determined by the following expression (1) is defined as the color-forming factor.

$$\text{Color-forming factor } (L \cdot mol^{-1} \cdot cm^{-1}) = Amax/\{(0.0002\ mmol/L) \times (1\ cm)\} \qquad \text{Expression (1)}$$

A more specific method of the above-described measurement X is as follows.

-Preparation of coloring agent solution X1-

0.1 mmol of the acid color-forming agent is accurately weighed and charged into a 50 mL volumetric flask.

Approximately 40 mL of acetonitrile is added to the volumetric flask, it is visually confirmed that the acid color-forming agent is completely dissolved, and then the solution is diluted to 50 mL with acetonitrile to obtain a coloring agent solution X1.

-Preparation of acid solution X2-

0.2 mmol of 10-camphorsulfonic acid (CSA) is charged into a 100 mL volumetric flask, and then approximately 80 mL of acetonitrile is added thereto. After confirming that the CSA is completely dissolved, the solution is diluted with 100 mL of acetonitrile to obtain an acid solution D.

-Preparation of measurement solution X3-

5 mL of deionized water is charged into a 100 mL volumetric flask using a transfer pipette, and 80 mL of acetonitrile is added thereto. Next, 1 mL of the coloring agent solution X1 and 1 mL of the acid solution X2 are added to the volumetric flask, and the solution is diluted with acetonitrile up to 100 mL to obtain a measurement solution X3.

A concentration of the acid color-forming agent, including the color forming substance generated in the measurement solution X3, is 0.02 mmol/L.

A measurement cell (quartz glass, optical path width: 10 mm) is filled with the measurement solution X3, and measurement is performed using an ultraviolet-visible spectrophotometer (for example, "UV-1800" manufactured by Shimadzu Corporation).

As a blank, a solution of water: acetonitrile = 5:95 is used.

An absorption maximal wavelength $\lambda$max in a visible light region (380 to 750 nm) is read from the obtained spectrum, an absorbance at the wavelength is defined as Amax, and the absorbance is substituted to the above expression (1) to calculate the emission coefficient of the acid color-forming agent.

From the viewpoint of more excellent visibility, the color-forming factor of the acid color-forming agent contained in the image-recording layer is preferably 20,000 or more, more preferably 35,000 or more, and still more preferably 50,000 or more.

In addition, from the viewpoint of more excellent suppressing property of the color-forming defect over time, the

color-forming factor of the acid color-forming agent contained in the image-recording layer is preferably 100,000 or less, more preferably 80,000 or less, and still more preferably 70,000 or less.

The acid color-forming agent is preferably a compound which forms color by being heated in a state of receiving an electron-accepting compound such as an acid.

Examples of the above-described acid include a protonic acid and a Lewis acid. In addition, a heating temperature during the heating is preferably 80°C to 200°C and more preferably 100°C to 180°C.

The acid color-forming agent is preferably a colorless compound having a mother nucleus structure and a decomposable group bonded to the mother nucleus structure, in which the decomposable group is rapidly ring-opened or cleaved in a case of being in contact with the electron-accepting compound. Among these, from the viewpoint of more excellent color formability, the acid color-forming agent more preferably has a structure which is ring-opened by decomposition of a decomposable group in a case of being in contact with the electron-accepting compound. The ring opening of the decomposable group means that a ring structure of the decomposable group is opened by decomposition, and the cleavage of the decomposable group means that a leaving group which is a part of the decomposable group is eliminated by decomposition.

Examples of the above-described decomposable group include a group having a partial structure selected from the group consisting of a lactone, a lactam, a sultone, a spiropyran, an ester, and an amide.

The number of decomposable groups in the acid color-forming agent is not particularly limited, but from the viewpoint of color formability, it is preferably 1 to 4, more preferably 1 or 2, and still more preferably 1.

From the viewpoint of color formability and fading resistance over time, the acid color-forming agent preferably has, as the decomposable group, at least one group represented by Formula (1a) to Formula (1d), more preferably has at least one group represented by Formula (1a) to Formula (1c), and still more preferably has a group represented by Formula (1a).

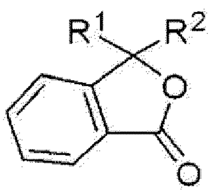
(1a)

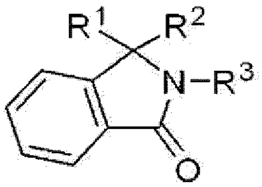
(1b)

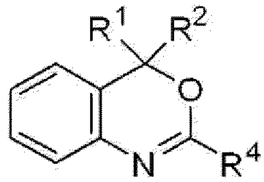
(1c)

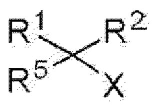
(1d)

In Formulae (1a) to (1d), $R^1$ and $R^2$ each represent a moiety linked to the above-described mother nucleus structure.

In Formula (1b), $R^3$ represents an aryl group or a heteroaryl group.

In Formula (1c), $R^4$ represents an aryl group or a heteroaryl group.

In Formula (1d), $R^5$ represents a hydrocarbon group and X represents a leaving group.

From the viewpoint of color formability, $R^3$ and $R^4$ are each preferably an aryl group having 6 to 12 carbon atoms or a heteroaryl group having 6 to 12 ring members, more preferably an aryl group having 6 to 12 carbon atoms, and still more preferably a phenyl group.

From the viewpoint of color formability, $R^5$ is preferably an alkyl group or an aryl group, more preferably an aryl group, still more preferably an aryl group having 6 to 12 carbon atoms, and particularly preferably a phenyl group.

X is not particularly limited as long as it is a group which can be eliminated by decomposition of the above-described decomposable group, but is preferably an acyloxy group, more preferably an acyloxy group having 1 to 8 carbon atoms, and still more preferably an acetyloxy group.

From the viewpoint of color formability, the specific coloring agent compound preferably has, as the mother nucleus structure, any of structures represented by Formulae (2a) to (2f), and more preferably has a structure represented by Formula (2a).

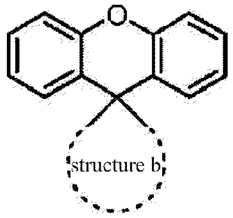

(2a)

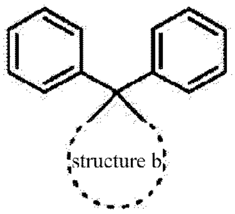

(2b)

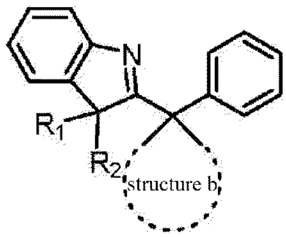

(2c)

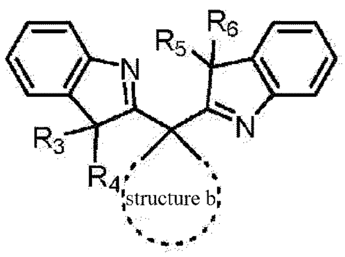

(2d)

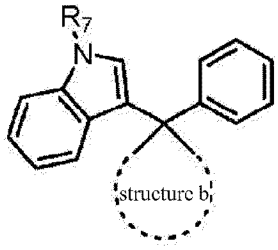

(2e)

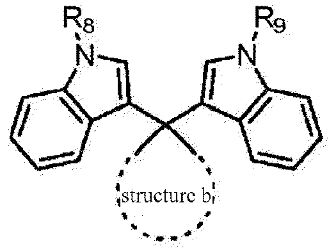

(2f)

In Formulae (2a) to (2f), a structure b represents a structure which is ring-opened or cleaved in a case of being in contact with an electron-accepting compound.

In Formulae (2c) to (2f), $R_1$ to $R_9$ each independently represent a hydrogen atom, an alkyl group, or an alkoxy group.

From the viewpoint of color formability and fading resistance over time, the structure b is preferably any of the groups represented by Formulae (1a) to (1d), more preferably any of the groups represented by Formulae (1a) to (1c), and still more preferably the group represented by Formula (1a).

The number of carbon atoms in the alkyl group or the alkoxy group represented by $R^1$ to $R^9$ is preferably 1 to 15 and more preferably 1 to 10. From the viewpoint of color formability and visibility, $R^1$ to $R^9$ are each independently preferably a hydrogen atom or an alkyl group, more preferably an alkyl group, and still more preferably a methyl group.

The structures represented by Formulae (2a) to (2f) may further have a substituent on an aromatic ring or a heterocyclic ring, in addition to $R_1$ to $R_9$.

Examples of the above-described substituent include an alkyl group, an aryl group, an alkoxy group, an aryloxy group, a dialkylamino group, a diarylamino group, an alkylarylamino group, an arylamino group, and an alkylamino group. Among these, from the viewpoint of color formability and fading resistance over time, it is preferable to have at least one dialkylamino group.

From the viewpoint of color formability and visibility, the acid color-forming agent preferably includes a leuco coloring agent, and it is more preferably a leuco coloring agent.

In addition, from the viewpoint of color formability and visibility, the above-described leuco coloring agent is preferably a leuco coloring agent having a phthalide structure or a fluoran structure.

From the viewpoint of developability after a lapse of time, color formability, and visibility, the acid color-forming agent is preferably a compound represented by Formula (3a) or Formula (3b), and more preferably a compound represented by Formula (3a).

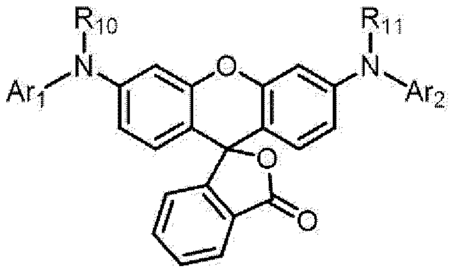

( 3a )

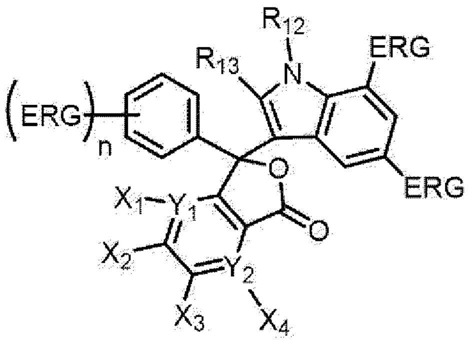

( 3b )

In Formula (3a),

$Ar_1$ and $Ar_2$ each independently represent an aryl group which may have a substituent or a heteroaryl group which may have a substituent, and

$R_{10}$ and $R_{11}$ each independently represent a hydrogen atom, an alkyl group, an aryl group which may have a substituent, or a heteroaryl group which may have a substituent.

In Formula (3b),

ERG's each independently represent an electron-donating group,

n represents an integer of 1 to 5,

$X_1$ to $X_4$ each independently represent a hydrogen atom, a halogen atom, or a monovalent organic group,

$Y_1$ and $Y_2$ each independently represent C or N,

$X_1$ does not exist in a case where $Y_1$ is N,

$X_4$ does not exist in a case where $Y_2$ is N, and

$R_{12}$ and $R_{13}$ each independently represent a hydrogen atom, an alkyl group, an aryl group which may have a substituent, or a heteroaryl group which may have a substituent.

The alkyl group in Formula (3a) or Formula (3b) may be linear or branched, or may have a ring structure. The number of carbon atoms in the alkyl group in Formula (3a) or Formula (3b) is preferably 1 to 20, more preferably 1 to 8, still more preferably 1 to 4, and particularly preferably 1 or 2.

The number of carbon atoms in the aryl group in Formula (3a) or Formula (3b) is preferably 6 to 20, more preferably 6 to 10, and still more preferably 6 to 8. Examples of the aryl group in Formula (3a) or Formula (3b) include a phenyl group, a naphthyl group, an anthracenyl group, and a phenanthrenyl group, each of which may have a substituent.

Examples of the heteroaryl group in Formula (3a) or Formula (3b) include a furyl group, a pyridyl group, a pyrimidyl group, a pyrazoyl group, and a thiophenyl group, each of which may have a substituent.

In addition, each group such as the alkyl group, the aryl group, and the heteroaryl group in Formula (3a) or Formula (3b) may have a substituent. Examples of the substituent include an alkyl group, an aryl group, a heteroaryl group, a halogen atom, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, and a cyano group. In addition, these substituents may be further substituted with these substituents.

The above-described substituent may be an electron-donating group.

From the viewpoint of color formability and visibility, as the electron-donating group represented by ERG and the electron-donating group which is the above-described substituent, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group is preferable; an alkoxy group, an aryloxy group, a heteroaryloxy group, or an alkyl group is more preferable; and an alkoxy group is still more preferable.

From the viewpoint of color formability and visibility, $R_{10}$ and $R_{11}$ in Formula (3a) each independently preferably represent an alkyl group or an aryl group which may have an electron-donating group, more preferably represent a methyl group or an aryl group having an electron-donating group, and still more preferably represent a phenyl group having an electron-donating group at a para-position.

From the viewpoint of color formability and visibility, $Ar_1$ and $Ar_2$ in Formula (3a) each independently preferably represent an aryl group which may have at least one substituent at an ortho-position or a heteroaryl group which may have at least one substituent at an ortho-position, more preferably represent an aryl group which has at least one substituent at an ortho-position, still more preferably represent a phenyl group which has at least one substituent at an ortho-position, and particularly preferably represent a phenyl group which has at least one substituent at an ortho-position and an electron-donating group at a para-position.

From the viewpoint of color formability and visibility, $R_{12}$ and $R_{13}$ in Formula (3b) are preferably a hydrogen atom, an alkyl group, or an aryl group substituted with an alkoxy group, more preferably an alkyl group, and still more preferably a methyl group.

n in Formula (3b) is preferably an integer of 1 to 3 and more preferably 1 or 2.

From the viewpoint of color formability and visibility, $X_1$ to $X_4$ in Formula (3b) each independently preferably represent a hydrogen atom or a chlorine atom, and more preferably represent a hydrogen atom.

From the viewpoint of color formability and visibility, in Formula (3b), it is preferable that at least one of $Y_1$ or $Y_2$ is C, and it is more preferable that both $Y_1$ and $Y_2$ are C.

Preferred specific Examples of the acid color-forming agent include the following compounds S-1 to S-20. Me represents a methyl group, Et represents an ethyl group, and Ph represents a phenyl group.

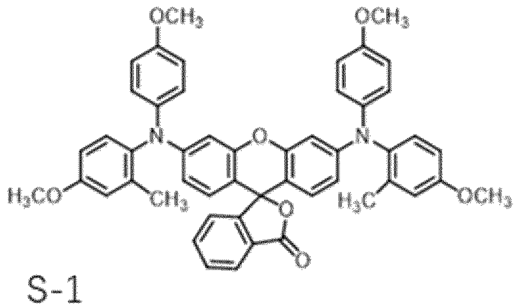

S-1

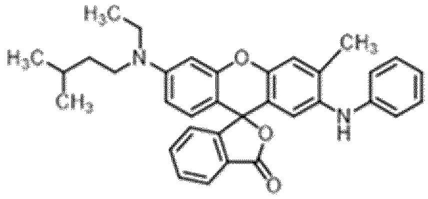

S-2

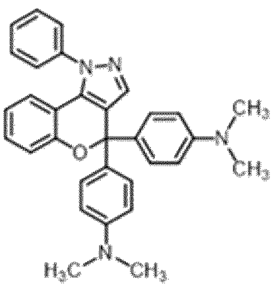

S-3

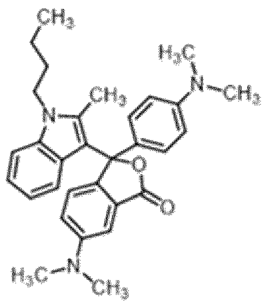

S-4

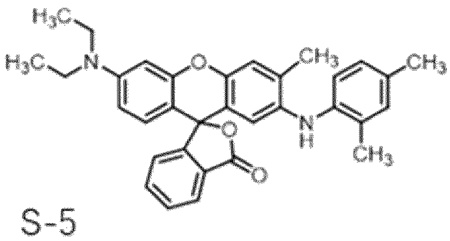

S-5

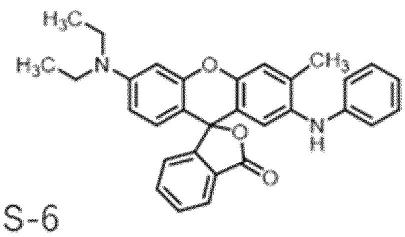

S-6

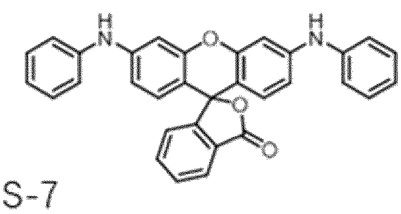

S-7

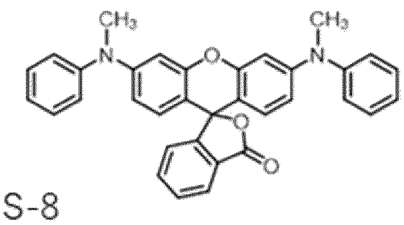

S-8

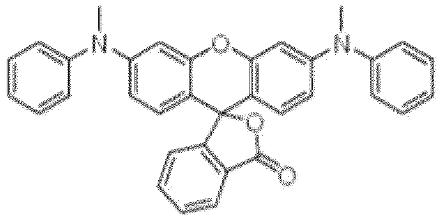

S-9

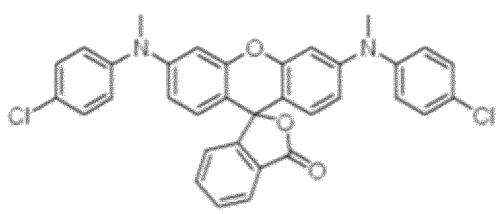

S-10

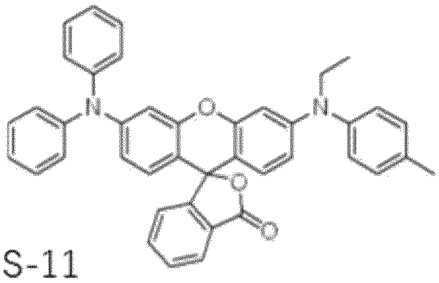

S-11

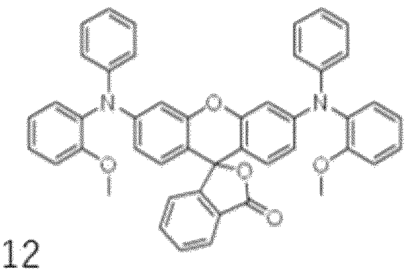

S-12

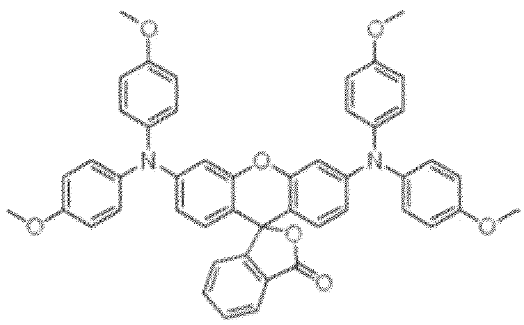

S-13

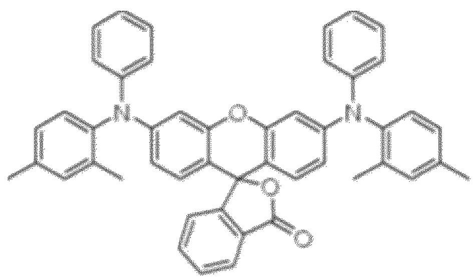

S-14

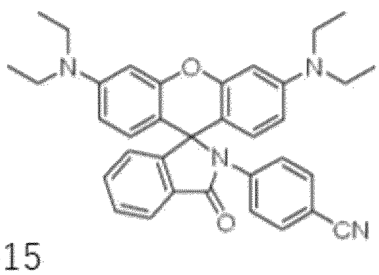

S-15

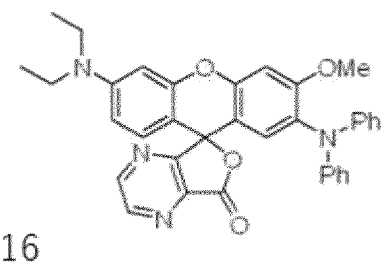

S-16

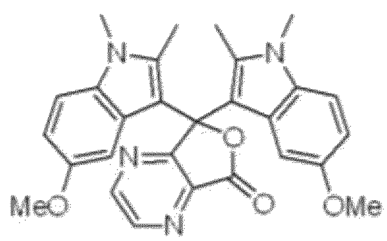

S-17

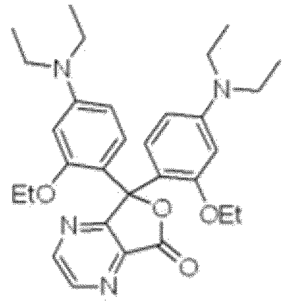

S-18

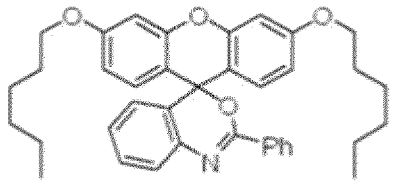

S-19

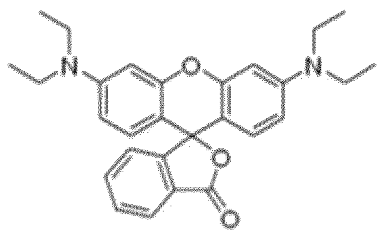

S-20

In addition, from the viewpoint of visibility, the maximum absorption wavelength λmax of the color forming substance generated from the acid color-forming agent in the visible light region (380 to 750 nm) described above is preferably present in a range of 500 to 650 nm, more preferably present in a range of 520 to 600 nm, still more preferably present in a range of 530 to 580 nm, and particularly preferably present in a range of 540 to 570 nm.

These acid color-forming agents may be used alone or in combination of two or more kinds thereof.

A content of the acid color-forming agent is preferably 0.5% to 10% by mass and more preferably 1% to 5% by mass with respect to the total mass of the image-recording layer.

<Polymerization initiator>

The image-recording layer preferably contains a polymerization initiator.

The polymerization initiator is a compound which generates a polymerization initiation species such as a radical or a cation by light, heat, or energy of both light and heat. As the polymerization initiator, a compound (so-called radical polymerization initiator) which generates a radical by light, heat, or energy of both light and heat, and initiates polymerization of a compound having a polymerizable unsaturated group is preferable.

**In** addition, Examples of the polymerization initiator include an electron-accepting polymerization initiator and an electron-donating polymerization initiator.

The image-recording layer preferably contains, as the polymerization initiator, at least one of an electron-accepting polymerization initiator or an electron-donating polymerization initiator, and more preferably contains both the electron-accepting polymerization initiator and the electron-donating polymerization initiator.

(Electron-accepting polymerization initiator)

The electron-accepting polymerization initiator is a compound which generates a polymerization initiation species such as a radical or a cation by light, heat, or energy of both light and heat. As the electron-accepting polymerization initiator, a known thermal polymerization initiator, a compound having a bond with a small bond dissociation energy, a photopolymerization initiator, or the like can be appropriately used.

As the electron-accepting polymerization initiator, a radical polymerization initiator is preferable.

Examples of the radical polymerization initiator include (a) an organic halide, (b) a carbonyl compound, (c) an azo compound, (d) an organic peroxide, (e) a metallocene compound, (f) an azido compound, (g) a hexaarylbiimidazole compound, (i) a disulfone compound, (j) an oxime ester compound, and (k) an onium salt compound.

Examples of the (a) organic halide include compounds described in paragraphs 0022 and 0023 of JP2008-195018A.

Examples of the (b) carbonyl compound include compounds described in paragraph 0024 of JP2008-195018A.

Examples of the (c) azo compound include azo compounds described in JP1996-108621A (JP-H8-108621A).

Examples of the (d) organic peroxide include compounds described in paragraph 0025 of JP2008-195018A.

Examples of the (e) metallocene compound include compounds described in paragraph 0026 of JP2008-195018A.

Examples of the (f) azido compound include a compound such as 2,6-bis(4-azidobenzylidene)-4-methylcyclohexanone.

Examples of the (g) hexaarylbiimidazole compound include compounds described in paragraph 0027 of JP2008-195018A.

Examples of the (i) disulfone compound include compounds described in JP1986-166544A (JP-S61-166544A) and JP2002-328465A.

Examples of the (j) onium salt compound include compounds described in paragraphs 0028 to 0030 of JP2008-195018A.

As the radical polymerization initiator, an onium-based polymerization initiator is preferable. The onium-based polymerization initiator is an onium salt compound which accepts an electron by intermolecular electron migration in a case

where an electron of an infrared absorber is excited by exposure to infrared rays, and generates a polymerization initiation species such as a radical.

As the onium-based polymerization initiator, from the viewpoint of more excellent printing durability, an iodonium salt compound, a sulfonium salt compound, or an azinium salt compound is preferable; an iodonium salt compound or a sulfonium salt compound is more preferable; and an iodonium salt compound is still more preferable.

As the iodonium salt compound, a diaryliodonium salt compound is preferable; a diphenyliodonium salt compound substituted with particularly an electron-donating group such as an alkyl group and an alkoxyl group is more preferable; and an asymmetric diphenyliodonium salt compound is still more preferable.

Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyliodonium=hexafluorophosphate, 4-hexyloxyphenyl-2,4-diethoxyphenyliodonium=tetrafluoroborate, 4-octyloxyphenyl-2,4,6-trimethoxyphenyliodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

As the sulfonium salt compound, a triarylsulfonium salt compound is preferable; a triarylsulfonium salt compound substituted with particularly an electron-withdrawing group such as a group in which at least a part of group on an aromatic ring is substituted with a halogen atom is more preferable; and a triarylsulfonium salt compound in which the total number of substituted halogen atoms on the aromatic ring is 4 or more is more preferable.

Specific examples thereof include triphenylsulfonium=hexafluorophosphate, triphenylsulfonium=benzoyl formate, bis(4-chlorophenyl)phenylsulfonium=benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

As a counter anion of the iodonium salt compound and the sulfonium salt compound, a sulfonamide anion or a sulfonimide anion is preferable, and a sulfonimide anion is more preferable.

As the sulfonamide anion, an arylsulfonamide anion is preferable.

As the sulfonimide anion, a bisarylsulfonimide anion is preferable.

Specific examples of the sulfonamide anion or the sulfonimide anion include compounds described in WO2020/262692A.

From the viewpoint of more excellent chemical resistance and printing durability, the lowest unoccupied molecular orbital (LUMO) of the electron-accepting polymerization initiator is preferably -3.00 eV or less, and more preferably -3.02 eV or less.

The lower limit thereof is preferably -3.80 eV or more, and more preferably -3.60 eV or more.

In a case where the image-recording layer contains an electron-accepting initiator, from the viewpoint of more excellent visibility and printing durability, a value obtained by subtracting LUMO of the infrared absorber from LUMO of the electron-accepting polymerization initiator (LUMO of electron-accepting polymerization initiator - LUMO of infrared absorber) is preferably 0.70 eV or less, more preferably 0.55 eV or less, and still more preferably 0.50 eV or less.

The lower limit thereof is not particularly limited, but is preferably 0.30 eV or more.

The electron-accepting polymerization initiator may be used alone, or two or more kinds thereof may be used in combination.

A content of the electron-accepting polymerization initiator is preferably 0.1% to 50% by mass, more preferably 0.5% to 30% by mass, and still more preferably 0.8% to 20% by mass with respect to the total mass of the image-recording layer.

(Electron-donating polymerization initiator)

From the viewpoint of more excellent chemical resistance and printing durability of the planographic printing plate, the polymerization initiator preferably includes an electron-donating polymerization initiator.

As the electron-donating polymerization initiator, for example, the following compounds are exemplified.

(i) Alkyl or arylate complex: it is considered that a carbon-hetero bond is oxidatively cleaved, and an active radical is generated; specific examples thereof include a borate salt compound.

(ii) Aminoacetic acid compound: it is considered that a C-X bond on carbon adjacent to a nitrogen is cleaved by oxidation, and an active radical is generated; as X, a hydrogen atom, a carboxy group, a trimethylsilyl group, or a benzyl group is preferable; specific examples thereof include N-phenylglycines (which may have a substituent in a phenyl group.) and N-phenyl iminodiacetic acids (which may have a substituent in a phenyl group).

(iii) Sulfur-containing compound: a compound in which a nitrogen atom in the above-described aminoacetic acid compound is replaced with a sulfur atom can generate an active radical by the same action; specific examples thereof include phenylthioacetic acid (which may have a substituent on a phenyl group).

(iv) Tin-containing compound: a compound in which a nitrogen atom in the above-described aminoacetic acid

compound is replaced with a tin atom can generate an active radical by the same action.
(v) Sulfinates: an active radical can be generated by oxidation; specific examples thereof include sodium aryl sulfinate.

As the electron-donating polymerization initiator, a borate salt compound is preferable.
As the borate salt compound, a tetraaryl borate salt compound or a monoalkyltriaryl borate salt compound is preferable, and from the viewpoint of stability of the compound, a tetraaryl borate salt compound is more preferable and a tetraphenyl borate salt compound is still more preferable.
A counter cation of the borate salt compound is not particularly limited, but an alkali metal ion or a tetraalkyl ammonium ion is preferable and a sodium ion, a potassium ion, or a tetrabutyl ammonium ion is more preferable.
As the borate salt compound, sodium tetraphenyl borate is preferable.
From the viewpoint of chemical resistance and printing durability, the highest occupied molecular orbital (HOMO) of the electron-donating polymerization initiator is preferably -6.00 eV or more, more preferably -5.95 eV or more, still more preferably -5.93 eV or more, and particularly preferably more than -5.90 eV.
The upper limit thereof is preferably -5.00 eV or less, and more preferably -5.40 eV or less.
Specific examples of the electron-donating polymerization initiator include electron-donating polymerization initiators described in WO2020/262692A.
From the viewpoint of visibility, printing durability, and temporal stability, the image-recording layer preferably contains at least one selected from the group consisting of an onium salt compound as the electron-accepting polymerization initiator and a borate salt compound as the electron-donating polymerization initiator; and more preferably contains both the onium salt compound as the electron-accepting polymerization initiator and the borate salt compound as the electron-donating polymerization initiator.
Examples of a preferred aspect in a case where the image-recording layer contains both the electron-accepting polymerization initiator and the electron-donating polymerization initiator include an aspect in which the electron-accepting polymerization initiator and the electron-donating polymerization initiator form a salt. Examples of the salt formed of the electron-accepting polymerization initiator and the electron-donating polymerization initiator include an iodonium borate compound formed of an iodonium compound which is the onium-based polymerization initiator, and a borate compound.
Specific examples of the iodonium borate compound include compounds described in WO2020/262692A.
The electron-donating polymerization initiator may be used alone, or two or more kinds thereof may be used in combination.
A content of the electron-donating polymerization initiator is preferably 0.01% to 30% by mass, more preferably 0.05% to 25% by mass, and still more preferably 0.1% to 20% by mass with respect to the total mass of the image-recording layer.
A content of the polymerization initiator (total content of the electron-accepting polymerization initiator and the electron-donating polymerization initiator) is preferably 0.1% to 50% by mass, more preferably 0.5% to 30% by mass, and still more preferably 0.8% to 20% by mass with respect to the total mass of the image-recording layer.
**In** addition, from the viewpoint of more excellent visibility, the content of the polymerization initiator (total content of the electron-accepting polymerization initiator and the electron-donating polymerization initiator) is preferably 0.5 molar equivalent or more, more preferably 1.0 molar equivalent or more, and still more preferably 3.0 molar equivalent or more with respect to the content of the acid color-forming agent. The upper limit thereof is not particularly limited, but is preferably 10.0 molar equivalent or less with respect to the content of the acid color-forming agent.

<Polymerizable compound>

It is preferable that the image-recording layer contains a polymerizable compound.
**In** the present specification, the polymerizable compound refers to a compound having a polymerizable group.
The polymerizable group is not particularly limited, and may be a radically polymerizable group or a cationically polymerizable group, but a radically polymerizable group is preferable.
Examples of the radically polymerizable group include groups having an ethylenically unsaturated group such as a (meth)acryloyl group, an allyl group, a vinylphenyl group, and a vinyl group; and from the viewpoint of reactivity, a (meth) acryloyl group is preferable.
A molecular weight of the polymerizable compound (in a case of having molecular weight distribution, a weight-average molecular weight) is preferably 50 or more and less than 2,500.
The polymerizable compound may be, for example, a radical polymerizable compound or a cationically polymerizable compound, and it is preferably an addition polymerizable compound (ethylenically unsaturated compound) having at least one ethylenically unsaturated bond.
The ethylenically unsaturated compound is preferably a compound having at least one ethylenically unsaturated bond at a terminal, and more preferably a compound having two or more ethylenically unsaturated bonds at a terminal. The

polymerizable compound has a chemical form such as a monomer, a pre-polymer, that is, a dimer, a trimer, or an oligomer, and a mixture of these.

**In** particular, from the viewpoint of printing durability, the polymerizable compound preferably includes a polymerizable compound having functionalities of 3 or more, more preferably includes a polymerizable compound having functionalities of 7 or more, and still more preferably includes a polymerizable compound having functionalities of 10 or more. In addition, from the viewpoint of printing durability of the planographic printing plate to be obtained, the above-described polymerizable compound preferably includes an ethylenically unsaturated compound having functionalities of 3 or more (preferably having functionalities of 7 or more and more preferably having functionalities of 10 or more), and more preferably includes a (meth)acrylate compound having functionalities of 3 or more (preferably having functionalities of 7 or more and more preferably having functionalities of 10 or more).

In addition, from the viewpoint of on-press developability and suppressing property of the color-forming defect over time, the above-described polymerizable compound preferably includes a polymerizable compound having functionalities of 2 or less, more preferably includes a difunctional polymerizable compound, and still more preferably includes a difunctional (meth)acrylate compound.

From the viewpoint of printing durability, on-press developability, and suppressing property of the color-forming defect over time, a content of the polymerizable compound having functionalities of 2 or less (preferably a bifunctional polymerizable compound) is preferably 5% to 100% by mass, more preferably 10% to 100% by mass, and still more preferably 15% to 100% by mass with respect to the total mass of the polymerizable compound in the above-described image-recording layer.

(Oligomer)

As the polymerizable compound contained in the image-recording layer, a polymerizable compound as an oligomer is preferable.

In the present specification, the oligomer represents a polymerizable compound having a molecular weight (in a case of having molecular weight distribution, a weight-average molecular weight) of 600 to 40,000 and at least one polymerizable group.

Hereinafter, the polymerizable compound as an oligomer, contained in the image-recording layer, is also simply referred to as "oligomer".

From the viewpoint of excellent chemical resistance and printing durability, the molecular weight of the oligomer is preferably 1,000 to 25,000.

In addition, from the viewpoint of improving printing durability, the number of polymerizable groups in one molecule of the oligomer is preferably 2 or more, more preferably 3 or more, still more preferably 6 or more, and particularly preferably 10 or more.

In addition, the upper limit value of the polymerizable groups in the oligomer is not particularly limited, but the number of polymerizable groups is preferably 20 or less.

From the viewpoint of printing durability and on-press developability, the oligomer is preferably a polymerizable compound having 7 or more polymerizable groups and having a molecular weight of 1,000 to 40,000, and more preferably a polymerizable compound having 7 to 20 polymerizable groups and having a molecular weight of 1,000 to 25,000.

The image-recording layer may contain a polymer component which may be generated in the process of producing the oligomer.

From the viewpoint of printing durability, visibility, and on-press developability, the oligomer preferably includes at least one selected from the group consisting of a compound having a urethane bond, a compound having an ester bond, and a compound having an epoxy residue, and preferably includes a compound having a urethane bond.

In the present specification, the epoxy residue refers to a structure formed of an epoxy group, and for example, the epoxy residue means a structure similar to a structure obtained by a reaction between an acid group (carboxylic acid group or the like) and an epoxy group.

As the compound having a urethane bond, compounds described in WO2020/262692A can be suitably used.

In addition, as the compound having a urethane bond, a compound which is prepared by obtaining polyurethane by a reaction between a polyisocyanate compound and a polyol compound and introducing a polymerizable group into the obtained polyurethane by a polymer reaction may also be used.

For example, the compound having a urethane bond may be obtained by reacting a polyol compound having an acid group with a polyisocyanate compound to obtain a polyurethane oligomer, and reacting the obtained polyurethane oligomer with a compound having an epoxy group and a polymerizable group.

The number of polymerizable groups in the compound having an ester bond, which is an example of the oligomer, is preferably 3 or more, and more preferably 6 or more. The upper limit value thereof is preferably 20 or less.

As the compound having an epoxy residue, which is an example of the oligomer, a compound containing a hydroxy group in the compound is preferable.

In addition, the number of polymerizable groups in the compound having an epoxy residue is preferably 2 to 6 and more preferably 2 or 3.

The above-described compound having an epoxy residue can be obtained, for example, by reacting a compound having an epoxy group with an acrylic acid.

As the oligomer, a commercially available product may also be used, and examples thereof include UA510H, UA-306H, UA-306I, and UA-306T (all manufactured by KYOEISHA CHEMICAL Co., Ltd.), UV-1700B, UV-6300B, and UV7620EA (all manufactured by The Nippon Synthetic Chemical Industry Co., Ltd.), U-15HA (manufactured by SHIN-NAKAMURA CHEMICAL Co., Ltd.), and EBECRYL450, EBECRYL657, EBECRYL885, EBECRYL800, EBECRYL3416, and EBECRYL860 (all manufactured by DAICEL-ALLNEX LTD.); but the oligomer is not limited to these.

From the viewpoint of improving chemical resistance, printing durability, and suppressing property of on-press developing residues, a content of the oligomer is preferably 30% to 100% by mass, more preferably 50% to 100% by mass, and still more preferably 80% to 100% by mass with respect to the total mass of the polymerizable compound in the image-recording layer.

(Low-molecular-weight polymerizable compound)

The polymerizable compound may further include a polymerizable compound other than the above-described oligomer.

From the viewpoint of chemical resistance, a low-molecular-weight polymerizable compound is preferable as the polymerizable compound other than the oligomer. The low-molecular-weight polymerizable compound may have a chemical form such as a monomer, a dimer, a trimer, and a mixture of these.

In addition, from the viewpoint of chemical resistance, the low-molecular-weight polymerizable compound is preferably at least one polymerizable compound selected from the group consisting of a polymerizable compound having three or more ethylenically unsaturated groups and a polymerizable compound having an isocyanuric ring structure.

In the present specification, the low-molecular-weight polymerizable compound refers to a polymerizable compound having a molecular weight (in a case of having molecular weight distribution, a weight-average molecular weight) of 50 or more and less than 600.

From the viewpoint of excellent chemical resistance, printing durability, and suppressing property of on-press developing residues, the molecular weight of the low-molecular-weight polymerizable compound is preferably 100 or more and less than 600, more preferably 300 or more and less than 600, and still more preferably 400 or more and less than 600.

In a case where the polymerizable compound includes the low-molecular-weight polymerizable compound as the polymerizable compound other than the oligomer (in a case where the polymerizable compound includes two or more kinds of low-molecular-weight polymerizable compounds, the total amount thereof), from the viewpoint of chemical resistance, printing durability, and suppressing property of on-press developing residues, a ratio of the above-described oligomer to the low-molecular-weight polymerizable compound (oligomer/low-molecular-weight polymerizable compound) is preferably 10/1 to 1/10, more preferably 10/1 to 3/7, and still more preferably 10/1 to 7/3 based on mass.

As the low-molecular-weight polymerizable compound, polymerizable compounds described in paragraphs 0082 to 0086 of WO2019/013268A can also be suitably used.

Details of the method of use, such as the structure of the polymerizable compound, whether the polymerizable compound is used alone or in combination, and the addition amount, can be set optionally.

In particular, from the viewpoint of printing durability, the image-recording layer preferably contains two or more polymerizable compounds.

A content of the polymerizable compound (in a case where the image-recording layer contains two or more polymerizable compounds, the total content of the polymerizable compounds) is preferably 5% to 75% by mass, more preferably 10% to 70% by mass, and still more preferably 15% to 60% by mass with respect to the total mass of the image-recording layer.

<Particles>

From the viewpoint of printing durability, the image-recording layer preferably contains particles.

The particles may be any of organic particles or inorganic particles, but from the viewpoint of printing durability, organic particles are preferable, and polymer particles are more preferable.

The organic particles mean particles composed of an organic substance, and the polymer particles mean particles composed of a polymer. **In** other words, the polymer particles mean a polymer having a particle shape among polymers contained in the image-recording layer.

It is preferable that the polymer particles are particles selected from the group consisting of thermoplastic resin particles, thermally reactive resin particles, polymer particles having a polymerizable group, microcapsules encapsulating a hydrophobic compound, and microgels (cross-linked polymer particles). Among these, polymer particles having a

polymerizable group or microgels are preferable.

The polymer particles preferably contain at least one ethylenically unsaturated group because an effect of improving the printing durability of the exposed portion and the on-press developability of the non-exposed portion can be obtained.

In addition, from the viewpoint of printing durability and on-press developability, thermoplastic resin particles are preferable as the polymer particles.

Preferred examples of the thermoplastic resin particles include thermoplastic polymer particles described in Research Disclosure No. 33303 on January, 1992, JP1997-123387A (JP-H09-123387A), JP1997-131850A (JP-H09-131850A), JP1997-171249A (JP-H09-171249A), JP1997-171250A (JP-H09-171250A), and EP931647B.

Examples of the thermally reactive resin particles include polymer particles having a thermal reactive group. The thermally reactive polymer particles are crosslinked by a thermal reaction and have hydrophobic regions formed by a change in functional groups during the crosslinking.

As the thermally reactive group in the polymer particles having a thermally reactive group, a functional group that performs any reaction may be used as long as a chemical bond is formed, but a polymerizable group is preferable. Preferred examples thereof include an ethylenically unsaturated group which causes a radical polymerization reaction (such as an acryloyl group, a methacryloyl group, a vinyl group, or an allyl group); a cationically polymerizable group (such as a vinyl group, a vinyloxy group, an epoxy group, or an oxetanyl group); an isocyanate group which causes an addition reaction or a block body thereof, an epoxy group, a vinyloxy group, and a functional group having active hydrogen atom as a reaction partner of these (such as an amino group, a hydroxy group, or a carboxy group); a carboxy group which causes a condensation reaction and a hydroxy group or an amino group as a reaction partner thereof; and an acid anhydride which causes a ring-opening addition reaction and an amino group or a hydroxy group as a reaction partner thereof.

The microcapsule is particles in which at least a part of constituent components of the image-recording layer is encapsulated in the microcapsule, as described in JP2001-277740A and JP2001-277742A. The constituent components of the image-recording layer may be contained in a portion other than the microcapsule. A preferred aspect of the image-recording layer containing the microcapsule is an aspect in which hydrophobic constituent components are encapsulated in the microcapsule and hydrophilic constituent components are contained in a portion other than the microcapsule.

The microgels (crosslinked polymer particles) may contain a part of the constituent components of the image-recording layer in at least one of the surface or the inside of the microgels. From the viewpoint of sensitivity of the planographic printing plate precursor to be obtained and printing durability of the planographic printing plate to be obtained, a reactive microgel having a radically polymerizable group on the surface thereof is particularly preferable.

The constituent components of the image-recording layer can be made into microcapsules or microgels using a known method.

From the viewpoint of printing durability of the planographic printing plate to be obtained, stain resistance, and storage stability, it is preferable that the polymer particles are resin particles obtained by reacting a polyvalent isocyanate compound which is an adduct of a polyhydric phenol compound containing two or more hydroxy groups in a molecule and isophorone diisocyanate with a compound containing an active hydrogen.

As the above-described polyhydric phenol compound, a compound having a plurality of benzene rings having a phenolic hydroxy group is preferable.

As the above-described compound having an active hydrogen, a polyol compound or a polyamine compound is preferable, a polyol compound is more preferable, and at least one compound selected from the group consisting of propylene glycol, glycerin, and trimethylolpropane is still more preferable.

As the resin particles obtained by reacting the compound containing an active hydrogen with the polyvalent isocyanate compound which is an adduct of a polyhydric phenol compound containing two or more hydroxy groups in a molecule and isophorone diisocyanate, polymer particles described in paragraphs 0032 to 0095 of JP2012-206495A are preferably exemplified.

Furthermore, from the viewpoint of printing durability and solvent resistance of the planographic printing plate to be obtained, the polymer particles preferably include polymer particles containing a polymer having both (i) a constitutional unit having a pendant cyano group directly bonded to the hydrophobic main chain and (ii) a constitutional unit having a pendant group including a hydrophilic poly(alkylene oxide) segment.

Preferred examples of the above-described hydrophobic main chain include an acrylic resin chain.

Examples of the above-described pendant cyano group include $-[CH_2CH(C{\equiv}N)]-$ and $-[CH_2C(CH_3)(C{\equiv}N)]-$.

In addition, the above-described constitutional unit (i) having a pendant cyano group can be easily derived from an ethylene-based unsaturated monomer (for example, acrylonitrile, methacrylonitrile, or the like) or a combination of these.

In addition, as an alkylene oxide in the above-described hydrophilic polyalkylene oxide segment, ethylene oxide or propylene oxide is preferable and ethylene oxide is more preferable.

The number of repetitions of the alkylene oxide structure in the above-described hydrophilic polyalkylene oxide segment is preferably 10 to 100, more preferably 25 to 75, and still more preferably 40 to 50.

As the resin particles including both the constitutional unit (i) which has the pendant cyano group directly bonded to the hydrophobic main chain and the constitutional unit (ii) which has the pendant group including the hydrophilic polyalkylene oxide segment, particles described in paragraphs 0039 to 0068 of JP2008-503365A are preferably exemplified.

In addition, from the viewpoint of printing durability and on-press developability, the above-described polymer particles preferably contain a resin having a hydrophilic group.

The above-described hydrophilic group is not particularly limited as long as it has a hydrophilic structure, and examples thereof include an acid group such as a carboxy group, a hydroxy group, an amino group, a cyano group, and a polyalkylene oxide structure.

Among these, from the viewpoint of on-press developability and printing durability, a polyalkylene oxide structure is preferable, and a polyethylene oxide structure, a polypropylene oxide structure, or a polyethylene/propylene oxide structure is more preferable.

In addition, from the viewpoint of on-press developability and suppressing property of developing residues during on-press development, polymer particles containing a resin having, as the above-described polyalkylene oxide structure, a polypropylene oxide structure are preferable, and polymer particles containing a resin having both a polyethylene oxide structure and a polypropylene oxide structure are more preferable.

From the viewpoint of on-press developability, the number of alkylene oxide structures in the above-described polyalkylene oxide structure is preferably 2 or more, more preferably 5 or more, still more preferably 5 to 200, and particularly preferably 8 to 150.

In addition, from the viewpoint of printing durability, receptivity, and on-press developability, the above-described hydrophilic group preferably includes a constitutional unit having a cyano group or a group represented by Formula (Z), more preferably includes a constitutional unit represented by Formula (AN) or a group represented by Formula (Z), and still more preferably includes a group represented by Formula (Z).

*-Q-W-Y (Z)

In Formula (Z), Q represents a divalent linking group, W represents a divalent group having a hydrophilic structure or a divalent group having a hydrophobic structure, Y represents a monovalent group having a hydrophilic structure or a monovalent group having a hydrophobic structure, any of W or Y has a hydrophilic structure, and * represents a bonding site to another structure.

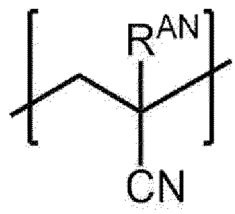

( AN )

In Formula (AN), $R^{AN}$ represents a hydrogen atom or a methyl group.

From the viewpoint of printing durability, the polymer contained in the above-described polymer particles preferably has a constitutional unit formed of the compound having a cyano group.

Generally, it is preferable that the cyano group is introduced as a constitutional unit having a cyano group into the resin using a compound (monomer) having a cyano group. Examples of the compound having a cyano group include an acrylonitrile compound, and (meth)acrylonitrile is preferable.

The constitutional unit having a cyano group is preferably a constitutional unit formed of an acrylonitrile compound, and more preferably a constitutional unit formed of (meth)acrylonitrile, that is, the constitutional unit represented by Formula (AN).

In a case where the above-described polymer has a constitutional unit having a cyano group, from the viewpoint of printing durability, a content of the constitutional unit having a cyano group (preferably, the constitutional unit represented by Formula (AN)) in the polymer having the constitutional unit having a cyano group is preferably 5% to 90% by mass, more preferably 20% to 80% by mass, and still more preferably 30% to 60% by mass with respect to the total mass of the polymer having a constitutional unit having a cyano group.

In addition, from the viewpoint of printing durability, receptivity, and on-press developability, the above-described polymer particles preferably contain a polymer having the group represented by Formula (Z).

Q in Formula (Z) is preferably a divalent linking group having 1 to 20 carbon atoms, and more preferably a divalent linking group having 1 to 10 carbon atoms.

In addition, Q in Formula (Z) is preferably an alkylene group, an arylene group, an ester bond, an amide bond, or a group obtained by combining two or more of these, and more preferably a phenylene group, an ester bond, or an amide bond.

The above-described divalent group having a hydrophilic structure in W of Formula (Z) is preferably a polyalkyleneoxy group or a group in which $-CH_2CH_2NR^W-$ is bonded to one terminal of the polyalkyleneoxy group. $R^W$ represents a hydrogen atom or an alkyl group.

The above-described divalent group having a hydrophobic structure in W of Formula (Z) is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$'s each independently represent a linear, branched, or cyclic alkylene group having 6 to 120 carbon atoms, a haloalkylene group having 6 to 120 carbon atoms, an arylene group having 6 to 120 carbon atoms, an alkarylene group having 7 to 120 carbon atoms (divalent group formed by removing one hydrogen atom from an alkylaryl group), or an aralkylene group having 7 to 120 carbon atoms.

The above-described monovalent group having a hydrophilic structure in Y of Formula (Z) is preferably -OH, -C(=O)OH, a polyalkyleneoxy group having a hydrogen atom or an alkyl group at a terminal, or a group in which $-CH_2CH_2NR^W-$ is bonded to one terminal of a polyalkyleneoxy group having a hydrogen atom or an alkyl group at the other terminal.

As the above-described monovalent group having a hydrophobic structure in Y of Formula (Z), a linear, branched, or cyclic alkyl group having 6 to 120 carbon atoms, a haloalkyl group having 6 to 120 carbon atoms, an aryl group having 6 to 120 carbon atoms, an alkaryl group (alkylaryl group) having 7 to 120 carbon atoms, an aralkyl group having 7 to 120 carbon atoms, $-OR^{WB}$, $-C(=O)OR^{WB}$, or $-OC(=O)R^{WB}$ is preferable. $R^{WB}$ represents an alkyl group having 6 to 20 carbon atoms.

From the viewpoint of printing durability, receptivity, and on-press developability, in the above-described polymer particles having the group represented by Formula (Z), W is preferably a divalent group having a hydrophilic structure, and it is more preferable that Q is a phenylene group, an ester bond, or an amide bond, W is a polyalkyleneoxy group, and Y is a polyalkyleneoxy group having a hydrogen atom or an alkyl group at a terminal.

In addition, from the viewpoint of printing durability and on-press developability, the above-described polymer particles preferably contain a polymer having a polymerizable group, and polymer particles having a polymerizable group on a particle surface are more preferable.

Furthermore, from the viewpoint of printing durability, the above-described polymer particles preferably contain a polymer having a hydrophilic group and a polymerizable group.

The above-described polymerizable group may be a cationically polymerizable group or a radically polymerizable group, and from the viewpoint of reactivity, it is preferably a radically polymerizable group.

The above-described polymerizable group is not particularly limited as long as it is a group capable of polymerization, but from the viewpoint of reactivity, an ethylenically unsaturated group is preferable, a vinylphenyl group (styryl group), a (meth)acryloxy group, or a (meth)acrylamide group is more preferable, and a (meth)acryloxy group is still more preferable.

In addition, the polymer in the polymer particles having a polymerizable group preferably has a constitutional unit having a polymerizable group.

The polymerizable group may be introduced into the surface of the polymer particles by a polymer reaction.

In addition, from the viewpoint of printing durability and on-press developability, the image-recording layer preferably contains, as the above-described polymer particles, addition polymerization-type resin particles having a dispersible group, and it is more preferable that the above-described dispersible group includes the group represented by Formula (Z).

From the viewpoint of printing durability, receptivity, on-press developability, and suppressing property of developing residues during on-press development, the above-described polymer particles preferably contain a resin having a urea bond.

Suitable Examples of the above-described resin having a urea bond include those described in WO2020/262692A.

From the viewpoint of printing durability and on-press developability, the above-described image-recording layer preferably contains thermoplastic resin particles.

A thermoplastic resin contained in the thermoplastic resin particles is not particularly limited, and examples thereof include polyethylene, polystyrene, polyvinyl chloride, polyvinylidene chloride, polymethyl (meth)acrylate, polyethyl (meth)acrylate, polybutyl (meth)acrylate, polyacrylonitrile, polyvinyl acetate, and a copolymer of these. The thermoplastic resin may be in a state of latex.

As the thermoplastic resin, a resin which forms a part or all of a hydrophobic film forming the image-recording layer by melting or softening the thermoplastic resin due to heat generated in the exposure step described later is preferable.

From the viewpoint of ink receptivity and printing durability, the above-described thermoplastic resin preferably includes a resin having a constitutional unit formed of an aromatic vinyl compound and a constitutional unit having a cyano group.

Suitable Examples of the resin having a constitutional unit formed of an aromatic vinyl compound and a constitutional unit having a cyano group include resins described in WO2020/262692A.

From the viewpoint of printing durability and ink receptivity, A glass transition temperature (Tg) of the thermoplastic resin contained in the thermoplastic resin particles is preferably 60°C to 150°C, more preferably 80°C to 140°C, and still more preferably 90°C to 130°C.

In a case where the thermoplastic resin particles contain two or more kinds of thermoplastic resins, a value obtained by the FOX equation described later is referred to as the glass transition temperature of the thermoplastic resin.

In the present specification, the glass transition temperature of the resin can be measured by differential scanning calorimetry (DSC).

Specifically, the glass transition temperature is measured according to the method described in JIS K 7121 (1987) or JIS K 6240 (2011). As the glass transition temperature in the present specification, an extrapolated glass transition initiation temperature (hereinafter, may be referred to as Tig) is used.

The method of measuring the glass transition temperature will be described in more detail.

In a case where the glass transition temperature is acquired, the resin is maintained at a temperature lower than the expected Tg of the resin by approximately 50°C until the device is stabilized, the resin is heated to a temperature higher than the temperature at which the glass transition is completed by approximately 30°C at a heating rate of 20 °C/min, and a differential thermal analysis (DTA) curve or a DSC curve is created.

The extrapolated glass transition start temperature (Tig), that is, the glass transition temperature Tg in the present specification is acquired as the temperature of the intersection between a straight line obtained by extending the base line on a low temperature side in the DTA curve or the DSC curve onto a high temperature side and a tangent drawn at a point where the gradient of a curve from a step-like change portion of the glass transition is maximized.

In a case where the thermoplastic resin particles contain two or more kinds of thermoplastic resins, Tg of the thermoplastic resins contained in the thermoplastic resin particles is determined as follows.

In a case where Tg of a first thermoplastic resin is denoted by Tg1 (K), a mass fraction of the first thermoplastic resin to the total mass of thermoplastic resin components in the thermoplastic resin particles is denoted by W1, Tg of a second thermoplastic resin is denoted by Tg2 (K), and a mass fraction of the second thermoplastic resin to the total mass of thermoplastic resin components in the thermoplastic resin particles is denoted by W2, Tg0 (K) of the thermoplastic resin particles can be estimated according to the following FOX equation.

FOX equation:

$$1/Tg0 = (W1/Tg1) + (W2/Tg2)$$

In addition, in a case where the thermoplastic resin particles contain three or more kinds of resins or three or more kinds of thermoplastic resin particles having different kinds of thermoplastic resins are contained in a pretreatment liquid, Tg of the thermoplastic resin particles can be estimated according to the following equation in the same manner as described above, in a case where Tg of an n-th thermoplastic resin is denoted by Tgn (K) and a mass fraction of the n-th thermoplastic resin with respect to the total mass of the thermoplastic resin components in the thermoplastic resin particles is denoted by Wn.

FOX equation:

$$1/Tg0 = (W1/Tg1) + (W2/Tg2) + (W3/Tg3) \cdots + (Wn/Tgn)$$

As the differential scanning calorimeter (DSC), for example, EXSTAR 6220 manufactured by SII NanoTechnology Inc. can be used.

From the viewpoint of printing durability, an average particle diameter of the thermoplastic resin particles is preferably 1 to 200 nm, more preferably 3 nm or more and less than 80 nm, and still more preferably 10 to 49 nm.

Unless otherwise specified, the average particle diameter of the thermoplastic resin particles refers to a value measured by a dynamic light scattering method (DLS). The measurement of the average particle diameter of the thermoplastic resin particles by DLS is performed using Brookhaven BI-90 (manufactured by Brookhaven Instruments) according to the manual of the instrument.

A weight-average molecular weight of the thermoplastic resin contained in the thermoplastic resin particles is preferably 3,000 to 300,000 and more preferably 5,000 to 100,000.

A method of producing the thermoplastic resin contained in the thermoplastic resin particles is not particularly limited, and the thermoplastic resin can be produced by a known method.

For example, the thermoplastic resin is obtained by polymerizing a styrene compound, an acrylonitrile compound, and as necessary, at least one compound selected from the group consisting of an N-vinyl heterocyclic compound, a compound used for forming a constitutional unit having an ethylenically unsaturated group, a compound used for forming a constitutional unit having an acidic group, a compound used for forming a constitutional unit having a hydrophobic group, and a compound used for forming the other constitutional units, by a known method.
Specifically, suitable Examples of the thermoplastic resin contained in the thermoplastic resin particles include those described in WO2020/262692A.
As inorganic particles, known inorganic particles can be used, and metal oxide particles such as silica particles and titania particles can be suitably used.
An average particle diameter of the above-described particles is preferably 0.01 to 3.0 μm, more preferably 0.03 to 2.0 μm, and still more preferably 0.10 to 1.0 μm. **In** a case where the average particle diameter thereof is within the above-described range, excellent resolution and temporal stability are obtained.
The average particle diameter of the particles is measured by a dynamic light scattering method, as in the average particle diameter of the thermoplastic resin particles described above. Instead of the measurement by the dynamic light scattering method, a transmission electron micrograph of the particles may be imaged, particle diameters of a total of 5,000 particles may be measured on the micrograph, and an arithmetic average value may be calculated and used as the average particle diameter of the particles. Non-spherical particles are defined as having a diameter of a circle having the same area as the particle area in the photograph.
In addition, the average particle diameter of the particles is a volume average particle size unless otherwise specified.
The image-recording layer may contain only one kind of the particles (preferably the polymer particles) or may contain two or more kinds thereof.
From the viewpoint of on-press developability and printing durability, a content of the particles (preferably, the polymer particles) in the above-described image-recording layer is preferably 5% to 90% by mass, more preferably 10% to 90% by mass, still more preferably 20% to 90% by mass, and particularly preferably 50% to 90% by mass with respect to the total mass of the above-described image-recording layer.
In addition, from the viewpoint of on-press developability and printing durability, the content of the polymer particles in the above-described image-recording layer is preferably 20% to 100% by mass, more preferably 35% to 100% by mass, even more preferably 50% to 100% by mass, and particularly preferably 80% to 100% by mass with respect to the total mass of components having a molecular weight of 3,000 or more in the above-described image-recording layer.

<Binder polymer>

The image-recording layer may contain a binder polymer.
The above-described polymer particles do not correspond to the above-described binder polymer. That is, the binder polymer is a polymerized substance not in a form of particles.
As the binder polymer, a (meth)acrylic resin, a polyvinyl acetal resin, or a polyurethane resin is preferable.
In addition, as the binder polymer, a known binder polymer used in the image-recording layer of the planographic printing plate precursor can be used. As an example, a binder polymer which is used for the on-press development-type planographic printing plate precursor (hereinafter, also referred to as a binder polymer for on-press development) will be described in detail.
The binder polymer for on-press development is preferably a binder polymer having an alkylene oxide chain. The binder polymer having an alkylene oxide chain may have a poly(alkylene oxide) moiety in the main chain or in the side chain. **In** addition, the binder polymer may be a graft polymer having a poly(alkylene oxide) in the side chain or a block copolymer of a block constituted of a repeating unit containing a poly(alkylene oxide) and a block constituted of a repeating unit not containing an (alkylene oxide).
In a case where the binder polymer has a poly(alkylene oxide) moiety in the main chain, a polyurethane resin is preferable. Examples of a main chain of the polymer in a case where the binder polymer has a poly(alkylene oxide) moiety in the side chain include a (meth)acrylic resin, a polyvinyl acetal resin, a polyurethane resin, a polyurea resin, a polyimide resin, a polyamide resin, an epoxy resin, a polystyrene resin, a novolac-type phenolic resin, a polyester resin, synthetic rubber, and natural rubber; and a (meth)acrylic resin is preferable.
In addition, other preferred exampless of the binder polymer include a polymer compound (hereinafter, also referred to as a "star polymer compound") which has a polymer chain bonded to a nucleus through a sulfide bond by means of using a polyfunctional, in a range of hexa- to deca-functional, thiol as the nucleus and in which the polymer chain has a polymerizable group.
From the viewpoint of curability, preferred exampless of the star polymer compound include a star polymer compound having a polymerizable group such as an ethylenically unsaturated group on a main chain or a side chain, more preferably on a side chain.

Examples of the star polymer compound include those described in JP2012-148555A or WO2020/262692A.
A molecular weight (a weight-average molecular weight (Mw) obtained as a polystyrene equivalent value by GPC) of the binder polymer is preferably 2,000 or more, more preferably 5,000 or more, and still more preferably 10,000 to 300,000.
It is possible to use in combination with a hydrophilic polymer such as polyacrylic acid and polyvinyl alcohol described in JP2008-195018A as necessary. In addition, it is also possible to use in combination with a lipophilic polymer and a hydrophilic polymer.
In addition, from the viewpoint of printing durability and on-press developability, the image-recording layer preferably contains a binder polymer having a constitutional unit formed of an aromatic vinyl compound, and more preferably contains a binder polymer having a constitutional unit formed of an aromatic vinyl compound and an infrared absorber which is decomposed by exposure to infrared rays.
In addition, from the viewpoint of suppressing deterioration in on-press developability over time, a glass transition temperature (Tg) of the binder polymer is preferably 50°C or higher, more preferably 70°C or higher, still more preferably 80°C or higher, and particularly preferably 90°C or higher.
Furthermore, from the viewpoint of ease of permeation of water into the image-recording layer, the upper limit of the glass transition temperature of the binder polymer is preferably 200°C or lower and more preferably 120°C or lower.
From the viewpoint of further suppressing deterioration in on-press developability over time, the binder polymer having the above-described glass transition temperature is preferably polyvinyl acetal.
The polyvinyl acetal is a resin obtained by acetalizing a hydroxy group of polyvinyl alcohol with an aldehyde. Among these, polyvinyl butyral obtained by acetalizing (that is, butyralizing) a hydroxy group of polyvinyl alcohol with butylaldehyde is preferable.
In addition, from the viewpoint of improving printing durability, the polyvinyl acetal preferably has an ethylenically unsaturated group.
Specific examples of the polyvinyl acetal include those described in WO2020/262692A.
The image-recording layer preferably contains, as the binder polymer, a resin having a fluorine atom, and more preferably contains a fluoroaliphatic group-containing copolymer.
In a case where the resin having a fluorine atom, particularly, the fluoroaliphatic group-containing copolymer is used, it is possible to inhibit surface abnormalities resulting from foaming during the formation of the image-recording layer and to improve the condition of the coated surface, and further to improve the ink receptivity of the image-recording layer to be formed.
In addition, the image-recording layer containing the fluoroaliphatic group-containing copolymer has high gradation and is highly sensitive, for example, to laser light, so that the obtained planographic printing plate exhibits excellent fogging property by scattered light, reflected light, and the like and has excellent printing durability.
Specific examples of the above-described fluoroaliphatic group-containing copolymer include those described in WO2020/262692A.
The binder polymer may be used alone, or in combination of two or more kinds thereof.
The binder polymer can be contained in an optional amount in the image-recording layer, but a content of the binder polymer is preferably 1% to 90% by mass and more preferably 5% to 80% by mass with respect to the total mass of the image-recording layer.

<Polymerization inhibitor>

From the viewpoint of more excellent temporal stability and developability after a lapse of time, the image-recording layer preferably contains a polymerization inhibitor. In a case where the image-recording layer contains a polymerization inhibitor, unnecessary thermal polymerization of the polymerizable compound, particularly the radically polymerizable compound can be prevented during the production or storage of the image-recording layer.
Examples of the polymerization inhibitor include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylenebis(4-methyl-6-t-butylphenol), and an N-nitroso-N-phenylhydroxylamine aluminum salt.
As the polymerization inhibitor, a compound represented by Formula (Ph) is preferable from the viewpoint of more excellent temporal stability and developability over time.

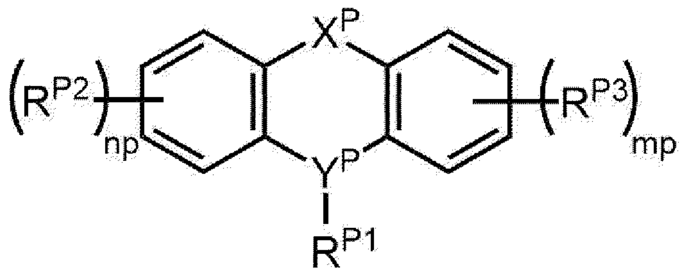

( Ph )

In Formula (Ph), $X^P$ represents O, S, or NH, $Y^P$ represents N or CH, $R^{P1}$ represents a hydrogen atom or an alkyl group, $R^{P2}$ and $R^{P3}$ each independently represent a halogen atom, an alkylthio group, an arylthio group, an alkoxy group, an aryloxy group, an alkyl group, an aryl group, an acylthio group, or an acyl group, and mp and np each independently represent an integer of 0 to 4.

From the viewpoint of temporal stability and developability after a lapse of time, $X^P$ in Formula (Ph) is preferably O or S and more preferably S.

From the viewpoint of temporal stability and developability after a lapse of time, $Y^P$ in Formula (Ph) is preferably N.

From the viewpoint of temporal stability and developability after a lapse of time, $R^{P1}$ in Formula (Ph) is preferably a hydrogen atom or a methyl group and more preferably a hydrogen atom.

$R^{P2}$ and $R^{P3}$ in Formula (Ph) each independently are preferably a halogen atom, an alkylthio group, an arylthio group, an alkoxy group, an aryloxy group, an alkyl group, or an aryl group.

From the viewpoint of temporal stability and developability after a lapse of time, mp and np in Formula (Ph) are each independently preferably an integer of 0 to 2, more preferably 0 or 1, and still more preferably 0.

The polymerization inhibitor may be used alone, or in combination of two or more kinds thereof.

A content of the polymerization inhibitor is preferably 0.001% to 5% by mass and more preferably 0.01% to 1% by mass with respect to the total mass of the image-recording layer.

<Chain transfer agent>

The image-recording layer may contain a chain transfer agent. The chain transfer agent contributes to improvement of printing durability of the planographic printing plate.

The chain transfer agent is preferably a thiol compound, and from the viewpoint of boiling point (difficulty of being volatilized), it is more preferably a thiol compound having 7 or more carbon atoms and still more preferably a compound (aromatic thiol compound) having 7 or more carbon atoms and having a mercapto group on an aromatic ring. The above-described thiol compound is preferably a monofunctional thiol compound.

Specific examples of the chain transfer agent include compounds described in WO2020/262692A.

The chain transfer agent may be used alone, or in combination of two or more kinds thereof.

A content of the chain transfer agent is preferably 0.01% to 50% by mass, more preferably 0.05% to 40% by mass, and still more preferably 0.1% to 30% by mass with respect to the total mass of the image-recording layer.

<Other components>

The image-recording layer may contain, as a component other than the above-described components, an oil sensitizing agent (for example, a phosphonium compound, a nitrogen-containing low-molecular-weight compound, or an ammonium group-containing polymer), a development accelerator, a surfactant, a higher fatty acid derivative, a plasticizer, an inorganic lamellar compound, or the like. For these other components, description in paragraphs 0114 to 0159 of JP2008-284817A can be referred to.

In addition, specific Examples of the development accelerator include compounds described in WO2020/262692A.

<Method of forming image-recording layer>

The image-recording layer can be formed, for example, by dispersing or dissolving the above-described components in a known solvent to prepare a coating liquid, coating a support with the coating liquid by a known method such as bar coating, and drying the coating liquid, as described in paragraphs 0142 and 0143 of JP2008-195018A.

As the solvent, a known solvent can be used, and examples thereof include water, acetone, methyl ethyl ketone (2-butanone), cyclohexane, ethyl acetate, ethylene dichloride, tetrahydrofuran, toluene, ethylene glycol monomethyl

ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, and ethyl lactate.

The solvent may be used alone, or in combination of two or more kinds thereof. A concentration of solid contents in the coating liquid is preferably 1% to 50% by mass.

A coating amount (solid content) of the image-recording layer after the coating and the drying varies depending on the applications thereof, but from the viewpoint of obtaining excellent sensitivity and excellent film-coating characteristics of the image-recording layer, it is preferably 0.3 to 3.0 $g/m^2$.

A layer thickness of the image-recording layer is preferably 0.1 to 3.0 μm and more preferably 0.3 to 2.0 μm.

A thickness of each layer in the planographic printing plate precursor can be measured by producing a section obtained by cutting the planographic printing plate precursor in a direction perpendicular to the surface of the planographic printing plate precursor, and observing a cross section of the section with a scanning electron microscope (SEM).

[Other layers]

The planographic printing plate precursor may include other layers in addition to the support and the image-recording layer described above.

The planographic printing plate precursor may include an undercoat layer disposed between the support and the image-recording layer as necessary, for example, in order to improve adhesiveness between the support and the image-recording layer.

In addition, the planographic printing plate precursor may include a protective layer (overcoat layer) on the image-recording layer as necessary, in order to prevent occurrence of scratches and the like on the image-recording layer, to shield oxygen, and to prevent ablation during exposure to a high-illuminance laser.

<Undercoat layer>

The undercoat layer is a layer disposed between the support and the image-recording layer, and has a function of improving the adhesiveness between the support and the image-recording layer.

The configuration of the undercoat layer is not particularly limited, but it is preferable that the undercoat layer contains polyvinylphosphonic acid from the viewpoint of suppressing ink adhesiveness in the non-exposed portion while maintaining printing durability.

Here, as the polyvinylphosphonic acid, compounds decribed in US3276868A, US4153461A, and US4689272A can be used.

The configuration of the undercoat layer is not particularly limited, but it is preferable that the undercoat layer contains a compound having a betaine structure from the viewpoint that stain resistance and deinking capability after being left to stand are more excellent.

Here, the betaine structure refers to a structure having at least one cation and at least one anion. The number of cations is typically the same as the number of anions to be neutral as a whole, but in the present specification, in a case where the number of cations is not the same as the number of anions, an electric charge is cancelled by having a required amount of counter ions to be the betaine structure.

A content of the above-described compound having a betaine structure in the undercoat layer is preferably 80% by mass or more, and more preferably 90% by mass or more with respect to the total mass of the undercoat layer. The lower limit thereof may be, for example, 100% by mass.

The undercoat layer may have an aspect of containing a compound other than the compound having a betaine structure.

For example, the undercoat layer may contain a compound having a hydrophilic group. Examples of the hydrophilic group include a carboxylic acid group and a sulfonic acid group.

The compound having a hydrophilic group may further have a radically polymerizable reactive group.

(Method of forming undercoat layer)

The undercoat layer is produced by forming an undercoat layer on the support.

The method of producing the undercoat layer is not particularly limited, and examples thereof include a method of coating the anodic oxide film of the support with a coating liquid for forming an undercoat layer, which contains a

predetermined compound (for example, the compound having a betaine structure).

It is preferable that the coating liquid for forming an undercoat layer contains a solvent. Examples of the solvent include water and an organic solvent.

Examples of the method of coating the film with the coating liquid for forming an undercoat layer include various known methods. Examples thereof include a bar coater coating, a spin coating, a spray coating, a curtain coating, a dip coating, an air knife coating, a blade coating, and a roll coating.

A coating amount (solid content) of the undercoat layer is preferably 0.1 to 100 $mg/m^2$.

<Protective layer>

The planographic printing plate precursor preferably includes a protective layer (also referred to as "overcoat layer") on a surface of the image-recording layer opposite to the support. That is, a planographic printing plate precursor including the support, the image-recording layer, and the protective layer in this order is preferable.

The protective layer may have at least one of a function of suppressing a reaction inhibiting image formation by shielding oxygen, a function of preventing occurrence of scratches in the image-recording layer, or a function of preventing ablation during exposure to a high-illuminance laser.

Protective layers having the characteristics are described in, for example, US3458311A and JP1980-049729B (JP-S55-049729B). As an oxygen-impermeable polymer used in the protective layer, any of a water-soluble polymer or a hydrophobic polymer (water-insoluble polymer) can be appropriately selected and used, and two or more kinds thereof can be mixed and used as necessary; but from the viewpoint of on-press developability, a water-soluble polymer is preferable.

In the present specification, the water-soluble polymer means a polymer having a solubility of more than 5% by mass in pure water at 25°C.

Examples of the water-soluble polymer used in the protective layer include polyvinyl alcohol, modified polyvinyl alcohol, polyvinylpyrrolidone, a cellulose derivative, polyethylene glycol, and poly(meth)acrylonitrile.

In addition, the water-soluble polymer preferably includes at least one selected from the group consisting of modified polyvinyl alcohol and a cellulose derivative.

As the modified polyvinyl alcohol, an acid-modified polyvinyl alcohol having a carboxy group or a sulfo group is preferably used. Specific examples thereof include modified polyvinyl alcohols described in JP2005-250216A and JP2006-259137A.

Examples of the cellulose derivative include methyl cellulose, hydroxypropyl methyl cellulose, and carboxymethyl cellulose.

Among the above-described water-soluble polymers, a polymer containing polyvinyl alcohol is preferable, and a polymer containing polyvinyl alcohol having a saponification degree of 50% or more is more preferable.

The above-described saponification degree is preferably 60% or more, more preferably 70% or more, and still more preferably 85% or more. The upper limit of the saponification degree is not particularly limited, and may be 100% or less.

The above-described saponification degree is measured according to the method described in JIS K 6726: 1994.

As an aspect of the protective layer, for example, an aspect in which the protective layer contains polyvinyl alcohol and polyethylene glycol is also preferable.

In a case where the protective layer contains a water-soluble polymer, a content of the water-soluble polymer is preferably 1% to 99% by mass, more preferably 3% to 97% by mass, and still more preferably 5% to 95% by mass with respect to the total mass of the protective layer.

The protective layer preferably contains a hydrophobic polymer.

The hydrophobic polymer refers to a polymer which is dissolved less than 5 g or is not dissolved in 100 g of pure water at 125°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), and a copolymer obtained by combining raw material monomers of these resins.

The hydrophobic polymer preferably includes a polyvinylidene chloride resin. In addition, the hydrophobic polymer preferably includes a styrene-acrylic copolymer (also referred to as a styrene acrylic resin).

From the viewpoint of on-press developability, the hydrophobic polymer is preferably hydrophobic polymer particles.

One hydrophobic polymer may be used alone, or two or more kinds thereof may be used in combination.

In a case where the protective layer contains a hydrophobic polymer, a content of the hydrophobic polymer is preferably 1% to 70% by mass, more preferably 5% to 50% by mass, and still more preferably 10% to 40% by mass with respect to the total mass of the protective layer.

From the viewpoint of improving visibility of the exposed portion, the protective layer preferably contains a color

forming substance precursor.

The color forming substance precursor means a compound having a property of forming color by a stimulus such as light and acid and changing the color of the image-recording layer.

Examples of the color forming substance precursor include an infrared absorber and an acid color-forming agent.

The protective layer preferably contains, as the color forming substance precursor, an infrared absorber, and more preferably contains a decomposition-type infrared absorber.

The infrared absorber and the acid color-forming agent contained in the protective layer are the same as the infrared absorber and the acid color-forming agent contained in the image-recording layer, including preferred aspects thereof.

The color forming substance precursor contained in the protective layer may be used alone, or in combination of two or more kinds thereof.

From the viewpoint of color formability, a content of the color forming substance precursor in the protective layer is preferably 0.10% to 50% by mass, more preferably 0.50% to 30% by mass, and still more preferably 1.0% to 20% by mass with respect to the total mass of the protective layer.

From the viewpoint of development defect suppressiveness, the protective layer preferably contains a filler.

Examples of the filler include inorganic particles, organic resin particles, and an inorganic lamellar compound. Among these, an inorganic lamellar compound is preferable. By using an inorganic lamellar compound, it is possible to effectively inhibit an attachment re-attached from the roll surface from being directly attached to the surface of the image-recording layer.

Examples of the inorganic particles include metal oxide particles such as silica particles. The following inorganic lamellar compound is not included in the inorganic particles.

Examples of the organic resin particles include crosslinked resin particles.

The inorganic lamellar compound refers to particles having thin flat plate shapes, and examples thereof include mica groups such as natural mica and synthetic mica, talc represented by a formula $3MgO \cdot 4SiO \cdot H_2O$, taeniolite, montmorillonite, saponite, hectorite, and zirconium phosphate.

The mica compound is preferably used as the inorganic lamellar compound. Examples of the mica compound include mica groups such as natural mica and synthetic mica represented by Formula: $A(B,C)_{2-5}D_4O_{10}(OH,F,O)_2$ [here, A is any one of K, Na, or Ca, B and C are any one of Fe(II), Fe(III), Mn, Al, Mg, or V, and D is Si or Al].

In the mica groups, Examples of the natural mica include muscovite, paragonite, phlogopite, biotite, and lepidolite. Examples of the synthetic mica include non-swelling mica such as fluorophlogopite $KMg_3(AlSi_3O_{10})F_2$, potassium tetrasilic mica $(KMg_{2.5}Si_4O_{10})F_2$, and Na tetrasilylic mica $NaMg_{2.5}(Si_4O_{10})F_2$, and swelling mica such as Na or Li taeniolite $(Na, Li)Mg_2Li(Si_4O_{10})F_2$ and montmorillonite-based Na or Li hectorite $(Na, Li)_{1/8}Mg_{2/5}Li_{1/8}(Si_4O_{10})F_2$. Furthermore, synthetic smectite is also useful.

From the viewpoint of diffusion control, regarding a shape of the mica compound, the thickness is preferably thin, and the planar size is preferably large as long as the smoothness and active light ray-transmitting properties of coating surfaces are not impaired.

Therefore, an aspect ratio is preferably 20 or more, more preferably 100 or more, and still more preferably 200 or more. The aspect ratio is a ratio of the major axis to the thickness of a particle, and can be measured from projection views obtained from the microphotograph of the particles. As the aspect ratio increases, the obtained effect is stronger.

The average long diameter of the particle diameters of the mica compound is preferably 0.3 to 20, more preferably 0.5 to 10 μm, and still more preferably 1 to 5 μm. The average thickness of the particles is preferably 0.1 μm or less, more preferably 0.05 μm or less, and still more preferably 0.01 μm or less. In the case of swelling synthetic mica, which is a representative compound, the thickness is preferably approximately 1 to 50 nm, and the surface size (long diameter) is preferably approximately 1 to 20 μm.

A content of the inorganic lamellar compound is preferably 1% to 60% by mass and more preferably 3% to 50% by mass with respect to the total mass of the protective layer. Even in a case where a plurality of types of inorganic lamellar compounds are used in combination, the total amount of the inorganic lamellar compounds is preferably the above-described content. In a case where the total amount is within the above-described range, oxygen-shielding property improves and excellent sensitivity can be obtained. In addition, the degradation of receptivity can be prevented.

The protective layer may contain a known additive such as a plasticizer for imparting flexibility and a surfactant for improving coatability, in addition to the above-described components. In addition, the oil sensitizing agent described in the section of the image-recording layer may be contained in the protective layer.

The protective layer can be formed by a known method of applying a composition containing the above-described components. A coating amount (expressed in terms of solid contents) of the protective layer is preferably 0.0 to 10 $g/m^2$, more preferably 0.02 to 3 $g/m^2$, and still more preferably 0.02 to 1 $g/m^2$.

A film thickness of the protective layer in the planographic printing plate precursor is not particularly limited, but is preferably 0.1 to 5.0 μm and more preferably 0.3 to 4.0 μm.

The planographic printing plate precursor may further include a known layer laminated on the planographic

printing plate precursor, other than the above. For example, a back coating layer may be provided on the surface of the support opposite to the image-recording layer as necessary.

[Laminate]

The planographic printing plate precursor may constitute a laminate in which a plurality of planographic printing plate precursors are laminated.

It is preferable that the laminate in which a plurality of planographic printing plate precursors are laminated further includes a protective material which protects the planographic printing plate precursors. The planographic printing plate precursor is in a form of one thin plate adopting a metal as the support. Therefore, in a case where scratches or deformation occurs in the corners, sides, inside, or the like of the planographic printing plate precursor, unfortunately, images are likely to be blurred by photosensitization, or ink is likely to be non-uniformly distributed by printing. Therefore, in a case of constituting a laminate in which a plurality of precursors are laminated, it is preferable to dispose a protective material for each predetermined number of precursors to protect the precursors.

For example, by packaging a laminate including a plurality of planographic printing plate precursors and a protective material with a packaging material to form a package, and handling the package (transportation, storage, and the like), deformation (bending and the like) of the precursors during handling is less likely to occur, and damage to the precursors is suppressed. In addition, even in a case where an external force acts on the package, since a part of the external force is absorbed by the protective material, deformation and scratches of the precursors are suppressed.

The disposition of the protective material in the laminate is not particularly limited, and examples thereof include the uppermost portion of the laminate, between the laminated planographic printing plate precursors, and the lowermost portion of the laminate. The protective material is preferably disposed at least at the uppermost portion of the laminate, and more preferably disposed at least at the uppermost portion and the lowermost portion.

A material of the protective material is not particularly limited, and examples thereof include thick paper, cardboard, and plastic. Among these, from the viewpoint of suppressing development defect, cardboard or plastic is preferable and plastic is more preferable. Examples of the plastic include polyester, polycarbonate, and polyolefin; and polyester is preferable.

A size (length and width) and a thickness of the protective material are not particularly limited and can be appropriately selected according to the planographic printing plate precursor to be protected.

From the viewpoint of suppressing development defect, a moisture content of the protective material is preferably 10% by mass or less, more preferably 7% by mass or less, and particularly preferably 3% by mass or less. The lower limit value of the moisture content is 0% by mass. The moisture content (equilibrium moisture content) of the protective material is measured according to the method described in JIS P 8202 (1998).

The laminate may have an interleaving paper between the planographic printing plate precursors.

Examples of a material of the interleaving paper include paper in which 100% by mass of wood pulp is used, paper in which wood pulp and synthetic pulp are used in combination, and paper in which a low-density polyethylene layer or a high-density polyethylene layer is provided on a surface thereof.

In addition, the entire laminate may be packaged with a known packaging material.

[Method of manufacturing planographic printing plate precursor]

Examples of a method of manufacturing the planographic printing plate precursor according to the embodiment of the present invention include a method including a step of producing a support including an aluminum alloy plate and an anodic oxide film, and a step of forming an image-recording layer on a surface of the produced support on the anodic oxide film side.

The step of producing the support is described in <Method of producing support> above, and the step of forming the image-recording layer is described in <Method of forming image-recording layer> above.

As necessary, after the step of producing the support, a step of forming an undercoat layer on the surface of the obtained support on the anodic oxide film side may be performed, and then the above-described step of forming the image-recording layer on the surface of the formed undercoat layer may be performed.

In addition, after performing the above-described step of forming the image-recording layer, a step of forming a protective layer on the surface of the formed image-recording layer may be performed.

The method of forming the undercoat layer and the step of forming the protective layer are as described above.

[Manufacturing method of planographic printing plate and printing method]

A method of manufacturing a planographic printing plate using the planographic printing plate precursor and a printing method using the planographic printing plate precursor will be described.

The manufacturing method of a planographic printing plate according to the embodiment of the present invention includes a step (exposure step) of exposing the image-recording layer of the planographic printing plate precursor in an imagewise manner (imagewise exposure) to form an exposed portion and a non-exposed portion, and a step (on-press development step) of supplying at least one of a printing ink or a dampening water on a printing press to remove the non-exposed portion of the imagewise-exposed image-recording layer and to manufacture a planographic printing plate.
The printing method according to the embodiment of the present invention includes a step (exposure step) of exposing the image-recording layer of the planographic printing plate precursor in an imagewise manner (imagewise exposure) to form an exposed portion and a non-exposed portion, a step (on-press development step) of supplying at least one of printing ink or dampening water on a printing press to remove the non-exposed portion of the image-recording layer and to manufacture a planographic printing plate; and a step (printing step) of performing printing using the manufactured planographic printing plate.
Hereinafter, each of the above-described steps will be described in detail.

<Exposure step>

The manufacturing method of a planographic printing plate according to the embodiment of the present invention and the printing method according to the embodiment of the present invention include an exposure step of imagewise-exposing the image-recording layer of the planographic printing plate precursor to form an exposed portion and a non-exposed portion.
The imagewise exposure is performed by laser exposure through a transparent original picture having a line image or a halftone image or by laser beam scanning using digital data.
A wavelength of a light source for the imagewise exposure is preferably 750 to 1,400 nm. In a case where a light source which emits light having a wavelength of 750 to 1,400 nm is used, it is preferable to use an image-recording layer containing an infrared absorber having absorption in this wavelength range.
As the light source which emits light having a wavelength of 750 to 1,400 nm, a solid-state laser or a semiconductor laser which radiates infrared rays is exemplified. The output of the infrared laser is preferably 100 mW or more, the exposure time per one pixel is preferably equal to or less than 20 microseconds, and the irradiation energy quantity is preferably 10 to 300 $mJ/cm^2$. In addition, for the purpose of reducing the exposure time, it is preferable to use a multi-beam laser device. The exposure mechanism may be an internal drum system, an external drum system, a flat bed system, or the like.
The imagewise exposure can be performed using a plate setter according to a usual method. The imagewise exposure may be performed on a printing press after the planographic printing plate precursor is mounted on the printing press.

<On-press development step>

In the on-press development step, at least one of printing ink or dampening water is supplied to the imagewise-exposed planographic printing plate precursor on a printing press, and the image-recording layer in the non-exposed portion is removed, thereby manufacturing a planographic printing plate.
That is, in a case where the planographic printing plate precursor is imagewise-exposed and directly mounted on the printing press without performing any developer treatment or the planographic printing plate precursor is mounted on the printing press, imagewise-exposed on the printing press, and printed by supplying printing ink and dampening water, in the non-exposed portion, at the initial stage of the printing, the non-exposed portion in the image-recording layer is dissolved or dispersed in the supplied printing ink and/or dampening water to be removed, and thus the hydrophilic surface in the removed portion is exposed. On the other hand, in the exposed portion, the image-recording layer cured by the exposure forms an oily ink receiving unit having a lipophilic surface. The printing ink or dampening water may be supplied first to the plate surface, but the printing ink is preferably first supplied from a viewpoint of preventing the dampening water from being contaminated by the removed image-recording layer component.
In this manner, the planographic printing plate precursor is manufactured on the printing press by on-press development and is used as it is for printing a large number of sheets.

<Printing step>

The printing method includes a printing step of printing a recording medium using the planographic printing plate manufactured by the exposure step and the on-press development step.
As printing ink used in the printing step, various known inks can be used as desired. As the printing ink, an oil-based ink or an ultraviolet-curable ink (UV ink) is preferable.
In the above-described printing step, dampening water may be supplied as necessary.

The above-described printing step may be successively performed after the above-described on-press development step without stopping the printing press.
As the recording medium, a known recording medium can be used as desired.
In the manufacturing method of a planographic printing plate and the printing method, the entire surface of the planographic printing plate precursor or the planographic printing plate may be heated at any stage of before the exposure, during exposure, from the exposure to the development, or after the development, as necessary. By such heating, an image forming reaction in the image-recording layer is promoted, and advantages such as improvement in sensitivity or printing durability and stabilization of sensitivity can be obtained.
In a case where the planographic printing plate precursor is heated before the development, since it is possible to prevent problems such as curing of the non-exposed portion, it is preferable to heat the planographic printing plate precursor under mild conditions of 150°C or lower.
In a case where the planographic printing plate is heated after the development, since a sufficient image reinforcing effect can be obtained and problems such as deterioration of the support and thermal decomposition of the image area can be suppressed, it is preferable to heat the planographic printing plate under extremely severe conditions, for example, in a range of 100°C to 500°C.

Examples

Hereinafter, the present invention will be described in detail with reference to Examples, but the materials, the amounts and proportions of the materials used, the details of treatments, the procedure of treatments, and the like shown in Examples can be appropriately modified as long as the gist of the present invention is maintained. Accordingly, the scope of the present invention should not be construed as being limited by the specific examples given below.
In the present example, "part" means "parts by mass" unless otherwise specified. In a polymer compound, the molecular weight indicates the weight-average molecular weight (Mw) and the proportion of constitutional repeating units indicates mole percentage unless otherwise specified.
[Manufacturing Example A: Production of aluminum alloy plate]

[Manufacturing Examples A1 to A9]

Aluminum alloy plates of Manufacturing Examples A1 to A9 were produced as follows.
Using an aluminum alloy molten metal having a formulation of Si: 0.08% by mass, Fe: 0.31% by mass, Cu: 0.002% by mass, Ti: 0.020% by mass, other: 0.05% by mass or less, and the remainder of Al, continuous casting was performed by a twin-roll continuous casting method such that a casting plate thickness was 5.5 mm.
In the continuous casting, a cooling rate condition of the casting treatment was appropriately adjusted in a range of a cooling rate of 100 to 500 °C/sec for each of Manufacturing Examples. A density of the specific intermetallic compound in the aluminum alloy plate could be adjusted depending on the conditions of the cooling rate.
Next, the obtained continuous casting plate was subjected to cold rolling to have a plate thickness of 0.9 mm, subjected to an intermediate annealing heat treatment under conditions of 450°C and 4 hours, and further subjected to cold rolling again to finish to a thickness of 0.3 mm.
Next, leveling was corrected using a tension leveler to manufacture each aluminum alloy plate. The aluminum alloy plates manufactured in Manufacturing Examples A1 to A9, in which the cooling rate condition of the casting treatment was changed, were respectively referred to as aluminum alloy plates 1 to 9.
The formulation of each of the manufactured aluminum alloy plates was the same as the formulation of the aluminum alloy molten metal used for the manufacturing. **In** addition, a density of the intermetallic compound having a major axis of 2.0 μm or more on the surface of the manufactured aluminum alloy plate was the same as the density of the specific intermetallic compound shown in Table 2 below.

[Comparative Manufacturing Examples A1 to A3]

Aluminum alloy plates of Comparative Manufacturing Examples A1 to A3 were produced as follows.
A slab having a thickness of 500 mm was cast by direct chill (DC) casting using an aluminum alloy molten metal having the same formulation as the aluminum alloy plates of Manufacturing Examples A1 to A9.
In the casting, a cooling rate condition of the casting treatment was appropriately adjusted in a range of a cooling rate of 1 to 5 °C/sec for each of Comparative Manufacturing Examples.
Next, after cutting and removing a range of thickness of 20 mm from both surfaces of the obtained slab, a heat treatment (equalization treatment) was carried out in a state of the slab under conditions of 500°C to 600°C.
Next, the heat-treated slab was subjected to hot rolling to be rolled to a thickness of 3 mm, subjected to an intermediate annealing treatment at 410°C to 550°C, and then subjected to cold rolling to finish to a thickness of 0.3 mm.

Next, leveling was corrected using a tension leveler to manufacture each aluminum alloy plate. The aluminum alloy plates manufactured in Comparative Manufacturing Examples A1 to A3, in which the cooling rate condition of the casting treatment was changed, were respectively referred to as aluminum alloy plates C1 to C3.

The formulation of each of the manufactured aluminum alloy plates was the same as the formulation of the aluminum alloy molten metal used for the manufacturing. In addition, a density of the intermetallic compound having a major axis of 2.0 μm or more on the surface of the manufactured aluminum alloy plate was the same as the density of the specific intermetallic compound shown in Table 2 below.

[Manufacturing Example B: Manufacturing of support]

[Manufacturing Example B1]

The aluminum alloy plate 1 having a thickness of 0.3 mm, manufactured in Manufacturing Example A1 above, was subjected to the following treatment to manufacture a support 1. A water washing treatment was performed between all the treatment steps in the manufacturing of the support, and after the water washing treatment, the liquid was drained by a nip roller.

<Alkaline etching treatment (1)>

The aluminum alloy plate was subjected to an etching treatment by spraying a caustic soda aqueous solution in which the concentration of caustic soda was 26% by mass and the concentration of aluminum ions was 6.5% by mass using a spray at a temperature of 70°C. Thereafter, washing with water by spraying was performed. The dissolved aluminum amount of the surface to be subjected to an electrochemical roughening treatment was 5 g/$m^2$.

<Desmutting treatment (1) using acidic aqueous solution>

Next, a desmutting treatment was performed using an acidic aqueous solution. Specifically, the desmutting treatment was performed for 3 seconds by spraying the acidic aqueous solution onto the aluminum alloy plate. As the acidic aqueous solution used for the desmutting treatment, an aqueous solution containing 150 g/L of sulfuric acid was used. A liquid temperature thereof was 30°C.

<Hydrochloric acid electrolytic treatment>

Next, a hydrochloric acid electrolytic treatment was performed using the AC current and an electrolytic solution having a hydrochloric acid concentration of 13 g/L, an aluminum ion concentration of 15 g/L, and a sulfuric acid concentration of 1.0 g/L. A liquid temperature of the electrolytic solution was 25°C. The aluminum ion concentration was adjusted by adding aluminum chloride.

The waveform of the AC current was a sine wave in which the positive and negative waveforms were symmetrical, the frequency was 50 Hz, the ratio between the anodic reaction time and the cathodic reaction time in one cycle of the AC current was 1: 1, and the current density was 35 A/$dm^2$ in terms of the peak current value of the AC current waveform. In addition, the sum total of electric quantity of the aluminum alloy plate used for the anodic reaction was 300 C/$dm^2$, and the electrolytic treatment was performed four times at energization intervals of 2.5 seconds for each of the electric quantity of 75 C/$dm^2$. A carbon electrode was used as a counter electrode of the aluminum alloy plate. Thereafter, the water washing treatment was performed.

<Alkali etching treatment (2)>

The aluminum alloy plate after the hydrochloric acid electrolytic treatment was subjected to an etching treatment by spraying a caustic soda aqueous solution in which the concentration of caustic soda was 5% by mass and the concentration of aluminum ions was 0.5% by mass using a spray at a temperature of 45°C. An amount of aluminum dissolved in the surface subjected to the hydrochloric acid electrolytic treatment was 0.2 g/$m^2$. Thereafter, the water washing treatment was performed.

<Desmutting treatment (2) using acidic aqueous solution>

Next, a desmutting treatment was performed using an acidic aqueous solution. Specifically, the desmutting treatment was performed for 3 seconds by spraying the acidic aqueous solution onto the aluminum alloy plate. As the acidic aqueous solution used for the desmutting treatment, an aqueous solution having a sulfuric acid concentration of 170

g/L and an aluminum ion concentration of 5 g/L was used. A liquid temperature thereof was 35°C.

<First anodization treatment>

A first anodization treatment (surface layer anodization treatment) was performed by direct current electrolysis using an anodization device having a structure shown in Fig. 8. An anodic oxide film having a predetermined film thickness was formed by performing the anodization treatment under conditions shown in Table 1. A concentration of sulfuric acid in the first anodization treatment was 170 g/L.

An aluminum alloy plate 616 in an anodization treatment device 610 shown in Fig. 8 was transported as indicated by an arrow in Fig. 8. The aluminum alloy plate 616 was positively charged by a power supply electrode 620 in a power supply tank 612 in which an electrolytic solution 618 was stored. The aluminum alloy plate 616 was transported upward by a roller 622 in the power supply tank 612, redirected downward by a nip roller 624, transported toward an electrolytic treatment tank 614 in which the electrolytic solution 626 was stored, and redirected to the horizontal direction by a roller 628. Next, the aluminum alloy plate 616 was negatively charged by an electrolytic electrode 630 so that an anodic oxide film was formed on the surface thereof, and the aluminum alloy plate 616 coming out of the electrolytic treatment tank 614 was transported to the next step. In the anodization device 610, direction changing unit was formed of the roller 622, the nip roller 624, and the roller 628, and the aluminum alloy plate 616 was transported in a mountain shape and an inverted U shape by the roller 622, the nip roller 624, and the roller 628 in an inter-tank portion between the power supply tank 612 and the electrolytic treatment tank 614. The power supply electrode 620 and the electrolytic electrode 630 were connected to a DC power source 634. A tank wall 632 was disposed between the power supply tank 612 and the electrolytic treatment tank 614.

<Pore widening treatment>

The aluminum alloy plate subjected to the above-described anodization treatment was immersed in an aqueous solution of caustic soda, having a temperature of 40°C, a caustic soda concentration of 5% by mass, and an aluminum ion concentration of 0.5% by mass, and subjected to a pore widening treatment for a treatment time shown in Table 1. Thereafter, washing with water by spraying was performed.

<Second anodization treatment>

The aluminum alloy plate subjected to the above-described pore widening treatment was subjected to a second anodization treatment (underlayer anodization treatment) by direct current electrolysis using the anodization device having the structure shown in Fig. 8. An anodic oxide film having a predetermined film thickness was formed by performing the anodization treatment under conditions shown in Table 1 to manufacture a support 1. A concentration of sulfuric acid in the second anodization treatment was 170 g/L.

[Manufacturing Examples B2 to B20, B23, and B24, and Comparative Manufacturing Examples B1 to B3]

Each support was produced according to the same procedure as in Manufacturing Example B1, except that each aluminum alloy plate shown in Table 1 was used instead of the aluminum alloy plate 1, and the conditions of the alkali etching treatment (2), the conditions of the anodization treatment, and/or the conditions of the pore widening treatment in Manufacturing Example B1 were changed to the conditions shown in Table 1.

[Manufacturing Example B21]

The alkali etching treatment (1), the desmutting treatment (1), the hydrochloric acid electrolytic treatment, the alkali etching treatment (2), the desmutting treatment (2), the first anodization treatment (surface layer anodization treatment), and the pore widening treatment were performed according to the same procedure as in Manufacturing Example B1, except that the conditions of the alkali etching treatment (2), the conditions of the anodization treatment, and/or the conditions of the pore widening treatment were changed to the conditions shown in Table 1.

<Interlayer anodization treatment (1)>

The aluminum alloy plate subjected to the above-described pore widening treatment was subjected to an interlayer anodization treatment by direct current electrolysis using the anodization device having the structure shown in Fig. 8. An anodic oxide film having a predetermined film thickness was formed by performing the anodization treatment under conditions shown in Table 1.

The aluminum alloy plate subjected to the above-described interlayer anodization treatment (1) was subjected to a second anodization treatment (underlayer anodization treatment) under the conditions shown in Table 1 by direct current electrolysis using the anodization device having the structure shown in Fig. 8, thereby forming an anodic oxide film having a predetermined film thickness to manufacture a support 21.

Micropores composed of upper hole portions, middle hole portions, and small-diameter hole portions were formed in the anodic oxide film of the support 21.

[Manufacturing Example B22]

The alkali etching treatment (1), the desmutting treatment (1), the hydrochloric acid electrolytic treatment, the alkali etching treatment (2), the desmutting treatment (2), the first anodization treatment (surface layer anodization treatment), the pore widening treatment, and the interlayer anodization treatment were performed according to the same procedure as in Manufacturing Example B21, except that the conditions of the alkali etching treatment (2), the conditions of the anodization treatment, and/or the conditions of the pore widening treatment were changed to the conditions shown in Table 1.

<Interlayer anodization treatment (2)>

The aluminum alloy plate subjected to the above-described interlayer anodization treatment (1) was subjected to a second interlayer anodization treatment by direct current electrolysis using the anodization device having the structure shown in Fig. 8. An anodic oxide film having a predetermined film thickness was formed by performing the anodization treatment under conditions shown in Table 1.

The aluminum alloy plate subjected to the above-described interlayer anodization treatment (2) was subjected to a second anodization treatment (underlayer anodization treatment) under the conditions shown in Table 1 by direct current electrolysis using the anodization device having the structure shown in Fig. 8, thereby forming an anodic oxide film having a predetermined film thickness to manufacture a support 22.

Micropores composed of upper hole portions, middle hole portions having a two-stage structure, and small-diameter hole portions were formed in the anodic oxide film of the support 22.

For the supports 1 to 24 manufactured in Manufacturing Examples B1 to B24 and the supports C1 to C3 manufactured in Comparative Manufacturing Examples B1 to B3, a density of the specific intermetallic compounds and physical properties of the anodic oxide film were measured by the above-described methods. The measurement results are summarized in Table 2.

In the tables, regarding the supports 21 and 22, the column of "Average diameter" and the column of "Depth" in the column of "Large-diameter hole portion" each indicate the average diameter and the depth of "Upper hole portion" on the film surface; and the column of "Average diameter" and the column of "Depth" in the column of "Small-diameter hole portion" each indicate the average diameter and the depth of "Lower hole portion" at a communicate position with the middle hole portion.

In the tables, regarding the support 21, the column of "Maximum diameter (1)" in the column of "Middle hole portion" indicates the maximum value of the inner diameter of the middle hole portion.

In the tables, regarding the support 22, the column of "Maximum diameter (1)" in the column of "Middle hole portion" indicates the maximum value of the inner diameter of the first middle hole portion, and the column of "Maximum diameter (2)" indicates the maximum value of the inner diameter of the second middle hole portion.

[Table 1]

| | Support | Al alloy plate | Alkali etching treatment (1) | Electrochemical roughening treatment | | | Alkali etching treatment (2) | First anodization treatment | | | | Pore widening treatment | Interlayer anodization treatment (1) | | | | Interlayer anodization treatment (2) | | | | Second anodization treatment | | | |
|---|---|---|---|---|---|---|---|---|---|---|---|---|---|---|---|---|---|---|---|---|---|---|---|---|
| | No. | No. | (g/m²) | Concentration of sulfuric acid (g/L) | Liquid temperature (°C) | Electric quantity (c/dm²) | (g/m²) | Electrolytic solution | Liquid temperature (°C) | Current density (A/dm²) | Electric quantity (c/dm²) | Treatment time (sec) | Electrolytic solution | Liquid temperature (°C) | Current density (A/dm²) | Electric quantity (c/dm²) | Electrolytic solution | Liquid temperature (°C) | Current density (A/dm²) | Electric quantity (c/dm²) | Electrolytic solution | Liquid temperature (°C) | Current density (A/dm²) | Electric quantity (c/dm²) |
| Manufacturing Example B1 | 1 | 1 | 5 | 13 | 25 | 300 | 0.1 | Sulfuric acid | 40 | 20 | 45 | 3 | - | - | - | - | - | - | - | - | Sulfuric acid | 40 | 20 | 600 |
| Manufacturing Example B2 | 2 | 2 | 5 | 13 | 25 | 300 | 0.1 | Sulfuric acid | 40 | 20 | 45 | 3 | - | - | - | - | - | - | - | - | Sulfuric acid | 40 | 20 | 600 |
| Manufacturing Example B3 | 3 | 3 | 5 | 13 | 25 | 300 | 0.1 | Sulfuric acid | 40 | 20 | 45 | 3 | - | - | - | - | - | - | - | - | Sulfuric acid | 40 | 20 | 600 |
| Manufacturing Example B4 | 4 | 4 | 5 | 11 | 25 | 300 | 0.1 | Sulfuric acid | 40 | 20 | 45 | 3 | - | - | - | - | - | - | - | - | Sulfuric acid | 40 | 20 | 600 |
| Manufacturing Example B5 | 5 | 5 | 5 | 9 | 25 | 300 | 0.1 | Sulfuric acid | 40 | 20 | 45 | 3 | - | - | - | - | - | - | - | - | Sulfuric acid | 40 | 20 | 600 |
| Manufacturing Example B6 | 6 | 6 | 5 | 7 | 25 | 300 | 0.1 | Sulfuric acid | 40 | 20 | 45 | 3 | - | - | - | - | - | - | - | - | Sulfuric acid | 40 | 20 | 600 |
| Manufacturing Example B7 | 7 | 7 | 5 | 13 | 25 | 300 | 0.15 | Sulfuric acid | 40 | 20 | 45 | 3 | - | - | - | - | - | - | - | - | Sulfuric acid | 40 | 20 | 600 |
| Manufacturing Example B8 | 8 | 8 | 5 | 13 | 25 | 300 | 0.25 | Sulfuric acid | 40 | 20 | 45 | 3 | - | - | - | - | - | - | - | - | Sulfuric acid | 40 | 20 | 600 |
| Manufacturing Example B9 | 9 | 9 | 5 | 13 | 25 | 300 | 0.3 | Sulfuric acid | 40 | 20 | 45 | 3 | - | - | - | - | - | - | - | - | Sulfuric acid | 40 | 20 | 600 |
| Manufacturing Example B10 | 10 | 1 | 5 | 13 | 25 | 300 | 0.1 | Sulfuric acid | 40 | 20 | 45 | 2.5 | - | - | - | - | - | - | - | - | Sulfuric acid | 40 | 20 | 600 |
| Manufacturing Example B11 | 11 | 1 | 5 | 13 | 25 | 300 | 0.1 | Sulfuric acid | 40 | 20 | 45 | 1 | - | - | - | - | - | - | - | - | Sulfuric acid | 40 | 20 | 600 |
| Manufacturing Example B12 | 12 | 1 | 5 | 13 | 25 | 300 | 0.08 | Sulfuric acid | 40 | 20 | 45 | 3 | - | - | - | - | - | - | - | - | Sulfuric acid | 40 | 20 | 600 |
| Manufacturing Example B13 | 13 | 1 | 5 | 13 | 25 | 300 | 0.03 | Sulfuric acid | 40 | 20 | 45 | 3 | - | - | - | - | - | - | - | - | Sulfuric acid | 40 | 20 | 600 |
| Manufacturing Example B14 | 14 | 1 | 5 | 13 | 25 | 300 | 0.1 | Sulfuric acid | 40 | 20 | 80 | 3 | - | - | - | - | - | - | - | - | Sulfuric acid | 40 | 20 | 600 |
| Manufacturing Example B15 | 15 | 1 | 5 | 13 | 25 | 300 | 0.1 | Sulfuric acid | 40 | 20 | 112 | 3 | - | - | - | - | - | - | - | - | Sulfuric acid | 40 | 20 | 600 |
| Manufacturing Example B16 | 16 | 1 | 5 | 13 | 25 | 300 | 0.1 | Sulfuric acid | 40 | 20 | 23 | 3 | - | - | - | - | - | - | - | - | Sulfuric acid | 40 | 20 | 600 |
| Manufacturing Example B17 | 17 | 1 | 5 | 13 | 25 | 300 | 0.1 | Sulfuric acid | 40 | 20 | 12 | 3 | - | - | - | - | - | - | - | - | Sulfuric acid | 40 | 20 | 600 |
| Manufacturing Example B18 | 18 | 1 | 5 | 13 | 25 | 300 | 0.1 | Sulfuric acid | 40 | 20 | 45 | 3 | - | - | - | - | - | - | - | - | Sulfuric acid | 40 | 20 | 300 |
| Manufacturing Example B19 | 19 | 1 | 5 | 13 | 25 | 300 | 0.1 | Sulfuric acid | 40 | 20 | 45 | 3 | - | - | - | - | - | - | - | - | Sulfuric acid | 40 | 20 | 150 |
| Manufacturing Example B20 | 20 | 1 | 5 | 13 | 25 | 300 | 0.1 | Sulfuric acid | 40 | 20 | 45 | 3 | - | - | - | - | - | - | - | - | Sulfuric acid | 40 | 20 | 115 |
| Manufacturing Example B21 | 21 | 1 | 5 | 13 | 25 | 300 | 0.1 | Sulfuric acid | 40 | 20 | 45 | 3 | Phosphoric acid | 180 | 10 | 200 | - | - | - | - | Sulfuric acid | 40 | 20 | 600 |
| Manufacturing Example B22 | 22 | 1 | 5 | 13 | 25 | 300 | 0.1 | Sulfuric acid | 40 | 20 | 45 | 3 | Phosphoric acid | 180 | 10 | 200 | Phosphoric acid | 180 | 30 | 300 | Sulfuric acid | 40 | 20 | 600 |
| Manufacturing Example B23 | 23 | 1 | 5 | 13 | 25 | 300 | 0.1 | Sulfuric acid | 40 | 30 | 45 | 3 | - | - | - | - | - | - | - | - | Sulfuric acid | 40 | 20 | 600 |
| Manufacturing Example B24 | 24 | 1 | 5 | 13 | 25 | 300 | 0.1 | Sulfuric acid | 40 | 50 | 45 | 3 | - | - | - | - | - | - | - | - | Sulfuric acid | 40 | 20 | 600 |
| Comparative Manufacturing Example B1 | C1 | C1 | 5 | 13 | 25 | 300 | 0.1 | Sulfuric acid | 40 | 20 | 45 | 3 | - | - | - | - | - | - | - | - | Sulfuric acid | 40 | 20 | 600 |
| Comparative Manufacturing Example B2 | C2 | C2 | 5 | 13 | 25 | 300 | 0.1 | Sulfuric acid | 40 | 20 | 45 | 3 | - | - | - | - | - | - | - | - | Sulfuric acid | 40 | 20 | 600 |
| Comparative Manufacturing Example B3 | C3 | C3 | 5 | 13 | 25 | 300 | 0.1 | Sulfuric acid | 40 | 20 | 45 | 3 | - | - | - | - | - | - | - | - | Sulfuric acid | 40 | 20 | 600 |

[Table 2]

| | Support No. | Density of specific intermetallic compound (pieces/mm$^2$) | Anodic oxide film | | | | | | | | | | |
|---|---|---|---|---|---|---|---|---|---|---|---|---|---|
| | | | Density of specific recessed portions (pieces/mm$^2$) | Surface r area ratio ΔS (%) | Large-diameter hole portion | | | | Middle hole portion | | | Small-diameter hole portion | |
| | | | | | Average diameter (nm) | Density (pieces/μm$^2$) | Opening ratio (%) | Depth (nm) | Number of steps | Maximum diameter (1) (nm) | Maximum diameter (2) (nm) | Average diameter (nm) | Depth (nm) |
| Manufacturing Example B1 | 1 | 0 | 6800 | 50 | 30 | 900 | 63.5 | 100 | - | - | - | 10 | 1300 |
| Manufacturing Example B2 | 2 | 10 | 6800 | 50 | 26 | 900 | 47.8 | 160 | - | - | - | 10 | 1300 |
| Manufacturing Example B3 | 3 | 15 | 6800 | 50 | 26 | 900 | 47.8 | 160 | - | - | - | 10 | 1300 |
| Manufacturing Example B4 | 4 | 75 | 4650 | 48 | 30 | 900 | 63.5 | 100 | - | - | - | 10 | 1300 |
| Manufacturing Example B5 | 5 | 400 | 3300 | 43 | 30 | 900 | 63.5 | 100 | - | - | - | 10 | 1300 |
| Manufacturing Example B6 | 6 | 950 | 2800 | 41 | 30 | 900 | 63.5 | 100 | - | - | - | 10 | 1300 |
| Manufacturing Example B7 | 7 | 800 | 3100 | 38 | 30 | 900 | 63.5 | 100 | - | - | - | 10 | 1300 |
| Manufacturing Example B8 | 8 | 180 | 3700 | 26 | 30 | 900 | 63.5 | 100 | - | - | - | 10 | 1300 |
| Manufacturing Example B9 | 9 | 160 | 3700 | 23 | 30 | 900 | 63.5 | 100 | - | - | - | 10 | 1300 |
| Manufacturing Example B10 | 10 | 0 | 6800 | 50 | 26 | 900 | 47.8 | 100 | - | - | - | 10 | 1300 |
| Manufacturing Example B11 | 11 | 0 | 6800 | 50 | 14 | 900 | 13.8 | 100 | - | - | - | 10 | 1300 |
| Manufacturing Example B12 | 12 | 0 | 6800 | 57 | 30 | 900 | 63.5 | 100 | - | - | - | 10 | 1300 |
| Manufacturing Example B13 | 13 | 0 | 6800 | 63 | 42 | 900 | 63.5 | 100 | - | - | - | 10 | 1300 |

(continued)

| | Support No. | Density of specific intermetallic compound (pieces/mm$^2$) | Anodic oxide film | | | | | | | | | | |
|---|---|---|---|---|---|---|---|---|---|---|---|---|---|
| | | | Density of specific recessed portions (pieces/mm$^2$) | Surface r area ratio ΔS (%) | Large-diameter hole portion | | | | Middle hole portion | | | Small-diameter hole portion | |
| | | | | | Average diameter (nm) | Density (pieces/μm$^2$) | Opening ratio (%) | Depth (nm) | Number of steps | Maximum diameter (1) (nm) | Maximum diameter (2) (nm) | Average diameter (nm) | Depth (nm) |
| Manufacturing Example B14 | 14 | 0 | 6800 | 50 | 30 | 900 | 63.5 | 180 | - | - | - | 10 | 1300 |
| Manufacturing Example B15 | 15 | 0 | 6800 | 50 | 30 | 900 | 63.5 | 250 | - | - | - | 10 | 1300 |
| Manufacturing Example B16 | 16 | 0 | 6800 | 50 | 30 | 900 | 63.5 | 50 | - | - | - | 10 | 1300 |
| Manufacturing Example B17 | 17 | 0 | 6800 | 50 | 30 | 900 | 63.5 | 25 | - | - | - | 10 | 1300 |
| Manufacturing Example B18 | 18 | 0 | 6800 | 50 | 30 | 900 | 63.5 | 100 | - | - | - | 10 | 750 |
| Manufacturing Example B19 | 19 | 0 | 6800 | 50 | 30 | 900 | 63.5 | 100 | - | - | - | 10 | 330 |
| Manufacturing Example B20 | 20 | 0 | 6800 | 50 | 30 | 900 | 63.5 | 100 | - | - | - | 10 | 250 |
| Manufacturing Example B21 | 21 | 0 | 6800 | 50 | 30 | 900 | 63.5 | 100 | 1 | 50 | - | 10 | 750 |
| Manufacturing Example B22 | 22 | 0 | 6800 | 50 | 30 | 900 | 63.5 | 100 | 2 | 50 | 80 | 10 | 750 |
| Manufacturing Example B23 | 23 | 0 | 6800 | 50 | 30 | 480 | 33.9 | 100 | - | - | - | 10 | 1300 |
| Manufacturing Example B24 | 24 | 0 | 6800 | 50 | 30 | 390 | 27.6 | 100 | - | - | - | 10 | 1300 |
| Comparative Manufacturing Example B1 | C1 | 2100 | 2800 | 45 | 30 | 900 | 63.5 | 100 | - | - | - | 10 | 1300 |

(continued)

| | Support No. | Density of specific intermetallic compound (pieces/mm$^2$) | Anodic oxide film | | | | | | | | | | | |
|---|---|---|---|---|---|---|---|---|---|---|---|---|---|---|
| | | | Density of specific recessed portions (pieces/mm$^2$) | Surface r area ratio ΔS (%) | Large-diameter hole portion | | | | Middle hole portion | | | Small-diameter hole portion | |
| | | | | | Average diameter (nm) | Density (pieces/μm$^2$) | Opening ratio (%) | Depth (nm) | Number of steps | Maximum diameter (1) (nm) | Maximum diameter (2) (nm) | Average diameter (nm) | Depth (nm) |
| Comparative Manufacturing Example B2 | C2 | 1780 | 2350 | 45 | 30 | 900 | 63.5 | 100 | - | - | - | 10 | 1300 |
| Comparative Manufacturing Example B3 | C3 | 1100 | 3300 | 45 | 30 | 900 | 63.5 | 100 | - | - | - | 10 | 1300 |

[Preparation of coating liquid for undercoat layer]

The following components were mixed to prepare each of coating liquids 1 to 4 for an undercoat layer, used for forming an undercoat layer.

(Coating liquid 1 for undercoat layer)

· Polyacrylic acid aqueous solution (40% by mass, "Jurymer AC-10S" manufactured by TOAGOSEI CO., LTD.): 3.0 parts

· Water: 27.0 parts

(Coating liquid 2 for undercoat layer)

. Compound (U-1) for undercoat layer, represented by the following structural formula (11% by mass aqueous solution): 0.1050 parts
· Sodium gluconate: 0.0700 parts
· Surfactant (EMALEX (registered trademark) 710, manufactured by Nihon Emulsion Co., Ltd.): 0.0016 parts
· Preservative (BIOHOPE L, K·I Chemical Industry Co., LTD.): 0.0015 parts
· Water: 3.2900 parts

(U-1)

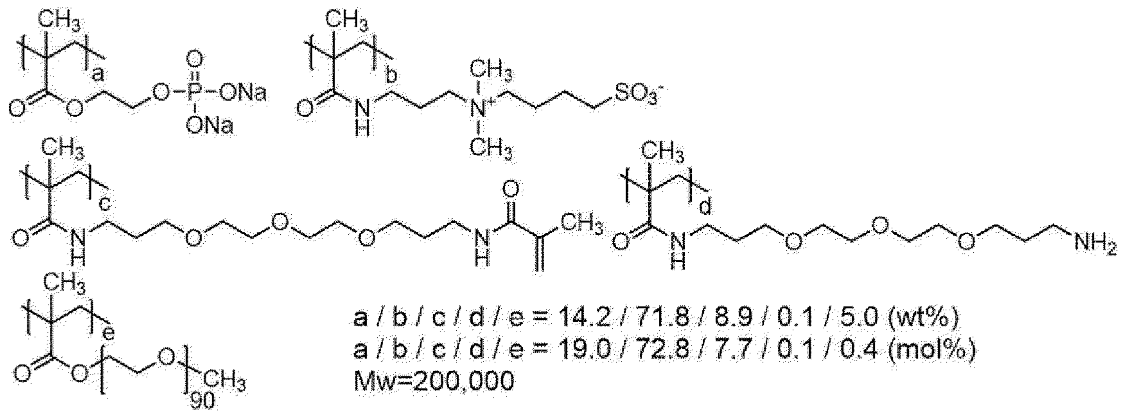

a / b / c / d / e = 14.2 / 71.8 / 8.9 / 0.1 / 5.0 (wt%)
a / b / c / d / e = 19.0 / 72.8 / 7.7 / 0.1 / 0.4 (mol%)
Mw=200,000

(Coating liquid 3 for undercoat layer)

· Compound (U-1) for undercoat layer (11% by mass aqueous solution): 0.1050 parts
· Sodium gluconate: 0.0700 parts
· Sipomer PAM-100 (Solvay): 0.0058 parts
· Surfactant (EMALEX 710, manufactured by Nihon Emulsion Co., Ltd.): 0.0016 parts
· Preservative (BIOHOPE L, manufactured by K·I Chemical Industry Co., LTD.): 0.0015 parts
· Water: 3.2900 parts

(Coating liquid 4 for undercoat layer)

· Compound (U-2) for undercoat layer (vinylphosphonic acid/acrylamide copolymer (molar ratio: 1:9)): 0.3200 parts
· Sipomer PAM-100 (Solvay): 0.0970 parts

· Surfactant (EMALEX 710, manufactured by Nihon Emulsion Co., Ltd.): 0.0016 parts
· Preservative (BIOHOPE L, manufactured by K·I Chemical Industry Co., LTD.): 0.0015 parts
· Water: 3.2900 parts

The compound (U-2) for an undercoat layer was synthesized by the following method.

3500 g of ethanol was charged into a 10 liter flask equipped with a stirrer, a condenser, and a dropping device, and then heated to 70°C. Next, 231.1 g (2.14 mol) of a vinylphosphonic acid monomer, 1368.9 g (19.26 mol) of acrylamide, and 52 g of AIBN were dissolved in 1000 g of ethanol, and this solution was added dropwise to the reaction apparatus over 4 hours. A white precipitate was generated during the dropwise addition of the monomer solution. After heating and stirring for 2 hours while maintaining the temperature at 70°C, the heating was stopped, and the reaction solution was cooled to room temperature. The generated precipitate was collected by decompression filtration and washed with 1000 g of ethanol. The precipitate was vacuum-dried at 40°C for 24 hours to obtain white microcrystals (yield: 1,550 g).

[Preparation of coating liquid for image-recording layer]

The following components were used in preparation of a coating liquid for forming an image-recording layer, used for forming an image-recording layer.

(Acid color-forming agent)

As an acid color-forming agent, the above-described compounds S-1 to S-20 and the following compounds S-C1 and S-C2 were used.

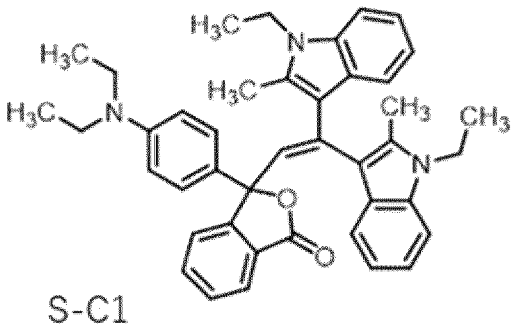

S-C1

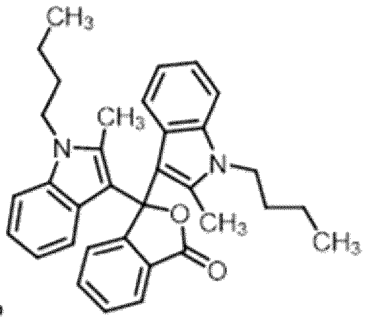

S-C2

The absorption maximal wavelength λmax (nm), the color-forming factor ($L\cdot mol^{-1}\cdot cm^{-1}$), and the molecular weight of the compound used as the acid color-forming agent in Examples and Comparative Examples are shown in Table 3 later. The absorption maximal wavelength λmax and the color-forming factor of the acid color-forming agent were measured by the above-described methods.

In addition, regarding the compounds S-2, S-5, and S-6, there are two peaks showing the absorption maximal wavelength λmax in a visible light range (380 to 750 nm), and Table 3 later shows the absorption maximal wavelength λmax and the color-forming factor of each peak.

(Infrared absorber)

The following compounds IR-1 to IR-9 were used as an infrared absorber.

The structural formulae and the energy levels of the lowest unoccupied molecular orbitals (LUMO) of the compounds IR-1 to IR-9 are shown below.

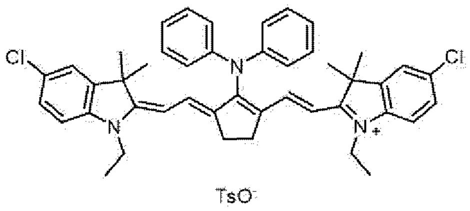

**IR-1**

LUMO = -3.75 ev

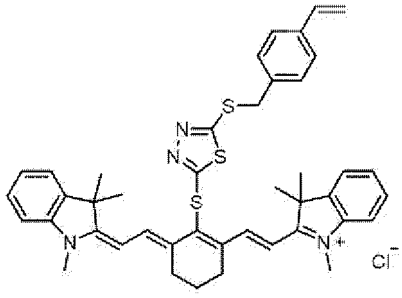

**IR-2**

LUMO = -3.82 ev

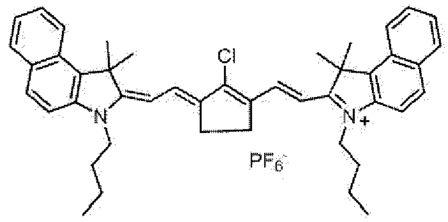

**IR-3**

LUMO = -3.78 ev

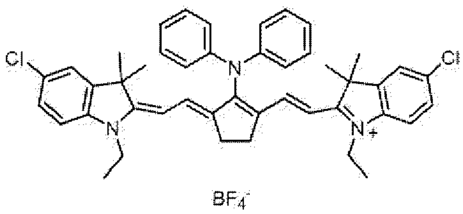

**IR-4**

LUMO = -3.75 ev

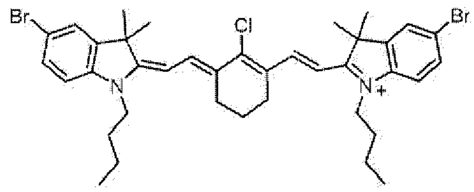

**IR-5**

LUMO = -3.85 ev

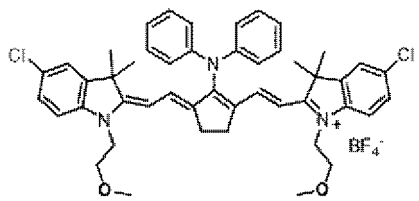

**IR-6**

LUMO = -3.75eV

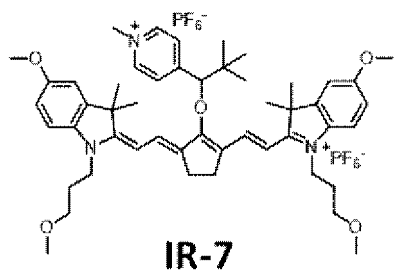

**IR-7**

LUMO = -3.70eV

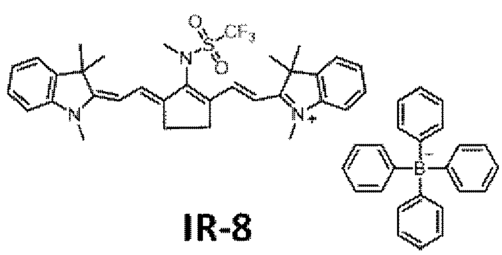

**IR-8**

LUMO = -3.82eV

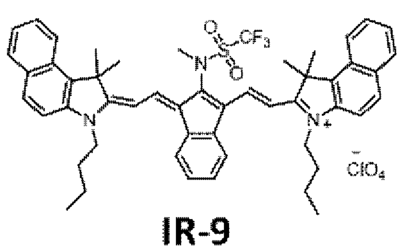

**IR-9**

LUMO = -3.84eV

(Polymerization initiator)

The following compounds I-1 to i-3 and B-1 were used as a polymerization initiator. An iodonium ion of the compound I-1, an iodonium ion of the compound I-2, and the compound I-3 are electron-accepting polymerization initiators, and a borate compound of the compound I-1 and the compound B-1 are electron-donating polymerization initiators.

The structural formulae and energy levels of the lowest unoccupied molecular orbitals (LUMO) of the respective polymerization initiators are shown below.

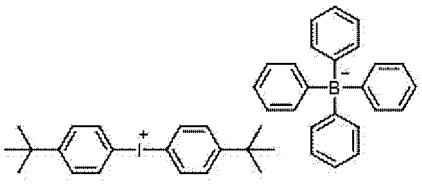

I-1

LUMO = -3.25 ev

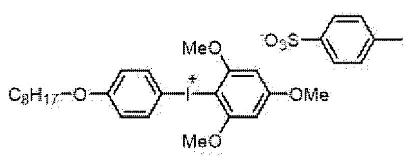

I-2

LUMO = -3.08 ev

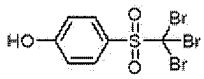

I-3

LUMO = -3.18 ev

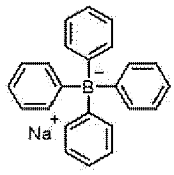

B-1

LUMO = -1.39 ev

(Polymerizable compound)

The following compounds M-1 to M-5 were used as a polymerizable compound.

- · M-1: urethane acrylate (40% 2-butanone solution) obtained by reacting DESMODUR (registered trademark) N100 (manufactured by Bayer AG), hydroxyethyl acrylate, and pentaerythritol triacrylate at a molar ratio of 1:1.5:1.5
- · M-2: 2-ethoxylate (10-ethylene oxide) bisphenol A acrylate (40% 2-butanone solution)
- · M-3: urethane acrylate (80% 2-butanone solution) obtained by reacting DESMODUR (registered trademark) N100 (manufactured by Bayer AG), hydroxyethyl acrylate, and pentaerythritol triacrylate at a molar ratio of 1:1.5:1.5
- · M-4: compound represented by the following structural formula
- · M-5: compound represented by the following structural formula

M-4 :

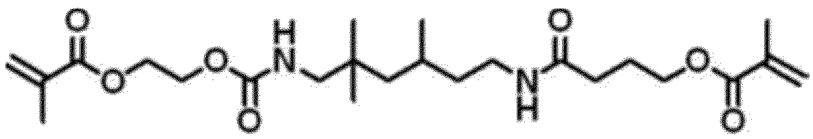

M-5 :

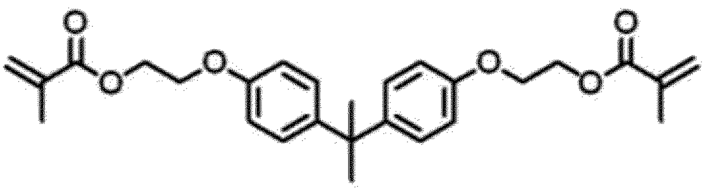

(Polymer particles)

The following polymer particles PP-1 to PP-3 were used as polymer particles.

-Polymer particles PP-1-

As the polymer particles PP-1, a polymer emulsion containing 24% of polymer particles of a graft copolymer of poly(ethylene glycol) methyl ether methacrylate/styrene/acrylonitrile = 10:9:81 in a mixed solvent in which a mass ratio of n-propanol/water was 80/20 was used. A volume average particle diameter of the polymer particles PP-1 was 193 nm.

-Polymer particles PP-2-

As the polymer particles PP-2, a microgel liquid containing the following components was used.

· Microgel (polymer particles PP-2): 2.640 parts
· Distilled water: 2.425 parts

The microgel used in the above-described microgel liquid was prepared by the following method.

-Preparation of polyvalent isocyanate compound-

0.043 parts of bismuth tris(2-ethylhexanoate) (NEOSTANN U-600, manufactured by NITTO KASEI CO., LTD.) was added to an ethyl acetate (25.31 parts) suspension solution of 17.78 parts (80 molar equivalent) of isophorone diisocyanate and 7.35 parts (20 molar equivalent) of a polyhydric phenol compound (1) represented by the following structural formula, and the mixture was stirred. The reaction temperature was set to 50°C immediately before a timing of heat generation being subsided, and the mixture was stirred for 3 hours, thereby obtaining an ethyl acetate solution (50% by mass) of a polyvalent isocyanate compound (1).

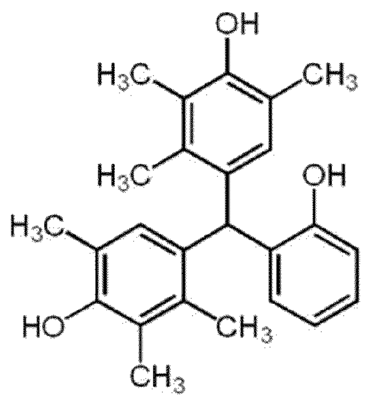

Polyhydric phenol compound (1)

-Preparation of microgel-

The following oil phase components and the water phase component were mixed with each other and emulsified at 12,000 rpm for 10 minutes using a homogenizer. The obtained emulsion was stirred at 45°C for 4 hours, 5.20 g of a 10% aqueous solution of 1,8-diazabicyclo[5.4.0]undeca-7-ene-octylate (U-CAT SA102, manufactured by San-Apro Ltd.) was added thereto, and the mixture was stirred at room temperature for 30 minutes and allowed to stand at 45°C for 24 hours. Distilled water was added thereto such that the concentration of solid contents was adjusted to 20% by mass, thereby obtaining an aqueous dispersion liquid of a microgel (1). In a case where an average particle diameter thereof was measured by a light scattering method, it was 0.28 μm.

~Oil-phase component~

(Component 1) Ethyl acetate: 12.0 parts

(Component 2) Adduct (50% by mass of ethyl acetate solution, manufactured by Mitsui Chemicals, Inc.) obtained by adding trimethylolpropane (6 mol equivalent) and xylene diisocyanate (18 mol equivalent) and adding one-terminal methylated polyoxyethylene (1 mol equivalent, repetition number of oxyethylene units: 90) thereto: 3.76 parts
(Component 3) Polyvalent isocyanate compound (1) (as 50% by mass of ethyl acetate solution): 15.0 parts
(Component 4) 65% by mass of solution of dipentaerythritol pentaacrylate (SR-399, manufactured by Sartomer Japan Inc.) in ethyl acetate: 11.54 parts
(Component 5) 10% solution of sulfonate type surfactant (PIONINE A-41-C, manufactured by TAKEMOTO OIL & FAT Co., Ltd.) in ethyl acetate: 4.42 parts

~Water-phase component~

· Distilled water: 46.87 parts

-Polymer particles PP-3-

The polymer particles PP-3 were prepared by the following method.

A polyfunctional isocyanate compound (PM-200: manufactured by Wanhua Chemical Group Co.,Ltd.): 6.66 parts, a 50% by mass ethyl acetate solution of "TAKENATE (registered trademark) D-116N (adduct of trimethylolpropane, m-xylylene diisocyanate, and polyethylene glycol monomethyl ether (E090) (following structure)" manufactured by Mitsui Chemicals, Inc.: 5.46 parts, a 65% by mass ethyl acetate solution of dipentaerythritol pentaacrylate (SR-399, manufactured by Sartomer Company Inc., represented by the following M-2): 11.53 parts, ethyl acetate: 18.66 parts, and PIONIN (registered trademark) A-41-C manufactured by TAKEMOTO OIL & FAT Co.,Ltd.: 0.45 parts were mixed together and stirred at room temperature (25°C) for 15 minutes, thereby obtaining an oil-phase component.

As a water-phase component, 46.89 parts of pure water was added to the obtained oil-phase component and mixed together, and the obtained mixture was emulsified at 12,000 rpm for 12 minutes by using a homogenizer, thereby obtaining an emulsion.

The obtained emulsion was added to 16.66 parts of distilled water, and stirred, and the obtained liquid was heated to 45°C, and stirred for 4 hours in a state of being kept at 45°C so that ethyl acetate was distilled away from the liquid. Next, the liquid from which ethyl acetate was distilled off was heated to 45°C and stirred for 48 hours in a state of being kept at 45°C, thereby obtaining microcapsule-type encapsulated polymer particles PP-3 made of a polyaddition type resin. Thereafter, the liquid containing the encapsulated polymer particles PP-3 was diluted with distilled water so that the concentration of solid contents was 20% by mass, thereby obtaining an aqueous dispersion of encapsulated polymer particles PP-3.

In a case where a volume average particle diameter of the encapsulated polymer particles PP-3 was measured using a laser diffraction/scattering-type particle size distribution analyzer LA-920 (manufactured by HORIBA, Ltd.), it was 200 nm. A content of the polymerizable compound M-2 with respect to the total mass of the encapsulated polymer particles PP-3 was 42% by mass.

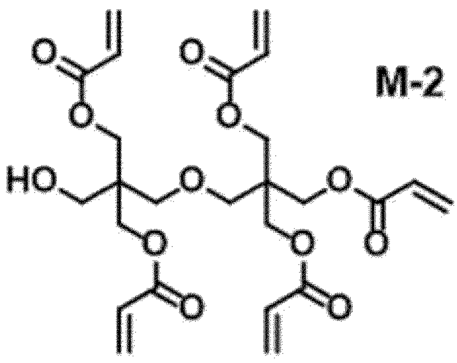

M-2

(Binder polymer)

The following polymer BP-1 was used as a binder polymer.

· BP-1: polyvinyl acetal ("S-LEC BL10" manufactured by SEKISUI CHEMICAL CO., LTD.)

(Hydrophilic compound)

The following compounds H-1 and H-2 were used as a hydrophilic compound.

· H-1: hydroxypropyl methyl cellulose (5% aqueous solution) in which 30% thereof was methoxylated and 10% thereof was hydroxypropoxylated; a viscosity of a 2% by mass aqueous solution of the compound H-1 at 20°C was 5 mPa·s.
· H-2: compound represented by the following structural formula

H-2 :

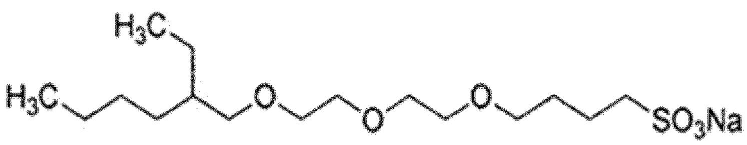

(Hydrophilic compound)

The following compound P-1 was used as a hydrophobic compound.

· P-1: phenothiazine
· P-2: tricresyl phosphate

(Surfactant)

The following compounds S-1 and S-2 were used as a surfactant.

· W-1: xylene/methoxy propyl acetate solution containing 25% by mass of modified polydimethylsiloxane copolymer (manufactured by BYK-Chemie GmbH, "BYK336")
· W-2: compound represented by the following structural formula

W-2 :

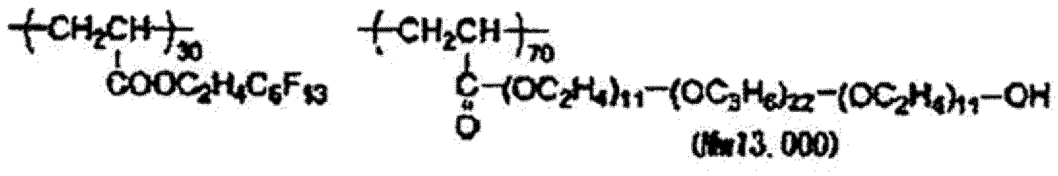

<Preparation of coating liquid A-1>

The acid color-forming agent S-4, the infrared absorber IR-1, the polymerization initiator I-1, the polymerizable compounds M-1 and M-2, the polymer particles PP-1, the hydrophilic compound H-1, the surfactant S-1, and a mixed solvent of 1-methoxy-2-propanol:methyl ethyl ketone:methanol = 4:4:1 (mass ratio) were mixed with each other to prepare a coating liquid A-1.
Table 3 later shows the content (addition amount) of each component other than the mixed solvent, contained in the coating liquid A-1. In addition, in each of Examples and Comparative Examples, in a case of preparing each coating liquid including the coating liquid A-1, the amount of the above-described mixed solvent was adjusted such that the content of solid contents was 6% by mass.

<Preparation of coating liquids A-2 to A-38 and coating liquids A-C1 to A-C3>

Coating liquids A-2 to A-38 and A-C1 to A-C3 were prepared in the same manner as in the coating liquid A-1, except that the type and content (addition amount) of the components used for preparing the coating liquid were changed so as to have the formulation shown in Table 3 later.
Table 3 shows the formulations of the coating liquids A-2 to A-38 and the coating liquids A-C1 to A-C3 used for forming the image-recording layer.
In the table, the column of "Acid color-forming agent/polymerization initiator" indicates the molar ratio of the

content of the polymerization initiator to the content of the acid color-forming agent in each coating liquid.

In the table, "Specific energy difference" indicates a value (unit: eV) obtained by subtracting the lowest unoccupied molecular orbital (LUMO) of the infrared absorber from the lowest unoccupied molecular orbital (LUMO) of the electron-accepting polymerization initiator in the coating liquid containing the electron-accepting polymerization initiator and the infrared absorber.

[Table 3]

| Table 3 (1) | Formulation | | | | | | | | | | | | | |
|---|---|---|---|---|---|---|---|---|---|---|---|---|---|---|
| | Acid color-forming agent | | | | | Infrared absorber | | | | | | | | |
| | Type | λmax | Color-forming factor | Molecular weight | Content | IR-1 | IR-2 | IR-3 | IR-4 | IR-5 | IR-6 | IR-7 | IR-8 | IR-9 |
| | | nm | L/(mol·cm) | g/mol | Part by mass | Part by mass | Part by mass | Part by mass | Part by mass | Part by mass | Part by mass | Part by mass | Part by mass | Part by mass |
| Coating liquid A-1 Coating liquid A-1 | S-4 | 590 | 42920 | 481.64 | 0.025 | 0.020 | | | | | | | | |
| Coating liquid A-2 | S-1 | 590 | 51000 | 782.89 | 0.025 | 0.020 | | | | | | | | |
| Coating liquid A-3 | S-2 | a) 450<br>b) 590 | a) 24320<br>b) 15200 | 518.66 | 0.025 | 0.020 | | | | | | | | |
| Coating liquid A-4 | S-3 | 620 | 30100 | 486.62 | 0.025 | 0.020 | | | | | | | | |
| Coating liquid A-5 | S-5 | a) 450<br>b) 590 | a) 24320<br>b) 15200 | 504.63 | 0.025 | 0.020 | | | | | | | | |
| Coating liquid A-6 | S-6 | a) 450<br>b) 590 | a) 24320<br>b) 15200 | 476.58 | 0.025 | 0.020 | | | | | | | | |
| Coating liquid A-7 | S-7 | 570 | 60160 | 482.54 | 0.025 | 0.020 | | | | | | | | |
| Coating liquid A-8 | S-8 | 570 | 79900 | 510.59 | 0.025 | 0.020 | | | | | | | | |
| Coating liquid A-9 | S-9 | 549 | 80240 | 570.65 | 0.025 | 0.020 | | | | | | | | |
| Coating liquid A-10 | S-10 | 550 | 52948 | 579.48 | 0.025 | 0.020 | | | | | | | | |
| Coating liquid A-11 | S-11 | 559 | 70778 | 600.72 | 0.025 | 0.020 | | | | | | | | |
| Coating liquid A-12 | S-12 | 552 | 48800 | 694.79 | 0.025 | 0.020 | | | | | | | | |

(continued)

| Table 3 (1) | Formulation | | | | | | | | | | | | | |
|---|---|---|---|---|---|---|---|---|---|---|---|---|---|---|
| | Acid color-forming agent | | | | | Infrared absorber | | | | | | | | |
| | Type | λmax | Color-forming factor | Molecular weight | Content | IR-1 | IR-2 | IR-3 | IR-4 | IR-5 | IR-6 | IR-7 | IR-8 | IR-9 |
| | | nm | L/(mol·cm) | g/mol | Part by mass | Part by mass | Part by mass | Part by mass | Part by mass | Part by mass | Part by mass | Part by mass | Part by mass | Part by mass |
| Coating liquid A-13 | S-13 | 580 | 50150 | 754.84 | 0.025 | 0.020 | | | | | | | | |
| Coating liquid A-14 | S-14 | 571 | 46150 | 690.84 | 0.025 | 0.020 | | | | | | | | |
| Coating liquid A-15 | S-15 | 554 | 52208 | 542.68 | 0.025 | 0.020 | | | | | | | | |
| Coating liquid A-16 | S-16 | 556 | 34200 | 570.65 | 0.025 | 0.020 | | | | | | | | |
| Coating liquid A-17 | S-17 | 568 | 30624 | 482.54 | 0.025 | 0.020 | | | | | | | | |
| Coating liquid A-18 | S-18 | 641 | 30750 | 518.66 | 0.025 | 0.020 | | | | | | | | |
| Coating liquid A-19 | S-19 | 444 | 53010 | 575.75 | 0.025 | 0.020 | | | | | | | | |
| Coating liquid A-20 | S-20 | 558 | 90000 | 442.56 | 0.025 | 0.020 | | | | | | | | |
| Coating liquid A-21 | S-4 | 590 | 42920 | 481.64 | 0.025 | 0.020 | | | | | | | | |
| Coating liquid A-22 | S-4 | 590 | 42920 | 481.64 | 0.025 | 0.020 | | | | | | | | |
| Coating liquid A-23 | S-4 | 590 | 42920 | 481.64 | 0.025 | 0.020 | | | | | | | | |
| Coating liquid A-24 | S-4 | 590 | 42920 | 481.64 | 0.025 | | 0.020 | | | | | | | |

(continued)

| Table 3 (1) | Formulation | | | | | | | | | | | | | |
|---|---|---|---|---|---|---|---|---|---|---|---|---|---|---|
| | Acid color-forming agent | | | | | Infrared absorber | | | | | | | | |
| | Type | λmax | Color-forming factor | Molecular weight | Content | IR-1 | IR-2 | IR-3 | IR-4 | IR-5 | IR-6 | IR-7 | IR-8 | IR-9 |
| | | nm | L/(mol·cm) | g/mol | Part by mass | Part by mass | Part by mass | Part by mass | Part by mass | Part by mass | Part by mass | Part by mass | Part by mass | Part by mass |
| Coating liquid A-25 | S-4 | 590 | 42920 | 481.64 | 0.025 | | | 0.020 | | | | | | |
| Coating liquid A-26 | S-4 | 590 | 42920 | 481.64 | 0.025 | | | | 0.020 | | | | | |
| Coating liquid A-27 | S-1 | 590 | 51000 | 782.89 | 0.025 | | | | 0.020 | | | | | |
| Coating liquid A-28 | S-2 | a) 450<br>b) 590 | a) 24320<br>b) 15200 | 518.66 | 0.025 | | | | 0.020 | | | | | |
| Coating liquid A-29 | S-7 | 570 | 60160 | 482.54 | 0.025 | | | | 0.020 | | | | | |
| Coating liauidA-30 | S-4 | 590 | 42920 | 481.64 | 0.025 | | | | 0.020 | | | | | |
| Coating liauidA-31 | S-4 | 590 | 42920 | 481.64 | 0.025 | | | | | 0.020 | | | | |
| Coating liquid A-32 | S-1 | 590 | 51000 | 782.89 | 0.025 | | | | | 0.020 | | | | |
| Coating liquid A-33 | S-2 | a) 450<br>b) 590 | a) 24320<br>b) 15200 | 518.66 | 0.025 | | | | | 0.020 | | | | |
| Coating liquid A-34 | S-7 | 570 | 60160 | 482.54 | 0.025 | | | | | 0.020 | | | | |
| Coating liquid A-35 | S-4 | 590 | 42920 | 481.64 | 0.025 | | | | | | 0.020 | | | |
| Coating liquid A-36 | S-4 | 590 | 42920 | 481.64 | 0.025 | | | | | | | 0.020 | | |

(continued)

| Table 3 (1) | Formulation | | | | | | | | | | | | | |
|---|---|---|---|---|---|---|---|---|---|---|---|---|---|---|
| | Acid color-forming agent | | | | | Infrared absorber | | | | | | | | |
| | Type | λmax | Color-forming factor | Molecular weight | Content | IR-1 | IR-2 | IR-3 | IR-4 | IR-5 | IR-6 | IR-7 | IR-8 | IR-9 |
| | | nm | L/(mol·cm) | g/mol | Part by mass | Part by mass | Part by mass | Part by mass | Part by mass | Part by mass | Part by mass | Part by mass | Part by mass | Part by mass |
| Coating liaui-dA-37 | S-4 | 590 | 42920 | 481.64 | 0.025 | | | | | | | | 0.020 | |
| Coating liquid A-38 | S-4 | 590 | 42920 | 481.64 | 0.025 | | | | | | | | | 0.020 |
| Coating liquid A-C1 | S-C1 | 670 | 17600 | 621.83 | 0.025 | | | | | | | | | |
| Coating liquid A-C2 | S-C2 | 530 | 19800 | 504.67 | 0.025 | | | | | | | | | |
| Coating liquid A-C3 | None | - | - | - | - | | | | | | | | | |

[Table 4]

| Table 3 (2) | Formulation | | | | | | | | | | | |
|---|---|---|---|---|---|---|---|---|---|---|---|---|
| | Polyrmarization initiator | | | | Polymerizable compound | | | | | Polymer particles | | |
| | I-1 | I-2 | I-3 | B-1 | M-1 | M-2 | M-3 | M-4 | M-5 | PP-1 | PP-2 | PP-3 |
| | Part by mass | Part by mass | Part by mass | Part by mass | Part by mass | Part by mass | Part by mass | Part by mass | Part by mass | Part by mass | Part by mass | Part by mass |
| Coating liquid A-1 | 0.060 | | | | 0.333 | 0.167 | | | | 0.675 | | |
| Coating liquid A-2 | 0.060 | | | | 0.333 | 0.167 | | | | 0.675 | | |
| Coating liquid A-3 | 0.060 | | | | 0.333 | 0.167 | | | | 0.675 | | |
| Coating liquid A-4 | 0.060 | | | | 0.333 | 0.167 | | | | 0.675 | | |
| Coating liquid A-5 | 0.060 | | | | 0.333 | 0.167 | | | | 0.675 | | |
| Coating liquid A-6 | 0.060 | | | | 0.333 | 0.167 | | | | 0.675 | | |
| Coating liquid A-7 | 0.060 | | | | 0.333 | 0.167 | | | | 0.675 | | |
| Coating liquid A-8 | 0.060 | | | | 0.333 | 0.167 | | | | 0.675 | | |
| Coating liquid A-9 | 0.060 | | | | 0.333 | 0.167 | | | | 0.675 | | |
| Coating liquid A-10 | 0.060 | | | | 0.333 | 0.167 | | | | 0.675 | | |
| Coating liquid A-11 | 0.060 | | | | 0.333 | 0.167 | | | | 0.675 | | |
| Coating liquid A-12 | 0.060 | | | | 0.333 | 0.167 | | | | 0.675 | | |
| Coating liquid A-13 | 0.060 | | | | 0.333 | 0.167 | | | | 0.675 | | |
| Coating liquidA-14 | 0.060 | | | | 0.333 | 0.167 | | | | 0.675 | | |
| Coating liquid A-15 | 0.060 | | | | 0.333 | 0.167 | | | | 0.675 | | |
| Coating liquid A-16 | 0.060 | | | | 0.333 | 0.167 | | | | 0.675 | | |
| Coating liquid A-17 | 0.060 | | | | 0.333 | 0.167 | | | | 0.675 | | |
| Coating liquid A-18 | 0.060 | | | | 0.333 | 0.167 | | | | 0.675 | | |
| Coating liquid A-19 | 0.060 | | | | 0.333 | 0.167 | | | | 0.675 | | |
| Coating liquid A-20 | 0.060 | | | | 0.333 | 0.167 | | | | 0.675 | | |

(continued)

| Table 3 (2) | Formulation | | | | | | | | | | | |
|---|---|---|---|---|---|---|---|---|---|---|---|---|
| | Polyrmarization initiator | | | | Polymerizable compound | | | | | Polymer particles | | |
| | I-1 | I-2 | I-3 | B-1 | M-1 | M-2 | M-3 | M-4 | M-5 | PP-1 | PP-2 | PP-3 |
| | Part by mass | Part by mass | Part by mass | Part by mass | Part by mass | Part by mass | Part by mass | Part by mass | Part by mass | Part by mass | Part by mass | Part by mass |
| Coating liquid A-21 | 0.020 | | | | 0.333 | 0.167 | | | | 0.675 | | |
| Coating liquid A-22 | 0.040 | | | | 0.333 | 0.167 | | | | 0.675 | | |
| Coating liquid A-23 | 0.080 | | | | 0.333 | 0.167 | | | | 0.675 | | |
| Coating liquid A-24 | 0.060 | | | | 0.333 | 0.167 | | | | 0.675 | | |
| Coating liquid A-25 | 0.060 | | | | 0.333 | 0.167 | | | | 0.675 | | |
| Coating liquid A-26 | | 0.100 | | 0.020 | | | 0.280 | | | | 2.300 | |
| Coating liquid A-27 | | 0.100 | | 0.020 | | | 0.280 | | | | 2.300 | |
| Coating liquid A-28 | | 0.100 | | 0.020 | | | 0.280 | | | | 2.300 | |
| Coating liquid A-29 | | 0.100 | | 0.020 | | | 0.280 | | | | 2.300 | |
| Coating liquid A-30 | | 0.100 | | 0.020 | | | 0.280 | | | | | 2.300 |
| Coating liquid A-31 | | | 0.060 | 0.050 | | | | 0.120 | 0.060 | | | |
| Coating liquid A-32 | | | 0.060 | 0.050 | | | | 0.120 | 0.060 | | | |
| Coating liquid A-33 | | | 0.060 | 0.050 | | | | 0.120 | 0.060 | | | |
| Coating liquid A-34 | | | 0.060 | 0.050 | | | | 0.120 | 0.060 | | | |
| Coating liquid A-35 | 0.060 | | | | 0.333 | 0.167 | | | | 0.675 | | |
| Coating liquid A-36 | 0.060 | | | | 0.333 | 0.167 | | | | 0.675 | | |
| Coating liquid A-37 | 0.060 | | | | 0.333 | 0.167 | | | | 0.675 | | |
| Coating liquid A-38 | 0.060 | | | | 0.333 | 0.167 | | | | 0.675 | | |
| Coating liquid A-C1 | | | | | 0.333 | 0.167 | | | | 0.675 | | |
| Coating liquid A-C2 | | | | | 0.333 | 0.167 | | | | 0.675 | | |

(continued)

| Table 3 (2) | Formulation | | | | | | | | | | | |
|---|---|---|---|---|---|---|---|---|---|---|---|---|
| | Polyrmarization initiator | | | | Polymerizable compound | | | | | Polymer particles | | |
| | I-1 | I-2 | I-3 | B-1 | M-1 | M-2 | M-3 | M-4 | M-5 | PP-1 | PP-2 | PP-3 |
| | Part by mass | Part by mass | Part by mass | Part by mass | Part by mass | Part by mass | Part by mass | Part by mass | Part by mass | Part by mass | Part by mass | Part by mass |
| Coating liquid A-C3 | | | | | 0.333 | 0.167 | | | | 0.675 | | |

[Table 5]

| Table 3 (3) | Formulation | | | | | | | Acid color-forming agent/polymerization initiator | Specific energy difference |
|---|---|---|---|---|---|---|---|---|---|
| | Binder polymer | Hydrophilic compound | | Hydrophobic compound | | Surfactant | | | |
| | BP-1 | H-1 | H-2 | P-1 | P-2 | W-1 | W-2 | Molar ratio | |
| | Part by mass | Part by mass | Part by mass | Part by mass | Part by mass | Part by mass | Part by mass | Equivalent | eV |
| Coating liquid A-1 | | 0.400 | | 0.005 | | 0.004 | | 3.2 | 0.50 |
| Coating liquid A-2 | | 0.400 | | 0.005 | | 0.004 | | 5.3 | 0.50 |
| Coating liquid A-3 | | 0.400 | | 0.005 | | 0.004 | | 3.5 | 0.50 |
| Coating liquid A-4 | | 0.400 | | 0.005 | | 0.004 | | 3.3 | 0.50 |
| Coating liquid A-5 | | 0.400 | | 0.005 | | 0.004 | | 3.4 | 0.50 |
| Coating liquid A-6 | | 0.400 | | 0.005 | | 0.004 | | 3.2 | 0.50 |
| Coating liquid A-7 | | 0.400 | | 0.005 | | 0.004 | | 3.3 | 0.50 |
| Coating liquid A-8 | | 0.400 | | 0.005 | | 0.004 | | 3.4 | 0.50 |
| Coating liquid A-9 | | 0.400 | | 0.005 | | 0.004 | | 3.8 | 0.50 |
| Coating liquid A-10 | | 0.400 | | 0.005 | | 0.004 | | 3.9 | 0.50 |

(continued)

| Table 3 (3) | Formulation | | | | | | | Acid color-forming agent/polymerization initiator | Specific energy difference |
|---|---|---|---|---|---|---|---|---|---|
| | Binder polymer | Hydrophilic compound | | Hydrophobic compound | | Surfactant | | | |
| | BP-1 | H-1 | H-2 | P-1 | P-2 | W-1 | W-2 | Molar ratio | |
| | Part by mass | Part by mass | Part by mass | Part by mass | Part by mass | Part by mass | Part by mass | Equivalent | eV |
| Coating liquid A-11 | | 0.400 | | 0.005 | | 0.004 | | 4.0 | 0.50 |
| Coating liquid A-12 | | 0.400 | | 0.005 | | 0.004 | | 4.7 | 0.50 |
| Coating liquid A-13 | | 0.400 | | 0.005 | | 0.004 | | 5.1 | 0.50 |
| Coating liquid A-14 | | 0.400 | | 0.005 | | 0.004 | | 4.7 | 0.50 |
| Coating liquid A-15 | | 0.400 | | 0.005 | | 0.004 | | 3.7 | 0.50 |
| Coating liquid A-16 | | 0.400 | | 0.005 | | 0.004 | | 3.8 | 0.50 |
| Coating liquid A-17 | | 0.400 | | 0.005 | | 0.004 | | 3.3 | 0.50 |
| Coating liquid A-18 | | 0.400 | | 0.005 | | 0.004 | | 3.5 | 0.50 |
| Coating liquid A-19 | | 0.400 | | 0.005 | | 0.004 | | 3.9 | 0.50 |
| Coating liquid A-20 | | 0.400 | | 0.005 | | 0.004 | | 3.0 | 0.50 |
| Coating liquid A-21 | | 0.400 | | 0.005 | | 0.004 | | 1.1 | 0.50 |
| Coating liquid A-22 | | 0.400 | | 0.005 | | 0.004 | | 2.2 | 0.50 |
| Coating liquid A-23 | | 0.400 | | 0.005 | | 0.004 | | 4.3 | 0.50 |
| Coating liquid A-24 | | 0.400 | | 0.005 | | 0.004 | | 3.2 | 0.57 |

(continued)

| Table 3 (3) | Formulation | | | | | | | Acid color-forming agent/polymerization initiator | Specific energy difference |
|---|---|---|---|---|---|---|---|---|---|
| | Binder polymer | Hydrophilic compound | | Hydrophobic compound | | Surfactant | | | |
| | BP-1 | H-1 | H-2 | P-1 | P-2 | W-1 | W-2 | Molar ratio | |
| | Part by mass | Part by mass | Part by mass | Part by mass | Part by mass | Part by mass | Part by mass | Equivalent | eV |
| Coating liquid A-25 | | 0.400 | | 0.005 | | 0.004 | | 3.2 | 0.53 |
| Coating liquid A-26 | | | 0.010 | | 0.015 | | 0.004 | 4.0 | 0.67 |
| Coating liquid A-27 | | | 0.010 | | 0.015 | | 0.004 | 6.5 | 0.67 |
| Coating liquid A-28 | | | 0.010 | | 0.015 | | 0.004 | 4.3 | 0.67 |
| Coating liquid A-29 | | | 0.010 | | 0.015 | | 0.004 | 4.0 | 0.67 |
| Coating liquid A-30 | | | 0.010 | | 0.015 | | 0.004 | 4.0 | 0.67 |
| Coating liquid A-31 | 0.150 | | 0.010 | | | | | 5.6 | 0.67 |
| Coating liquid A-32 | 0.150 | | 0.010 | | | | | 9.2 | 0.67 |
| Coating liquid A-33 | 0.150 | | 0.010 | | | | | 6.1 | 0.67 |
| Coating liquid A-34 | 0.150 | | 0.010 | | | | | 5.7 | 0.67 |
| Coating liquid A-35 | | 0.400 | | 0.005 | | 0.004 | | 5.3 | 0.50 |
| Coating liquid A-36 | | 0.400 | | 0.005 | | 0.004 | | 5.3 | 0.50 |
| Coating liquid A-37 | | 0.400 | | 0.005 | | 0.004 | | 5.3 | 0.50 |
| Coating liquid A-38 | | 0.400 | | 0.005 | | 0.004 | | 5.3 | 0.50 |

(continued)

| Table 3 (3) | Formulation | | | | | | | Acid color-forming agent/polymerization initiator | Specific energy difference |
|---|---|---|---|---|---|---|---|---|---|
| | Binder polymer | Hydrophilic compound | | Hydrophobic compound | | Surfactant | | | |
| | BP-1 | H-1 | H-2 | P-1 | P-2 | W-1 | W-2 | Molar ratio | |
| | Part by mass | Part by mass | Part by mass | Part by mass | Part by mass | Part by mass | Part by mass | Equivalent | eV |
| Coating liquid A-C1 | | 0.4 | | 0.005 | | 0.004 | | 4.2 | 0.50 |
| Coating liquid A-C2 | | 0.4 | | 0.005 | | 0.004 | | 3.4 | 0.50 |
| Coating liquid A-C3 | | 0.4 | | 0.005 | | 0.004 | | - | 0.50 |

[Example 1]

A surface of the support 1 on the anodic oxide film side, manufactured in Manufacturing Example B1, was coated with the coating liquid 1 for an undercoat layer such that the dry coating amount was 0.03 g/$m^2$, dried at 120°C for 40 seconds, and cooled to 20°C to 27°C, thereby forming an undercoat layer 1.

The surface of the formed undercoat layer 1 was bar-coated with the coating liquid A-1 (coating liquid for an image-recording layer) prepared by the above-described method and dried in an oven at 120°C for 40 seconds to form an image-recording layer 1 having a dry coating amount of 1.0 g/$m^2$, thereby producing a planographic printing plate precursor 1 in which the support 1, the undercoat layer 1, and the image-recording layer 1 were laminated.

[Examples 2 to 24 and Comparative Examples 1 to 3]

Each of planographic printing plate precursors in which a support, an undercoat layer, and an image-recording layer were laminated was produced according to the method described in Example 1, except that a support described in Table 4 later was used instead of the support 1.

[Examples 25 to 48, Examples 61 to 64, and Comparative Examples 4 to 6]

Each of planographic printing plate precursors in which a support, an undercoat layer, and an image-recording layer were laminated was produced according to the method described in Example 1, except that a coating liquid for an image-recording layer, described in Table 5 later, was used instead of the coating liquid A-1.

[Examples 49 to 51]

Each of planographic printing plate precursors in which a support, an undercoat layer, and an image-recording layer were laminated was produced according to the method described in Example 1, except that each of the coating liquids 2 to 4 for an undercoat layer was used instead of the coating liquid 1 for an undercoat layer.

In Examples 49 and 50, the surface of the support 1 on the anodic oxide film side was coated with the coating liquids 2 and 3 for an undercoat layer so that the dry coating amount was 0.1 g/$m^2$, thereby forming each of the undercoat layers.

[Examples 52 to 56]

A laminate consisting of a support, an undercoat layer, and an image-recording layer was produced according to the method described in Example 1, except that the support 23 manufactured in Manufacturing Example B23 was used instead of the support 1, the coating liquid 2 for an undercoat layer was used instead of the coating liquid 1 for an undercoat

layer, and a coating liquid for an image-recording layer, described in Table 5 later, was used instead of the coating liquid A-1.

Next, the surface of the image-recording layer of each produced laminate was bar-coated with the following coating liquid 1 for a protective layer and dried in an oven at 120°C for 60 seconds to form a protective layer 1 having a dry coating amount of 0.1 g/m$^2$, thereby producing each of the planographic printing plate precursors in which the support, the undercoat layer, the image-recording layer, and the protective layer were laminated.

(Coating liquid 1 for protective layer)

The following components were mixed to prepare a coating liquid 1 for a protective layer.

· Water: 3.0581 parts
· METOLOSE SM04 (methyl cellulose, manufactured by Shin-Etsu Chemical Co., Ltd., degree of methoxy substitution = 1.8): 0.1250 parts
· Inorganic lamellar compound dispersion liquid (1): 0.3375 parts
· Hydrophilic polymer (1) represented by the following structural formula (Mw: 30,000) (solid content: 20% by mass): 0.0825 parts
· RAPISOL A-80 (anionic surfactant, manufactured by NOF CORPORATION, 80% by mass aqueous solution): 0.0094 parts

The inorganic lamellar compound dispersion liquid (1) was prepared by adding 6.4 parts of synthetic mica ("Somashift ME-100" manufactured by Co-op Chemical Co., Ltd.) to 193.6 parts of deionized water and dispersing the mixture using a homogenizer until the volume average particle size (laser scattering method) reached 3 μm. An aspect ratio of the obtained dispersed particles was 100 or more.

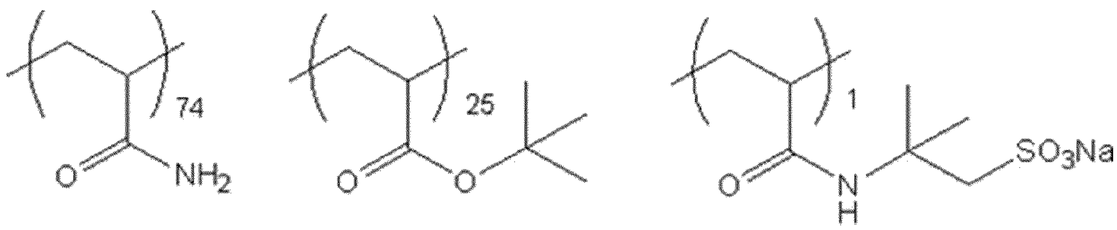

Hydrophilic polymer (1)

[Examples 57 to 60]

A laminate consisting of a support and an image-recording layer was produced according to the method described in Example 1, except that the support 24 manufactured in Manufacturing Example B24 was used instead of the support 1, the undercoat layer was not formed, the image-recording layer was directly formed on the surface of the support 24 on the anodic oxide film side, and a coating liquid for an image-recording layer, described in Table 5 later, was used instead of the coating liquid A-1.

Next, the surface of the image-recording layer of each produced laminate was bar-coated with the following coating liquid 2 for a protective layer and dried in an oven at 120°C for 60 seconds to form a protective layer 2 having a dry coating amount of 0.8 g/m$^2$, thereby producing each of the planographic printing plate precursors in which the support, the image-recording layer, and the protective layer were laminated.

(Coating liquid 2 for protective layer)

The following components were mixed to prepare a coating liquid 2 for a protective layer.

· 6% by mass of aqueous solution of polyvinyl alcohol ("CKS50" manufactured by Nippon Synthetic Chemical Industry Co., Ltd., sulfonic acid-modified, saponification degree: 99 mol% or more, degree of polymerization: 300): 10 parts
· Polyvinylpyrrolidone (LUVISKOL K-17, manufactured by BASF SE): 1 part
· RAPISOL A-80 (anionic surfactant, manufactured by NOF CORPORATION): 0.001 parts
· Deionized water: 6.0 parts
· wIR-1 (decomposition-type infrared absorber, the following compound): 0.01 parts

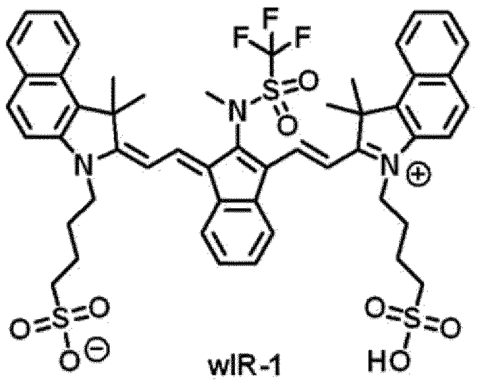

wIR-1

[Evaluation]

The following performances were evaluated for the planographic printing plate precursors produced in each of Examples and Comparative Examples.

<Visibility>

The obtained planographic printing plate precursor was exposed using an exposure machine ("Luxel PLATESETTER T-6000III" manufactured by FUJIFILM Corporation) equipped with an infrared semiconductor laser having a wavelength of 830 nm so that the exposure amount was 120 $mJ/cm^2$. An image in which characters "Fuji" were exposed as an exposed portion was exposed to the exposed image in a size of 3 to 14 points. Under a white light of 800 lux, the exposed planographic printing plate precursor was placed perpendicular to the floor. An experimenter stood at a distance of 1 m from the just exposed precursor and evaluated the points of the smallest characters that could be read accurately by both eyes. The evaluation was performed within 30 minutes after the exposure of the planographic printing plate precursor. The average values obtained by 10 experimenters were calculated, and the visibility was evaluated based on the following standard. The evaluation of visibility is preferably A, B, or C, more preferably A or B, and still more preferably A.

(Evaluation standard for visibility)

A: 3 points or more and less than 5 points
B: 5 points or more and less than 6 points
C: 6 points or more and less than 7 points
D: 7 points or more and less than 9 points
E: 9 points or more and less than 11 points
F: 11 points or more

<Dot-like color-forming defect over time>

The obtained planographic printing plate precursor was cut into a size of 40 cm in width and 60 cm in length, and stored together with an interleaving paper for 1 hour in an environment of 25°C and 70 %RH to be humidified, and then wrapped with aluminum craft paper and heated in an oven set at 60°C for 5 days.

Thereafter, the temperature was lowered to room temperature, the planographic printing plate precursor was taken out, and the number of color-forming defects having a major axis of 20 μm or more per 80 $cm^2$ was calculated by observation with a 25x loupe. The number of color-forming defects was calculated at five different locations, and the color-forming defect over time was evaluated based on the following evaluation standard from the average number thereof.

(Evaluation standard for dot-like color-forming defect over time)

10: number of dot-like color-forming defects was 5 or less (80 $cm^2$).
9: number of dot-like color-forming defects was 6 to 10 (80 $cm^2$).

8: number of dot-like color-forming defects was 11 to 20 (80 $cm^2$).
7: number of dot-like color-forming defects was 21 to 30 (80 $cm^2$).
6: number of dot-like color-forming defects was 31 to 40 (80 $cm^2$).
5: number of dot-like color-forming defects was 41 to 50 (80 $cm^2$).
4: number of dot-like color-forming defects was 51 to 60 (80 $cm^2$).
3: number of dot-like color-forming defects was 61 to 80 (80 $cm^2$).
2: number of dot-like color-forming defects was 81 to 100 (80 $cm^2$).
1: number of dot-like color-forming defects was 101 or more (80 $cm^2$).

<Corrosion stain suppressiveness>

The obtained planographic printing plate precursor was stored together with an interleaving paper for 1 hour in an environment of 25°C and 70 %RH to be humidified, and then wrapped with aluminum craft paper and heated in an oven set at 60°C for 5 days.

Thereafter, the temperature was lowered to room temperature, and the planographic printing plate precursor was attached to a plate cylinder of a printing press "LITHRONE 26" (manufactured by Komori Corporation) without being subjected to a development treatment. Dampening water and ink were supplied thereto using a standard automatic printing start method of the above-described printing press, using dampening water of Ecolity-2 (manufactured by FUJIFILM Corporation)/tap water = 2/98 (volume ratio) and Values-G (N) black ink (manufactured by DIC Corporation), on-press development was performed, and then printing was performed on 500 sheets of TOKUBISHI art paper (ream weight: 76.5 kg, manufactured by MITSUBISHI PAPER MILLS LIMITED.).

The 500th printed material was confirmed by a loupe observation (magnification: 25 times), the number of print stains (minute corrosion stains) having a length of 20 μm or more per 80 $cm^2$ was calculated, and the corrosion stain suppressiveness was evaluated based on the following evaluation standard.

(Evaluation standard for corrosive stain suppressiveness)

10: number of minute corrosion stains was 5 or less (per 80 $cm^2$).
9: number of minute corrosion stains was 6 to 10 (per 80 $cm^2$).
8: number of minute corrosion stains was 11 to 20 (per 80 $cm^2$).
7: number of minute corrosion stains was 21 to 30 (per 80 $cm^2$).
6: number of minute corrosion stains was 31 to 40 (per 80 $cm^2$).
5: number of minute corrosion stains was 41 to 50 (per 80 $cm^2$).
4: number of minute corrosion stains was 51 to 60 (per 80 $cm^2$).
3: number of minute corrosion stains was 61 to 80 (per 80 $cm^2$).
2: number of minute corrosion stains was 81 to 100 (per 80 $cm^2$).
1: number of minute corrosion stains was 101 or more (per 80 $cm^2$).

<Printing durability>

The planographic printing plate precursor produced as described above was exposed with an exposure machine ("Magnus 800 Quantum" manufactured by Kodak Co., Ltd.) equipped with an infrared semiconductor laser under conditions of output: 27 W, outer drum rotation speed: 450 rpm, and resolution: 2,400 dpi (dots per inch; 1 inch is 2.54 cm) (irradiation energy equivalent to 110 mJ/$cm^2$). The exposure image included a solid image and a 3% halftone dot chart of an amplitude modulation screen (AM screen).

The obtained exposed precursor was attached to a cylinder of a printing press "SX-74" manufactured by Heidelberger Druckmaschinen AG, which had a size of 939 mm in length and 636 mm in width (Kikuban size), without performing a development treatment. The printing press was connected to a 100 L dampening water circulation tank incorporating a nonwoven filter and a temperature controlling device. 80 L of 2.0% dampening water S-Z1 (manufactured by Fujifilm Corporation) is charged in a circulation device, dampening water and ink were supplied according to a standard automatic printing start method using T&K UV OFS K-HS solid ink GE-M (manufactured by T&K TOKA CO., LTD.) as printing ink, and then printing was performed on TOKUBISHI art paper (manufactured by MITSUBISHI PAPER MILLS LIMITED., ream weight: 76.5 kg) at a printing speed of 10,000 sheets per hour.

As the number of printed sheets increased, the image area was gradually worn, and the ink density on the printed material decreased. A halftone dot area ratio of the 3% AM halftone dots in the printed material was measured with a Gretag density meter (manufactured by Gretag-Macbeth). In a case where the obtained measured value was decreased

by 1% with respect to the measured value of the 500th printed sheet, the number of sheets of printing in this case was defined as the number of sheets of printing at the end of printing, a relative printing durability in a case where the number of printed sheets was 50,000 was determined by the following expression, and the printing durability was evaluated. As the numerical value is higher, the printing durability is better.

Relative printing durability = (Number of printed sheets of target planographic printing plate precursor)/50000 $\times$ 100

(Evaluation standard for printing durability)

10: relative printing durability was 99% or more.
9: relative printing durability was 90% or more and less than 99%.
8: relative printing durability was 80% or more and less than 90%.
7: relative printing durability was 70% or more and less than 80%.
6: relative printing durability was 60% or more and less than 70%.
5: relative printing durability was 50% or more and less than 60%.
4: relative printing durability was 40% or more and less than 50%.
3: relative printing durability was 30% or more and less than 40%.
2: relative printing durability was 20% or more and less than 30%.
1: relative printing durability was less than 20%.

<On-press developability>

The obtained planographic printing plate precursor was exposed using an exposure machine ("Luxel PLATESETTER T-6000III" manufactured by FUJIFILM Corporation) equipped with an infrared semiconductor laser under conditions of an outer drum rotation speed of 1000 rpm, a laser output of 70%, and a resolution of 2,400 dpi. The exposure was performed by imagewise exposure including a solid image and a 50% halftone dot chart of a frequency modulation (FM) screen in the exposed image.

The imagewise-exposed planographic printing plate precursor was attached to a plate cylinder of a printing press "LITHRONE 26" (manufactured by Komori Corporation) without being subjected to a development treatment. Dampening water and ink were supplied thereto using a standard automatic printing start method of the above-described printing press, using dampening water of Ecolity-2 (manufactured by FUJIFILM Corporation)/tap water = 2/98 (volume ratio) and Values-G (N) black ink (manufactured by DIC Corporation), on-press development was performed, and then printing was performed on 100 sheets of TOKUBISHI art paper (ream weight: 76.5 kg, manufactured by MITSUBISHI PAPER MILLS LIMITED.) at a printing speed of 10,000 sheets/hour.

The number of sheets of printing paper required for the on-press development of the non-exposed portion of the 50% halftone dot chart on the printing press to a state in which the ink was not transferred to the halftone dot non-image area was measured (hereinafter, also referred to as "number of sheets of wasted paper"). The on-press developability was evaluated based on the following standard from the measured number of sheets of wasted paper. As described below, it can be said that the on-press developability is better as the number of sheets of wasted paper is smaller.

(Evaluation standard for on-press developability)

10: number of sheets of wasted paper was 5 or less.
9: number of sheets of wasted paper was 6 to 10.
8: number of sheets of wasted paper was 11 to 15.
7: number of sheets of wasted paper was 16 to 19.
6: number of sheets of wasted paper was 20 to 25.
5: number of sheets of wasted paper was 26 to 29.
4: number of sheets of wasted paper was 30 to 34.
3: number of sheets of wasted paper was 35 to 39.
2: number of sheets of wasted paper was 40 to 50.
1: number of sheets of wasted paper was 51 or more.

<Scratch resistance>

The scratch resistance was evaluated using a surface property measuring instrument TRIBOGEAR TYPE: 18LFW (manufactured by Shinto Scientific Co., Ltd.). Each planographic printing plate precursor was scanned at a scanning speed of 20 mm/s while the load thereon was changed at intervals of 5 g/m$^2$ from 10 g/m$^2$ to 90 g/m$^2$ using a sapphire needle of 0.1 mm, to generate scratches. On-press development and printing were performed using the planographic printing plate precursor with scratches, and the presence or absence of scratches and stains on the paper surface of the 100th sheet of printing start was confirmed for each load. Based on the results of the lightest load among the loads at which the scratches and stains occurred, the scratch resistance of each planographic printing plate precursor was evaluated based on the following standard.

(Evaluation standard for scratch resistance)

10: no scratches and stains occurred even at a load of 90 g/m$^2$.
9: scratches and stains occurred at a load of 90 g/m$^2$.
8: scratches and stains occurred at a load of 85 g/m$^2$.
7: scratches and stains occurred at a load of 75 or 80 g/m$^2$.
6: scratches and stains occurred at a load of 65 or 70 g/m$^2$.
5: scratches and stains occurred at a load of 55 or 60 g/m$^2$.
4: scratches and stains occurred at a load of 45 or 50 g/m$^2$.
3: scratches and stains occurred at a load of 35 or 40 g/m$^2$.
2: scratches and stains occurred at a load of 25 or 30 g/m$^2$.
1: scratches and stains occurred at a load of 20 g/m$^2$ or less.

Tables 4 and 5 show the formulations and the evaluation results of each of Examples and Comparative Examples.

[Table 6]

| Table 4 | Support | Formulation | | Evaluation | | | | | |
|---|---|---|---|---|---|---|---|---|---|
| | | Coating liquid for undercoat layer | Coating liquid for image-recording layer | Visibility | Suppressing property of color-forming defect over time | Corrosion stain suppressiveness | Printing durability | On-press developability | Scratch resistance |
| Example 1 | 1 | 1 | A-1 | A | 9 | 9 | 8 | 7 | 10 |
| Example 2 | 2 | 1 | A-1 | A | 9 | 9 | 8 | 7 | 10 |
| Example 3 | 3 | 1 | A-1 | A | 8 | 8 | 8 | 7 | 10 |
| Example 4 | 4 | 1 | A-1 | A | 8 | 7 | 7 | 7 | 10 |
| Example 5 | 5 | 1 | A-1 | A | 7 | 6 | 6 | 6 | 10 |
| Example 6 | 6 | 1 | A-1 | A | 5 | 5 | 5 | 6 | 10 |
| Example 7 | 7 | 1 | A-1 | A | 5 | 5 | 5 | 6 | 10 |
| Example 8 | 8 | 1 | A-1 | A | 7 | 7 | 6 | 7 | 10 |
| Example 9 | 9 | 1 | A-1 | A | 7 | 7 | 5 | 8 | 10 |
| Example 10 | 10 | 1 | A-1 | A | 9 | 9 | 7 | 7 | 10 |
| Example 11 | 11 | 1 | A-1 | A | 9 | 9 | 5 | 7 | 10 |
| Example 12 | 12 | 1 | A-1 | A | 9 | 9 | 10 | 7 | 10 |
| Example 13 | 13 | 1 | A-1 | A | 9 | 9 | 8 | 9 | 10 |
| Example 14 | 14 | 1 | A-1 | A | 9 | 9 | 9 | 6 | 10 |
| Example 15 | 15 | 1 | A-1 | A | 9 | 9 | 10 | 6 | 10 |
| Example 16 | 16 | 1 | A-1 | A | 9 | 9 | 7 | 8 | 10 |
| Example 17 | 17 | 1 | A-1 | A | 9 | 9 | 5 | 8 | 10 |
| Example 18 | 18 | 1 | A-1 | A | 9 | 9 | 8 | 7 | 7 |
| Example 19 | 19 | 1 | A-1 | A | 9 | 9 | 8 | 7 | 6 |
| Example 20 | 20 | 1 | A-1 | A | 9 | 9 | 8 | 7 | 5 |
| Example 21 | 21 | 1 | A-1 | A | 9 | 9 | 8 | 7 | 8 |
| Example 22 | 22 | 1 | A-1 | A | 9 | 9 | 8 | 7 | 9 |
| Example 23 | 23 | 1 | A-1 | A | 9 | 9 | 6 | 8 | 9 |

(continued)

| Table 4 | Support | Formulation | | Evaluation | | | | | | |
|---|---|---|---|---|---|---|---|---|---|---|
| | | Coating liquid for undercoat layer | Coating liquid for image-recording layer | Visibility | Suppressing property of color-forming defect over time | Corrosion stain suppressiveness | Printing durability | On-press developability | Scratch resistance |
| Example 24 | 24 | 1 | A-1 | A | 9 | 9 | 5 | 8 | 9 |
| Comparative Example 1 | C1 | 1 | A-1 | A | 1 | 3 | 4 | 6 | 3 |
| Comparative Example 2 | C2 | 1 | A-1 | A | 2 | 2 | 3 | 7 | 2 |
| Comparative Example 3 | C3 | 1 | A-1 | A | 4 | 4 | 6 | 7 | 4 |

[Table 7]

| Table 5 | Support | Formulation | | | | Evaluation | | | | | |
|---|---|---|---|---|---|---|---|---|---|---|---|
| | | Coating liquid for undercoat layer | Coating liquid for image-recording layer | | Coating liquid for protective layer | Visibility | Suppressing property of color-forming defect over time | Corrosion stain suppressiveness | Printing durability | On-press developability | Scratch resistance |
| | | | No. | Acid color-forming agent | | | | | | | |
| Example 25 | 1 | 1 | A-2 | S-1 | None | A | 9 | 9 | 9 | 7 | 10 |
| Example 26 | 1 | 1 | A-3 | S-2 | None | C | 10 | 9 | 7 | 7 | 10 |
| Example 27 | 1 | 1 | A-4 | S-3 | None | B | 10 | 9 | 9 | 7 | 10 |
| Example 28 | 1 | 1 | A-5 | S-5 | None | C | 10 | 9 | 7 | 7 | 10 |
| Example 29 | 1 | 1 | A-6 | S-6 | None | C | 10 | 9 | 7 | 7 | 10 |
| Example 30 | 1 | 1 | A-7 | S-7 | None | A | 8 | 9 | 8 | 7 | 10 |
| Example 31 | 1 | 1 | A-8 | S-8 | None | A | 7 | 9 | 9 | 7 | 10 |
| Example 32 | 1 | 1 | A-9 | S-9 | None | A | 6 | 9 | 9 | 7 | 10 |
| Example 33 | 1 | 1 | A-10 | S-10 | None | A | 9 | 9 | 9 | 7 | 10 |
| Example 34 | 1 | 1 | A-11 | S-11 | None | A | 7 | 9 | 9 | 7 | 10 |
| Example 35 | 1 | 1 | A-12 | S-12 | None | B | 10 | 9 | 9 | 7 | 10 |
| Example 36 | 1 | 1 | A-13 | S-13 | None | A | 9 | 9 | 9 | 7 | 10 |
| Example 37 | 1 | 1 | A-14 | S-14 | None | A | 9 | 9 | 9 | 7 | 10 |
| Example 38 | 1 | 1 | A-15 | S-15 | None | A | 9 | 9 | 9 | 7 | 10 |
| Example 39 | 1 | 1 | A-16 | S-16 | None | B | 10 | 9 | 9 | 7 | 10 |
| Example 40 | 1 | 1 | A-17 | S-17 | None | B | 10 | 9 | 9 | 7 | 10 |
| Example 41 | 1 | 1 | A-18 | S-18 | None | B | 10 | 9 | 9 | 7 | 10 |
| Example 42 | 1 | 1 | A-19 | S-19 | None | A | 8 | 9 | 9 | 7 | 10 |
| Example 43 | 1 | 1 | A-20 | S-20 | None | C | 5 | 9 | 9 | 7 | 10 |
| Example 44 | 1 | 1 | A-21 | S-4 | None | C | 9 | 9 | 8 | 7 | 10 |
| Example 45 | 1 | 1 | A-22 | S-4 | None | A | 9 | 9 | 8 | 7 | 10 |

(continued)

| Table 5 | Support | Formulation | | | | Evaluation | | | | | |
|---|---|---|---|---|---|---|---|---|---|---|---|
| | | Coating liquid for undercoat layer | Coating liquid for image-recording layer | | Coating liquid for protective layer | Visibility | Suppressing property of color-forming defect over time | Corrosion stain suppressiveness | Printing durability | On-press developability | Scratch resistance |
| | | | No. | Acid color-forming agent | | | | | | | |
| Example 46 | 1 | 1 | A-23 | S-4 | None | A | 9 | 9 | 9 | 7 | 10 |
| Example 47 | 1 | 1 | A-24 | S-4 | None | C | 9 | 9 | 8 | 7 | 10 |
| Example 48 | 1 | 1 | A-25 | S-4 | None | B | 9 | 9 | 7 | 7 | 10 |
| Example 49 | 1 | 2 | A-1 | S-4 | None | A | 9 | 10 | 9 | 10 | 10 |
| Example 50 | 1 | 3 | A-1 | S-4 | None | A | 9 | 10 | 10 | 10 | 10 |
| Example 51 | 1 | 4 | A-1 | S-4 | None | A | 9 | 10 | 9 | 9 | 9 |
| Example 52 | 23 | 2 | A-26 | S-4 | 1 | A | 9 | 9 | 9 | 10 | 10 |
| Example 53 | 23 | 2 | A-27 | S-1 | 1 | A | 9 | 9 | 10 | 10 | 10 |
| Example 54 | 23 | 2 | A-28 | S-2 | 1 | B | 10 | 9 | 8 | 10 | 10 |
| Example 55 | 23 | 2 | A-29 | S-7 | 1 | A | 8 | 9 | 9 | 10 | 10 |
| Example 56 | 23 | 2 | A-30 | S-4 | 1 | A | 9 | 9 | 10 | 10 | 10 |
| Example 57 | 24 | | A-31 | S-4 | 2 | A | 9 | 10 | 8 | 6 | 10 |
| Example 58 | 24 | | A-32 | S-1 | 2 | A | 9 | 10 | 9 | 6 | 10 |
| Example 59 | 24 | | A-33 | S-2 | 2 | A | 9 | 10 | 7 | 6 | 10 |
| Example 60 | 24 | | A-34 | S-7 | 2 | A | 9 | 10 | 8 | 6 | 10 |
| Example 61 | 1 | 1 | A-35 | S-4 | None | A | 10 | 9 | 9 | 7 | 10 |
| Example 62 | 1 | 1 | A-36 | S-4 | None | A | 10 | 9 | 9 | 7 | 10 |
| Example 63 | 1 | 1 | A-37 | S-4 | None | A | 10 | 9 | 9 | 7 | 10 |
| Example 64 | 1 | 1 | A-38 | S-4 | None | A | 10 | 9 | 9 | 7 | 10 |
| Comparative Example 4 | 1 | 1 | A-C1 | S-C1 | None | E | 10 | 10 | 9 | 7 | 10 |

(continued)

| Table 5 | Support | Formulation | | | | Evaluation | | | | | |
|---|---|---|---|---|---|---|---|---|---|---|---|
| | | Coating liquid for undercoat layer | Coating liquid for image-recording layer | | Coating liquid for protective layer | Visibility | Suppressing property of color-forming defect over time | Corrosion stain suppressiveness | Printing durability | On-press developability | Scratch resistance |
| | | | No. | Acid color-forming agent | | | | | | | |
| Comparative Example 5 | 1 | 1 | A-C2 | S-C2 | None | D | 10 | 10 | 9 | 7 | 10 |
| Comparative Example 6 | 1 | 1 | A-C3 | None | None | F | 10 | 10 | 9 | 7 | 10 |

As is clear from Tables 4 and 5, it was found that the planographic printing plate precursors according to Examples were excellent in the suppressing property of the color-forming defect over time and in visibility, as compared with the planographic printing plate precursors according to Comparative Examples.

Explanation of References

ta: anodic reaction time
tc: cathodic reaction time
tp: time taken for current to reach peak from 0
Ia: peak current on anode cycle side
Ic: peak current on cathode cycle side
1: aluminum alloy plate
2, 4: roll-shaped brush
3: abrasive slurry
5, 6, 7, 8: support roller
10: planographic printing plate precursor
11: support
12: image-recording layer
13: aluminum alloy plate
14, 14A, 14B: anodic oxide film
20, 30: micropore
21, 31: film surface
22: large-diameter hole portion
22A, 24A, 32A, 34A, 36A: bottom portion
23, 33, 35: communicate position
24: small-diameter hole portion
32: upper hole portion
34: middle hole portion
36: lower hole portion
50: main electrolytic cell
51: AC power source
52: radial drum roller
53a, 53b: main pole
54: electrolytic solution feed inlet
55: electrolytic solution
56: slit
57: electrolytic solution passage
58: auxiliary anode
60: auxiliary anode cell
W: aluminum alloy plate
610: anodization treatment device
612: power supply tank
614: electrolytic treatment tank
616: aluminum alloy plate
618, 626: electrolytic solution
620: power supply electrode
622, 628: roller
624: nip roller
630: electrolytic electrode
632: tank wall
634: DC power source

**Claims**

**1.** An on-press development-type planographic printing plate precursor comprising:

a support; and
an image-recording layer,
wherein the support has an aluminum alloy plate and an anodic oxide film disposed on the aluminum alloy plate,
a density of intermetallic compounds having a major axis of 2.0 μm or more on a surface of the support on a side opposite to the image-recording layer is 1,000 pieces/mm$^2$ or less,
the image-recording layer contains an infrared absorber and an acid color-forming agent, and
a color-forming factor of the acid color-forming agent, which is determined by the following measurement X, is 20,000 or more,
measurement X: in a case where a solution obtained by mixing 1 mL of a first acetonitrile solution in which a concentration of the acid color-forming agent is 0.02 mmol/L, 1 mL of a second acetonitrile solution in which a concentration of 10-camphorsulfonic acid is 0.02 mmol/L, 5 mL of water, and 93 mL of acetonitrile is used for measuring a ultraviolet-visible absorption spectrum with a measurement cell having an optical path width of 10 mm to obtain an absorbance at an absorption maximal wavelength, which is denoted by Amax, a value determined by the following expression (1) is defined as the color-forming factor,

$$\text{color-forming factor } (L\cdot mol^{-1}\cdot cm^{-1}) = Amax/\{(0.0002 \text{ mmol/L}) \times (1 \text{ cm})\}. \quad \text{expression (1)}$$

2. The planographic printing plate precursor according to claim 1,
wherein the density of the intermetallic compounds having a major axis of 2.0 μm or more on the surface of the support on the side opposite to the image-recording layer is 500 pieces/mm$^2$ or less.

3. The planographic printing plate precursor according to claim 1,
wherein the density of the intermetallic compounds having a major axis of 2.0 μm or more on the surface of the support on the side opposite to the image-recording layer is 10 pieces/mm$^2$ or less.

4. The planographic printing plate precursor according to claim 1,
wherein a density of recessed portions having a depth of 0.7 μm or more from an average plane, which is obtained by measuring a surface of the support on a side of the anodic oxide film in a range of 400 μm × 400 μm using a non-contact three-dimensional roughness meter, is 3,000 pieces/mm$^2$ or more.

5. The planographic printing plate precursor according to claim 1,
wherein a surface area ratio ΔS calculated by the following expression (S1) from an actual area Sx which is obtained by an approximate three-point method from three-dimensional data obtained by, using an atomic force microscope, measuring 256 × 256 points in a range of 25 μm × 25 μm on a surface of the support on a side of the anodic oxide film and from a geometrically measured area S0 of the surface of the support on the side of the anodic oxide film is 25% or more,

$$\Delta S = (Sx - S0)/S0 \times 100\ (\%) \cdots (S1).$$

6. The planographic printing plate precursor according to claim 1,

wherein the anodic oxide film has a micropore extending in a depth direction from a surface of the anodic oxide film,
the micropore is composed of a large-diameter hole portion extending in the depth direction from the surface of the anodic oxide film and a small-diameter hole portion communicating with a bottom portion of the large-diameter hole portion and extending in the depth direction,
an average diameter of the large-diameter hole portion at the surface of the anodic oxide film is 15 to 50 nm,
a depth of the large-diameter hole portion is 30 to 1,000 nm,
an average diameter of the small-diameter hole portion at a communicate position with the large-diameter hole portion is 15 nm or less, and
a depth of the small-diameter hole portion is 300 to 3,000 nm.

7. The planographic printing plate precursor according to claim 1,

wherein the anodic oxide film has a micropore extending in a depth direction from a surface of the anodic oxide

film,
the micropore is composed of an upper hole portion extending in the depth direction from the surface of the anodic oxide film, a middle hole portion communicating with a bottom portion of the upper hole portion and extending in the depth direction, and a lower hole portion communicating with a bottom portion of the middle hole portion and extending in the depth direction to a bottom portion of the micropore,
an average diameter of the upper hole portion at the surface of the anodic oxide film is 15 to 50 nm,
a depth of the upper hole portion is 30 to 1,000 nm,
a maximum diameter of the middle hole portion is 20 to 100 nm, and is larger than the average diameter of the upper hole portion at the surface of the anodic oxide film,
an average diameter of the lower hole portion at a communicate position with the large-diameter hole portion is 20 nm or less, and
a depth of the lower hole portion is 500 to 3,000 nm.

**8.** The planographic printing plate precursor according to claim 1,

wherein the anodic oxide film has a micropore extending in a depth direction from a surface of the anodic oxide film,
a density of the micropores on the surface of the anodic oxide film is 400 to 1,500 pieces/$\mu m^2$, and
an opening ratio of the micropores on the surface of the anodic oxide film is 30% to 85%.

**9.** The planographic printing plate precursor according to claim 1,
wherein the color-forming factor of the acid color-forming agent, which is determined by the measurement X, is 20,000 to 100,000.

**10.** The planographic printing plate precursor according to claim 1,
wherein an absorption maximal wavelength $\lambda max$ of a color forming substance generated from the acid color-forming agent in a wavelength range of 380 to 750 nm is present in a range of 500 to 650 nm.

**11.** The planographic printing plate precursor according to claim 1,

wherein the acid color-forming agent has at least one group represented by Formulae (1a) to (1d),

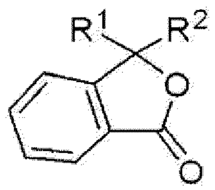
(1a)

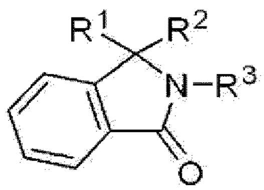
(1b)

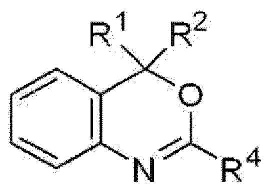
(1c)

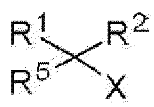
(1d)

in the formulae, $R^1$ and $R^2$ represent a portion linked to a mother nucleus structure of the acid color-forming agent,
$R^3$ represents an aryl group or a heteroaryl group,
$R^4$ represents an aryl group or a heteroaryl group,
$R^5$ represents a hydrocarbon group, and
X represents a leaving group.

**12.** The planographic printing plate precursor according to claim 11,

wherein the acid color-forming agent has any of structures represented by Formulae (2a) to (2f),

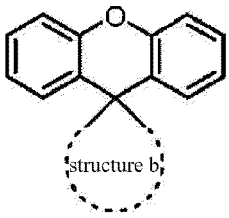

(2a)

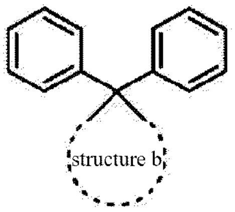

(2b)

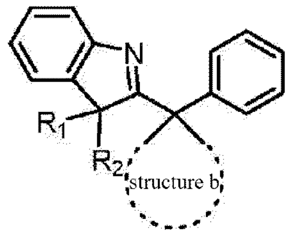

(2c)

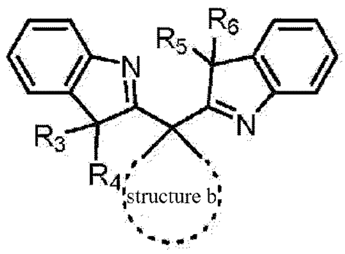

(2d)

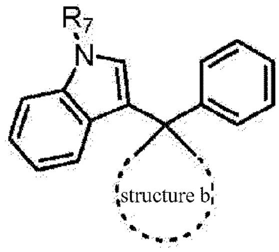

(2e)

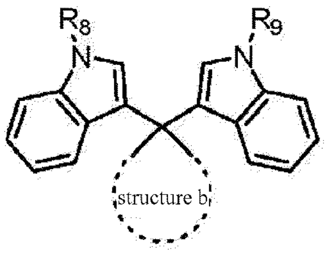

(2f)

in the formulae, a structure b represents a structure which is ring-opened or cleaved in a case of being in contact with an electron-accepting compound, and

$R_1$ to $R_9$ each independently represent a hydrogen atom, an alkyl group, or an alkoxy group.

**13.** The planographic printing plate precursor according to claim 11, wherein the acid color-forming agent includes a compound represented by Formula (3a) or a compound represented by Formula (3b),

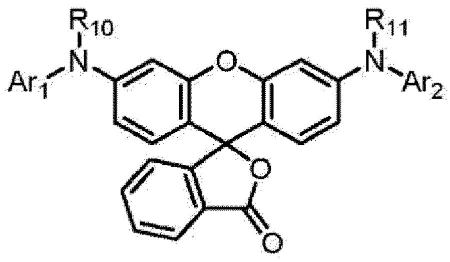

(3a)

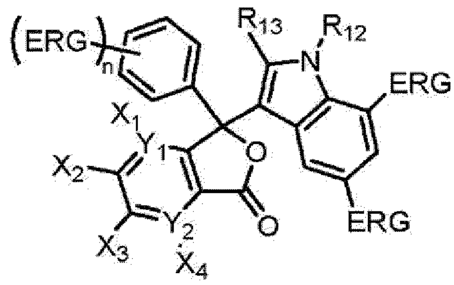

(3b)

in Formula (3a),

$Ar_1$ and $Ar_2$ each independently represent an aryl group which may have a substituent or a heteroaryl group which may have a substituent, and

$R_{10}$ and $R_{11}$ each independently represent a hydrogen atom, an alkyl group, an aryl group which may have a substituent, or a heteroaryl group which may have a substituent,

in Formula (3b),

ERG's each independently represent an electron-donating group,

n represents an integer of 1 to 5,

$X_1$ to $X_4$ each independently represent a hydrogen atom, a halogen atom, or a monovalent organic group,

$Y_1$ and $Y_2$ each independently represent C or N,

$X_1$ does not exist in a case where $Y_1$ is N,

$X_4$ does not exist in a case where $Y_2$ is N, and

$R_{12}$ and $R_{13}$ each independently represent a hydrogen atom, an alkyl group, an aryl group which may have a substituent, or a heteroaryl group which may have a substituent.

**14.** The planographic printing plate precursor according to claim 1,

wherein the image-recording layer further contains a polymerization initiator, and
the polymerization initiator includes an electron-accepting polymerization initiator and an electron-donating polymerization initiator.

**15.** The planographic printing plate precursor according to claim 14,

wherein the electron-accepting polymerization initiator is an onium salt compound, and
the electron-donating polymerization initiator is a borate salt compound.

**16.** The planographic printing plate precursor accepting to claim 14, wherein a total content of the electron-accepting polymerization initiator and the electron-donating polymerization initiator is 1.0 molar equivalent or more with respect to a content of the acid color-forming agent.

**17.** The planographic printing plate precursor according to claim 14, wherein a value obtained by subtracting a lowest unoccupied molecular orbital of the infrared absorber from a lowest unoccupied molecular orbital of the electron-accepting polymerization initiator is 0.55 eV or less.

**18.** The planographic printing plate precursor according to claim 1, wherein the image-recording layer further contains polymer particles.

**19.** The planographic printing plate precursor according to claim 18, wherein the polymer particles are microgels.

**20.** The planographic printing plate precursor according to claim 18,

wherein the polymer particles include a polymer having a hydrophobic main chain, and
the polymer includes a constitutional unit having a pendant cyano group directly bonded to the hydrophobic main chain and a constitutional unit having a pendant group including a hydrophilic polyalkylene oxide segment.

**21.** The planographic printing plate precursor according to claim 1, wherein the infrared absorber includes a decomposition-type infrared absorber which is decomposed by exposure to infrared rays.

**22.** The planographic printing plate precursor according to claim 21,

wherein the decomposition-type infrared absorber is a compound represented by Formula (A),

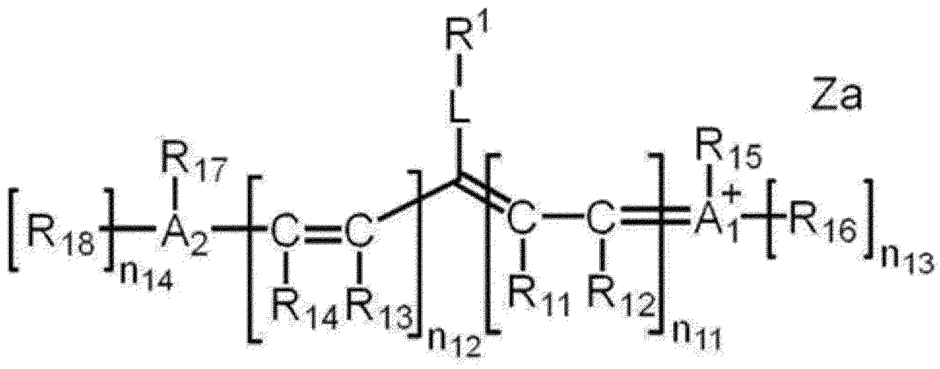

(A)

in the formula, $R^1$ represents a group having an $R^1$-L bond which is cleaved by exposure to infrared rays,
$R_{11}$ to $R_{18}$ each independently represent a hydrogen atom, a halogen atom, -Ra, -ORb, -SRc, or -NRdRe,
Ra to Re each independently represent a hydrocarbon group,
$A_1$, $A_2$, and a plurality of $R_{11}$'s to $R_{18}$'s may be linked to each other to form a monocycle or a polycycle,
$A_1$ and $A_2$ each independently represent an oxygen atom, a sulfur atom, or a nitrogen atom,
$n_{11}$ and $n_{12}$ each independently represent an integer of 0 to 5, where a total of $n_{11}$ and $n_{12}$ is 2 or more,

$n_{13}$ and $n_{14}$ each independently represent 0 or 1,
L represents an oxygen atom, a sulfur atom, or $-NR_{10}-$,
$R_{10}$ represents a hydrogen atom, an alkyl group, or an aryl group, and
Za represents a counter ion which neutralizes an electric charge.

**23.** The planographic printing plate precursor according to claim 1, further comprising:
a protective layer on the image-recording layer.

**24.** The planographic printing plate precursor according to claim 23,
wherein the protective layer contains a color forming substance precursor.

**25.** The planographic printing plate precursor according to claim 24,
wherein the color forming substance precursor includes an infrared absorber.

**26.** The planographic printing plate precursor according to claim 24,
wherein the color forming substance precursor includes a decomposition-type infrared absorber which is decomposed by exposure to infrared rays.

**27.** A manufacturing method of a planographic printing plate, comprising:

an exposure step of exposing the image-recording layer of the planographic printing plate precursor according to any one of claims 1 to 26 in an imagewise manner to form an exposed portion and a non-exposed portion; and
an on-press development step of supplying at least one of a printing ink or a dampening water on a printing press to remove the non-exposed portion of the imagewise-exposed image-recording layer and to manufacture a planographic printing plate.

**28.** A printing method comprising:

an exposure step of exposing the image-recording layer of the planographic printing plate precursor according to any one of claims 1 to 26 in an imagewise manner to form an exposed portion and a non-exposed portion;
an on-press development step of supplying at least one of a printing ink or a dampening water on a printing press to remove the non-exposed portion of the imagewise-exposed image-recording layer and to manufacture a planographic printing plate; and
a printing step of performing printing using the manufactured planographic printing plate.

FIG. 1

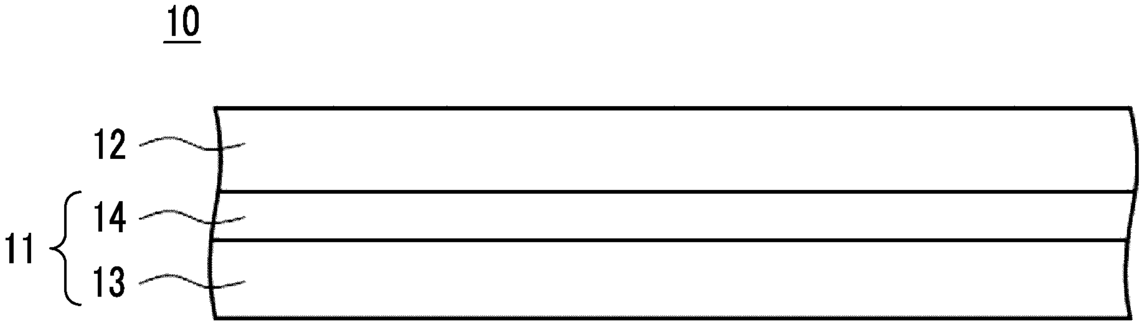


FIG. 2

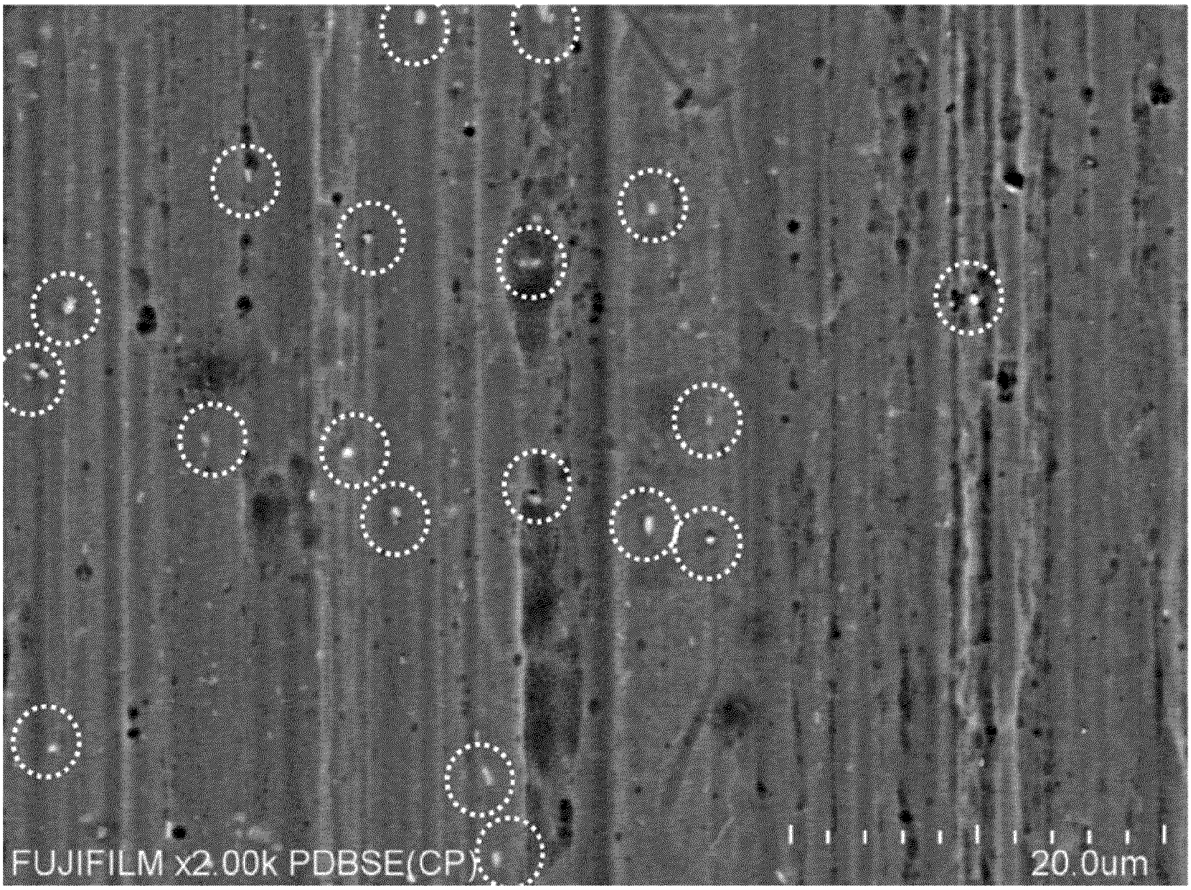

FIG. 3

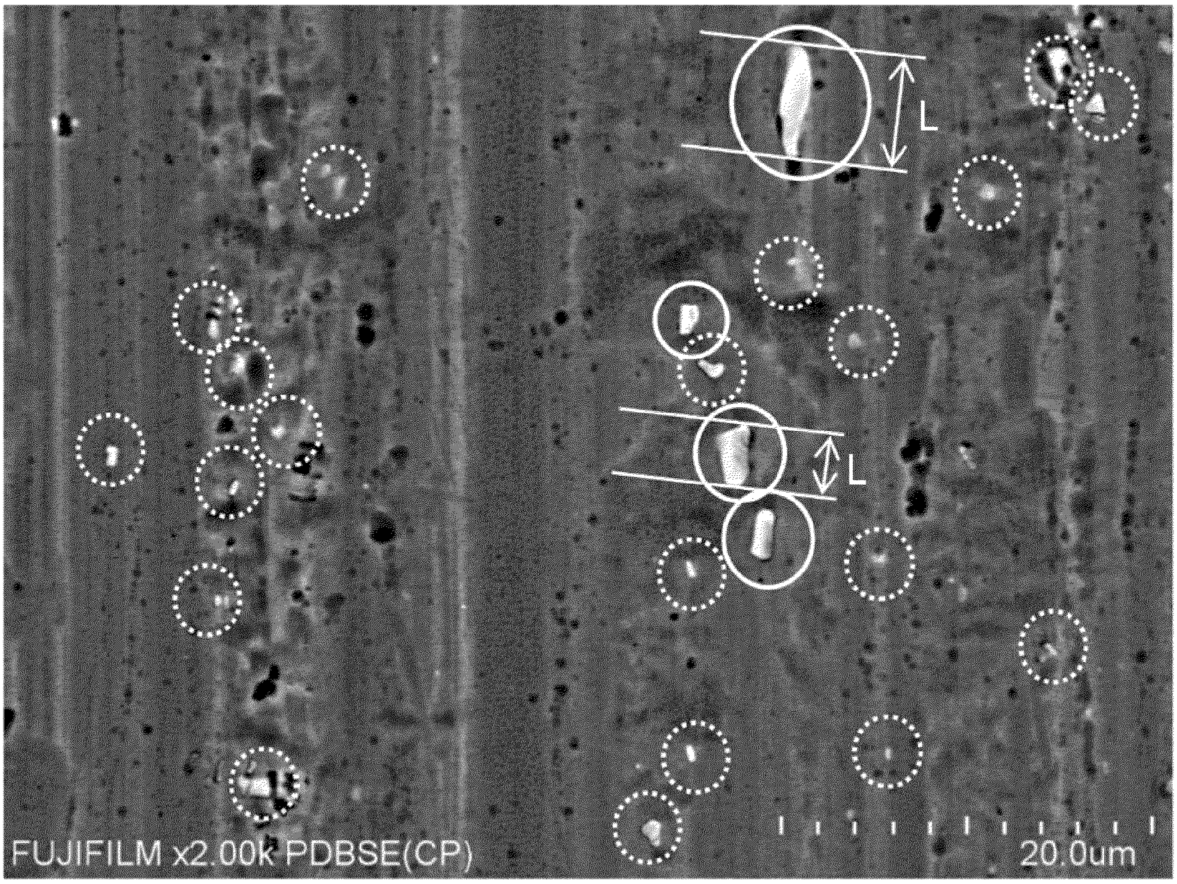
L
L
FUJIFILM x2.00k PDBSE(CP)
20.0um

FIG. 4

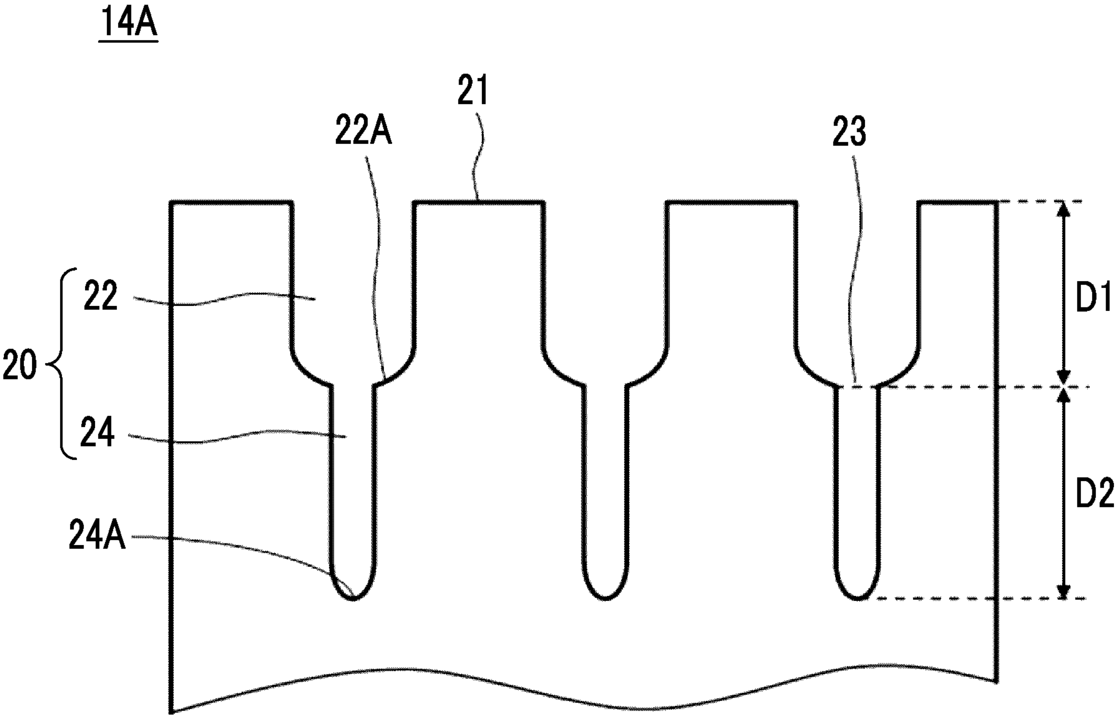
14A
21
22A
23
22
20
24
24A
D1
D2

FIG. 5

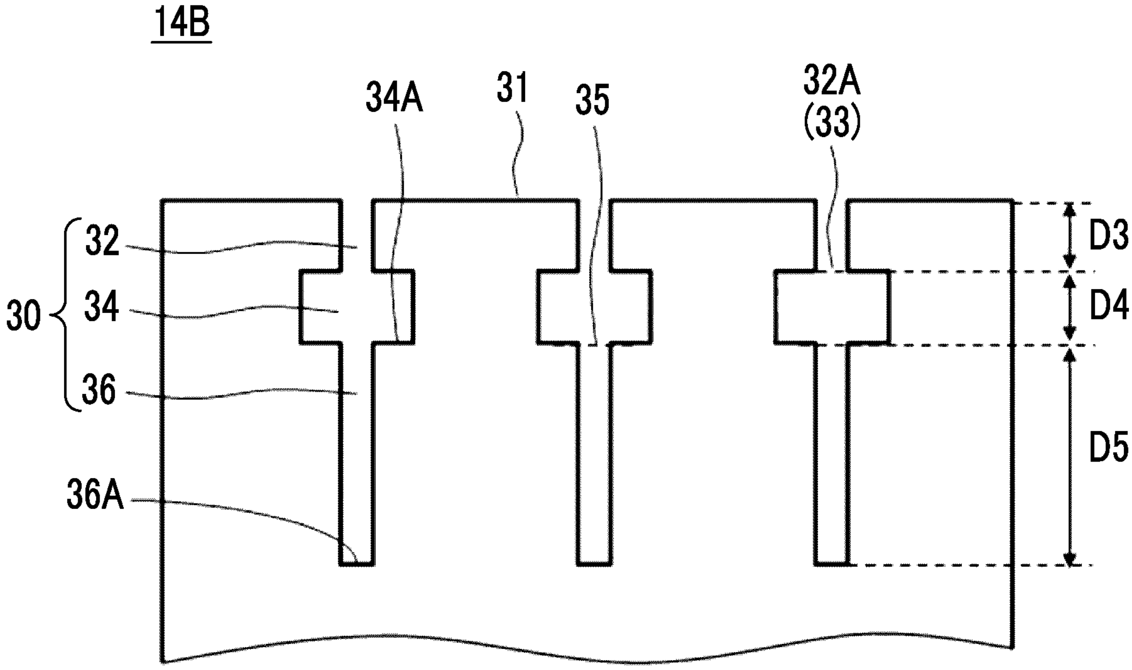
14B
34A
31
35
32A
(33)
32
30
34
36
36A
D3
D4
D5

FIG. 6

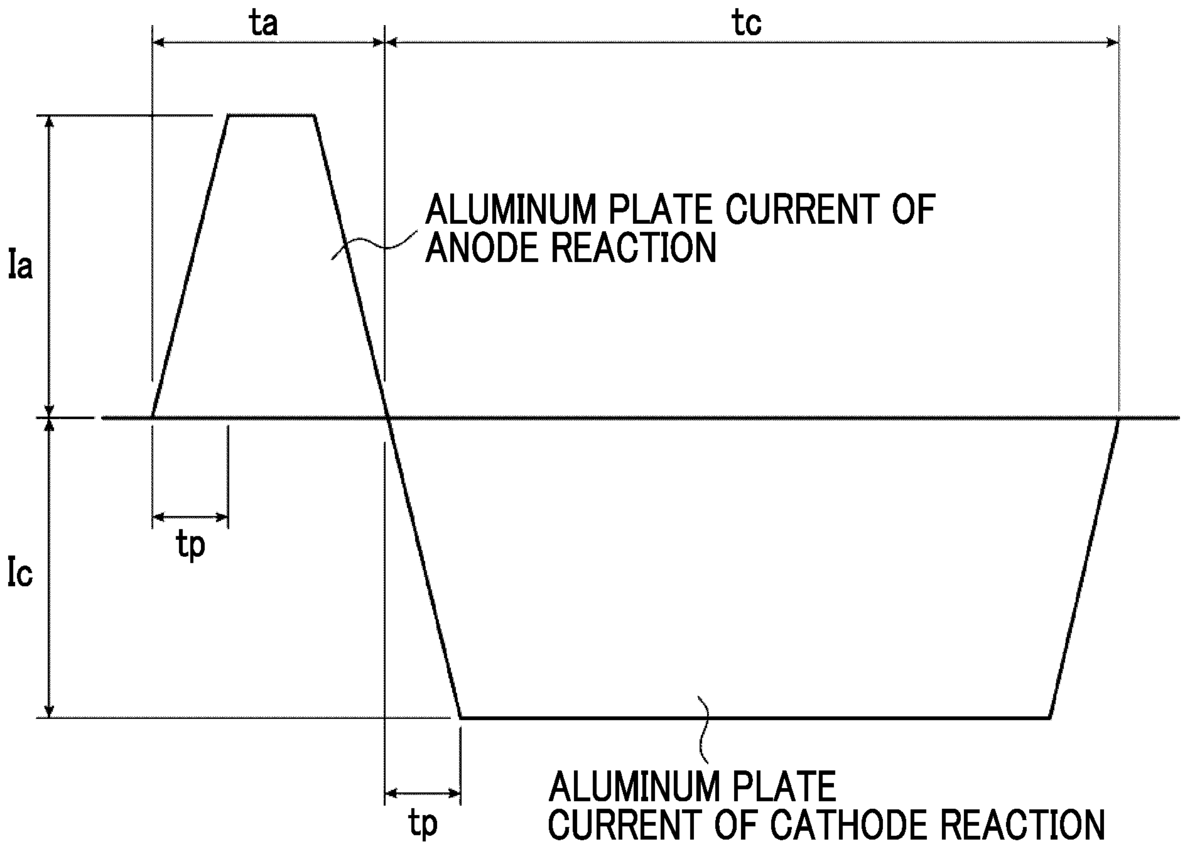
ta
tc
Ia
ALUMINUM PLATE CURRENT OF
ANODE REACTION
tp
Ic
tp
ALUMINUM PLATE
CURRENT OF CATHODE REACTION

FIG. 7

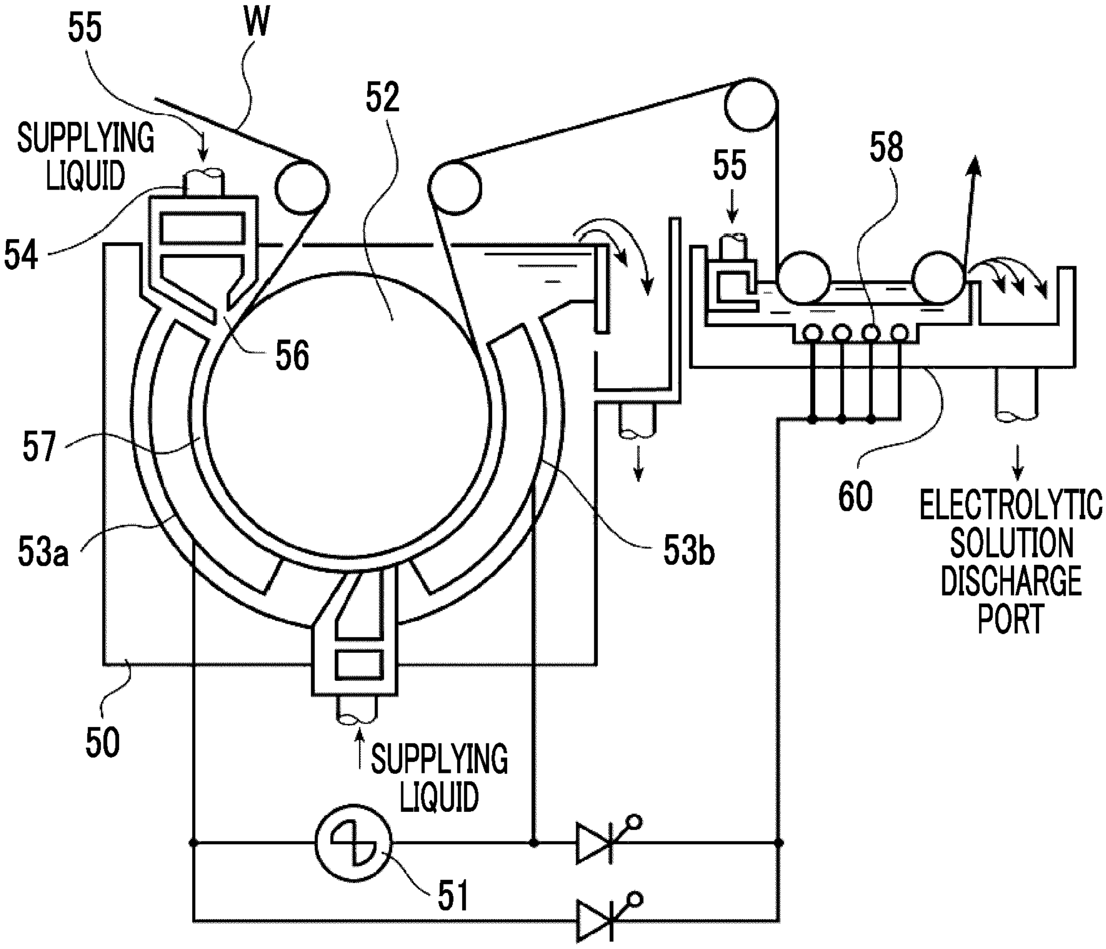
55
W
52
SUPPLYING LIQUID
54
55
58
56
57
53a
53b
60
ELECTROLYTIC SOLUTION DISCHARGE PORT
50
SUPPLYING LIQUID
51

FIG. 8

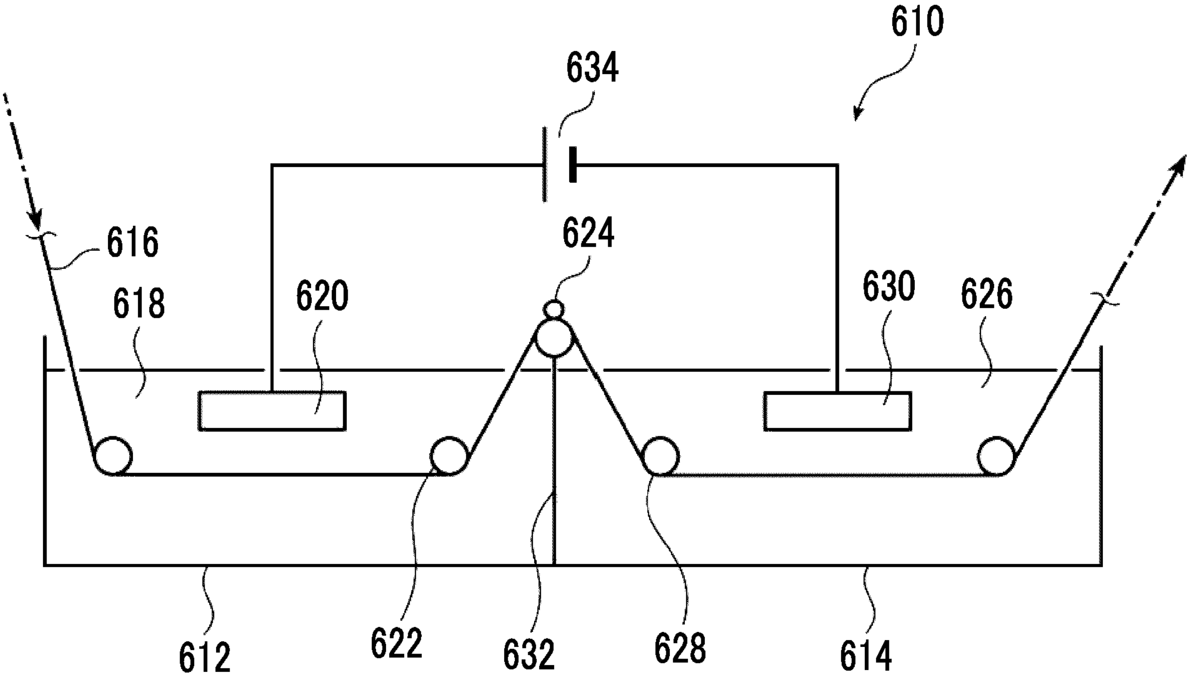
610
634
616
624
618
620
630
626
612
622
632
628
614

**INTERNATIONAL SEARCH REPORT**

International application No.
**PCT/JP2023/030714**

**A. CLASSIFICATION OF SUBJECT MATTER**

***B41N 1/14***(2006.01)i; ***B41C 1/10***(2006.01)i; ***B41M 1/06***(2006.01)i; ***G03F 7/00***(2006.01)i; ***G03F 7/004***(2006.01)i; ***G03F 7/029***(2006.01)i
FI: B41N1/14; B41C1/10; B41M1/06; G03F7/004 507; G03F7/004 505; G03F7/029; G03F7/004 501; G03F7/00 503

According to International Patent Classification (IPC) or to both national classification and IPC

**B. FIELDS SEARCHED**

Minimum documentation searched (classification system followed by classification symbols)

B41N1/14; B41C1/10; B41M1/06; G03F7/00; G03F7/004; G03F7/029

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2020/262692 A1 (FUJIFILM CORP.) 30 December 2020 (2020-12-30) claims 1-39, paragraphs [0473], [0553]-[0706] | 1-28 |
| Y | JP 2013-173353 A (FUJIFILM CORP.) 05 September 2013 (2013-09-05) claim 6, paragraphs [0104]-[0149] | 1-28 |
| Y | JP 2011-68014 A (FUJIFILM CORP.) 07 April 2011 (2011-04-07) claim 1, paragraphs [0220]-[0251] | 1-28 |
| Y | JP 11-151870 A (KONICA CORP.) 08 June 1999 (1999-06-08) claim 1, paragraphs [0036]-[0053] | 1-28 |
| Y | WO 2022/138710 A1 (FUJIFILM CORP.) 30 June 2022 (2022-06-30) claims 10-11, paragraphs [0002], [0176]-[0231] | 4-5 |
| Y | US 2021/0094336 A1 (EASTMAN KODAK CO.) 01 April 2021 (2021-04-01) claims 1-21, paragraphs [0261]-[0310], fig. 1 | 7-8 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **27 September 2023** | **10 October 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2023/030714**

| Patent document cited in search report | Publication date (day/month/year) | Patent family member(s) | Publication date (day/month/year) |
|---|---|---|---|
| WO 2020/262692 A1 | 30 December 2020 | US 2022/0111629 A1<br>claims 1-24, paragraphs [0973], [1183]-[1549]<br>EP 3991986 A1<br>CN 114051598 A | |
| JP 2013-173353 A | 05 September 2013 | US 2014/0326151 A1<br>claim 6, paragraphs [0233]-[0342]<br>WO 2013/111652 A1<br>EP 2808173 A1<br>CN 104066591 A | |
| JP 2011-68014 A | 07 April 2011 | US 2012/0189959 A1<br>claim 26, paragraphs [0837]-[1127]<br>WO 2011/037005 A1<br>EP 2481603 A1<br>CN 102548769 A | |
| JP 11-151870 A | 08 June 1999 | (Family: none) | |
| WO 2022/138710 A1 | 30 June 2022 | (Family: none) | |
| US 2021/0094336 A1 | 01 April 2021 | JP 2022-550947 A<br>WO 2021/067054 A1<br>EP 4017735 A1<br>CN 114502378 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2020262692 A
- JP 5045885 A
- JP H5045885 A
- JP 6035174 A
- JP H6035174 A
- JP 6057432 A
- JP H6057432 A
- JP 3162530 A
- JP H3162530 A
- JP 5140659 A
- JP H5140659 A
- JP 4231425 A
- JP H4231425 A
- JP 4276031 A
- JP H4276031 A
- JP 5311261 A
- JP H5311261 A
- JP 6136466 A
- JP H6136466 A
- JP 5051659 A
- JP H5051659 A
- JP 5049148 A
- JP H5049148 A
- JP 7040017 A
- JP H7040017 A
- JP 3079798 A
- JP H3079798 A
- JP 5201166 A
- JP H5201166 A
- JP 5156414 A
- JP H5156414 A
- JP 6262203 A
- JP H6262203 A
- JP 6122949 A
- JP H6122949 A
- JP 6210406 A
- JP H6210406 A
- JP 6026308 A
- JP H6026308 A
- JP 6135175 A
- JP H6135175 A
- JP 50040047 B
- JP S50040047 B
- JP 2005254638 A
- US 2714066 A
- US 3181461 A
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H5005005 A
- JP 2001222101 A
- JP 2008544322 A
- WO 2016027886 A
- WO 2019219560 A
- JP 8108621 A
- JP H8108621 A
- JP 61166544 A
- JP S61166544 A
- JP 2002328465 A
- WO 2019013268 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2008503365 A
- JP 2012148555 A
- JP 2008284817 A
- US 3276868 A
- US 4153461 A
- US 4689272 A
- US 3458311 A
- JP 55049729 B
- JP S55049729 B
- JP 2005250216 A
- JP 2006259137 A

**Non-patent literature cited in the description**


- Basics and Industrial Technology of Aluminum Materials. Light Metal Association, 32
- **L. F. MONDOLFO**. *Aluminum Alloys: Structure and properties*, 1976
- Dye Handbooks. Society of Synthetic Organic Chemistry, 1970
- *Research Disclosure No. 33303*, January 1992
- *JIS K 7121*, 1987
- *JIS K 6240*, 2011
- *JIS K 6726*, 1994
- *JIS P 8202*, 1998